# EUROPEAN PATENT SPECIFICATION

(11) **EP 4 181 224 B1**
(45) Date of publication and mention of the grant of the patent: **01.01.2025**
(21) Application number: 21856290.8
(22) Date of filing: 13.08.2021
(51) Int. Cl.: H10K 85/10, H10K 85/60, H10K 85/30

(54) **ORGANIC LIGHT-EMITTING DEVICE**
ORGANISCHE LICHTEMITTIERENDE VORRICHTUNG
DISPOSITIF ÉLECTROLUMINESCENT ORGANIQUE

(30) Priority: 14.08.2020 KR 20200102660
(43) Date of publication of application: 17.05.2023
(73) Proprietor: LG Chem, Ltd., Seoul 07336 (KR)
(72) Inventor: LEE, Jiyoung, Daejeon 34122 (KR); KANG, Sungkyoung, Daejeon 34122 (KR); KIM, Gyoungsik, Daejeon 34122 (KR); JUNG, Min Suk, Daejeon 34122 (KR); BAE, Jaesoon, Daejeon 34122 (KR); LEE, Jaechol, Daejeon 34122 (KR); JANG, Songrim, Daejeon 34122 (KR); CHOI, Doowhan, Daejeon 34122 (KR); SHIN, Jiyeon, Daejeon 34122 (KR); KANG, Eunhye, Daejeon 34122 (KR)
(74) Representative: Hoffmann Eitle
(86) International application number: PCT/KR2021/010818
(87) International publication number: WO 2022/035284

(56) References cited:
- KR-A- 20160 131 947
- KR-A- 20190 134 036
- KR-A- 20200 034 516
- KR-A- 20200 035 775
- KR-A- 20200 035 775
- KR-A- 20200 036 610
- KR-A- 20200 083 174
- US-A1- 2016 329 497

## Description

### [Technical Field]

The present disclosure relates to an organic light emitting device.

### [Background Art]

An organic light emission phenomenon is one of examples converting a current to visible light by an internal process of specific organic molecules. A principle of an organic light emission phenomenon is as follows. When an organic material layer is placed between an anode and a cathode and a current is applied between the two electrodes, electrons and holes are injected to the organic material layer from the cathode and the anode, respectively. The holes and the electrons injected to the organic material layer recombine to form excitons, and light emits when these excitons fall back to the ground state. An organic light emitting device using such a principle may be generally formed with a cathode, an anode, and an organic material layer placed therebetween, for example, a hole injection layer, a hole transfer layer, a light emitting layer, an electron injection layer and an electron transfer layer.

A deposition process has been mainly used in the art to manufacture an organic light emitting device. However, manufacturing an organic light emitting device using a deposition process has problems in that it causes much material loss and manufacturing a large area device is difficult, and a device using a solution process has been developed in order to resolve these problems.

Accordingly, development of materials and combinations of materials for organic material layers prepared using a solution process has been required.

KR 2020-0035775 A describes an organic light emitting device that comprises: an anode; a hole injection layer; a hole transport layer; a light emitting layer; an electron transport layer; and cathode. The hole injection layer includes fluorene derivatives represented by chemical formula 1 as described therein. The hole transport layer includes a copolymer including a polyphenylene derivative as first repeating unit represented by chemical formula 2 described therein and a phenylfluorene derivative as a second repeating unit represented by chemical formula 3 as described therein.

KR 2019-0134036 A describes an organic light emitting device comprising a first electrode, a second electrode provided to be opposite to the first electrode, a light emitting layer provided between the first electrode and the second electrode, a second organic material layer provided between the first electrode and the light emitting layer, and a first organic material layer provided between the first electrode and the second organic material layer. The light emitting layer comprises an anthracene derivative represented by chemical formula 1 described therein. The first organic material layer comprises a cured product of a coating composition comprising a fluorene derivative of chemical formula 2 as described therein and a boron-based anionic compound of chemical formula 3 as described therein. The second organic material layer comprises a polymer comprising a carbazole unit represented by chemical formula 4 described therein.

US2016329497 A1 describes a hole transport copolymer represented by E-[A]ₐ-[B']_{b}-[C']_{c}-E wherein A is a monomeric unit containing at least one triarylamine group; B' is a monomeric unit having at least three points of attachment in the copolymer; C' is an aromatic monomeric unit or a deuterated analog thereof; E is the same or different at each occurrence and is selected from the group consisting of H, D, halide, alkyl, silyl, germyl, aryl, arylamino, siloxane, crosslinkable groups, deuterated alkyl, deuterated silyl, deuterated germyl, deuterated aryl, deuterated arylamino, deuterated siloxane, and deuterated crosslinkable groups; a, b, and c are the same or different and are mole fractions, such that a+b+c=1, and a and b are non-zero.

### [Disclosure]

### [Technical Problem]

The present disclosure is directed to providing an organic light emitting device having excellent efficiency and/or lifetime properties.

### [Technical Solution]

The present invention provides an organic light emitting device including an anode; a cathode; a light emitting layer provided between the anode and the cathode; a first organic material layer including a composition including a compound of the following Chemical Formula 1 or a cured material thereof provided between the light emitting layer and the anode, wherein the first organic material layer further includes an ionic compound including an anion group of the following Chemical Formula 2; and a second organic material layer including a copolymer of the following Chemical Formula 3 or a cured material thereof provided between the first organic material layer and the light emitting layer.

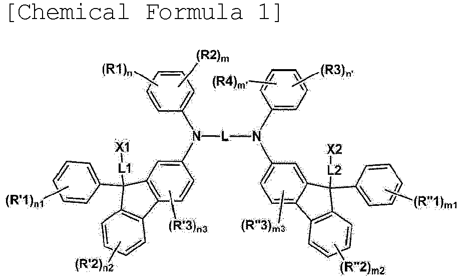

In Chemical Formula 1,
L is a substituted or unsubstituted C₆₋₆₀ arylene group; or a substituted or unsubstituted C₂₋₆₀ heteroarylene group including one or more heteroatoms selected from the group consisting of N, O and S,
R1 and R3 are the same as or different from each other, and each independently a halogen group,
R2 and R4 are the same as or different from each other, and each independently hydrogen; deuterium; or a C₁₋₁₀ alkyl group,
L1 and L2 are the same as or different from each other, and each independently a direct bond; or a methylene group,
X1 and X2 are the same as or different from each other, and each independently a curing group,
R'1, R'2, R'3, R"1, R"2 and R"3 are the same as or different from each other, and each independently hydrogen; deuterium; a substituted or unsubstituted C₁₋₆₀ alkyl group; a substituted or unsubstituted C₁₋₆₀ alkoxy group; a substituted or unsubstituted C₆₋₆₀ aryl group; or a C₂₋₆₀ heteroaryl group including one or more heteroatoms selected from the group consisting of N, O and S,
n and n' are each independently an integer of 1 to 5, m and m' are each independently 0 or 1, n+m is 5 or less, and n'+m' is 5 or less,
n1 and m1 are each independently an integer of 0 to 5, n2 and m2 are each independently an integer of 0 to 4, and n3 and m3 are each independently an integer of 0 to 3, and
when n, n', n1 to n3 and m1 to m3 are each 2 or greater, substituents in the two or more parentheses are the same as or different from each other, 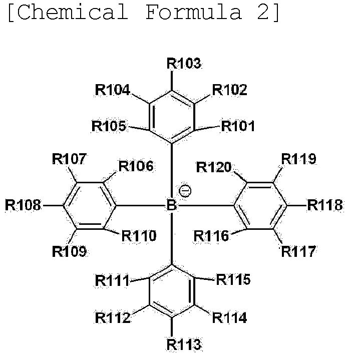
wherein, in Chemical Formula 2,
at least one of R101 to R120 is a curing group,
at least one of the rest of R101 to R120 that are not the curing group is F; a cyano group; or a substituted or unsubstituted fluoroalkyl group,
the rest of R101 to R120 that are not the curing group; the F; the cyano group; or the substituted or unsubstituted fluoroalkyl group are the same as or different from each other, and each independently hydrogen; deuterium; a nitro group; -C(O)R₂₀₁; -OR₂₀₂; -SR₂₀₃; -SO₃R₂₀₄; -COOR₂₀₅; -OC(O)R₂₀₆; -C(O )NR₂₀₇R₂₀₈; a substituted or unsubstituted alkyl group; a substituted or unsubstituted alkenyl group; a substituted or unsubstituted amine group; a substituted or unsubstituted aryl group; or a substituted or unsubstituted heterocyclic group, and
R₂₀₁ to R₂₀₈ are the same as or different from each other, and each independently hydrogen; deuterium; or a substituted or unsubstituted alkyl group, 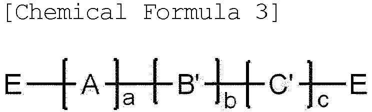
in Chemical Formula 3,
A is a monomer unit including at least one triarylamine group,
B' is a monomer unit having at least three bonding points in the copolymer,
C' is an aromatic monomer unit or a deuterated analogue thereof,
Es are the same as or different from each other, and each independently selected from the group consisting of hydrogen; deuterium; a halogen group; a substituted or unsubstituted alkyl group; a substituted or unsubstituted silyl group; a substituted or unsubstituted germanium group; a substituted or unsubstituted aryl group; a substituted or unsubstituted arylamino group; a substituted or unsubstituted siloxane group; and a substituted or unsubstituted curing group, and
a, b and c are a mole fraction, a+b+c=1, a≠0, and b≠0.

### [Advantageous Effects]

By an organic light emitting device according to the present invention including a compound of Chemical Formula 1 in a first organic material layer, curing and film retention are excellent when forming the first organic material layer, and a hole injection ability to a second organic material layer is enhanced.

In addition, by forming a second organic material layer including a copolymer of Chemical Formula 3 on the first organic material layer as above, the organic light emitting device according to the present invention has enhanced device efficiency and/or lifetime.

### [Description of Drawings]

FIG. 1 illustrates an example of an organic light emitting device according to one embodiment of the present disclosure.
FIG. 2 to FIG. 6 show NMR data of compounds prepared in preparation examples of the present disclosure.
FIG. 7 shows an NMR spectrum of lithium (perfluorophenyl)tris(2,3,5,6-tetrafluoro-4-vinylphenyl)borate (Compound 3.3').
FIG. 8 shows a mass spectrum of lithium (perfluorophenyl)tris(2,3,5,6-tetrafluoro-4-vinylphenyl)borate (Compound 3.3').

### [Reference Numeral]

101: Substrate
201: Anode
301: Hole Injection Layer
401: Hole Transfer Layer
501: Light Emitting Layer
601: Electron Injection and Transfer Layer
701: Cathode

### [Mode for Disclosure]

Hereinafter, the present invention will be described in detail.

In the present disclosure, a description of a certain member (layer) being placed "on" another member (layer) includes not only a case of the one member (layer) being in contact with the another member but a case of still another member (layer) being present between the two members (layers).

In the present specification, a description of a certain part "including" certain constituents means capable of further including other constituents, and does not exclude other constituents unless particularly stated on the contrary.

In the present disclosure, the "layer" has a meaning compatible with a `film' mainly used in the art, and means coating that covers a target area. The size of the "layer" is not limited, and each "layer" may have the same or a different size. According to one embodiment, the size of the "layer" may be the same as the whole device, may correspond to the size of a specific functional area, or may be as small as a single subpixel.

Unless defined otherwise in the present specification, all technological and scientific terms used in the present disclosure have the same meanings as terms commonly understood by those skilled in the art. Although methods and materials similar or equivalent to those described in the present disclosure may be used in implementing or experimenting embodiments of the present disclosure, suitable methods and materials are described later. All publications, patent applications, patents and other reference documents mentioned in the present disclosure are incorporated by reference in the present disclosure as a whole, and when conflicting, the present disclosure including definitions has priority unless specific passage is mentioned. Furthermore, materials, methods and examples are for illustrative purposes only, and not to limit the present disclosure.

In the present disclosure, a "curing group" means a group capable of inducing crosslinking through heat treatment and/or exposure to light. The crosslinking may be produced by linking radicals generated while a carbon-carbon multiple bond or a cyclic structure is decomposed by heat treatment or light irradiation.

In one embodiment of the present disclosure, the curing group may be selected from among the following structures.

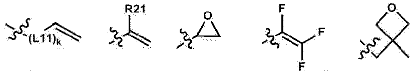

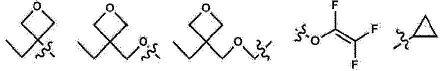

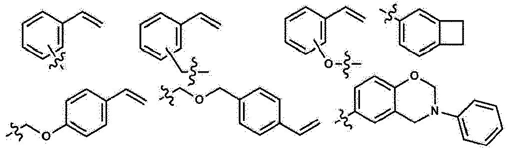

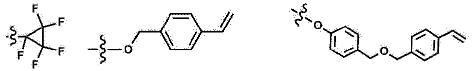

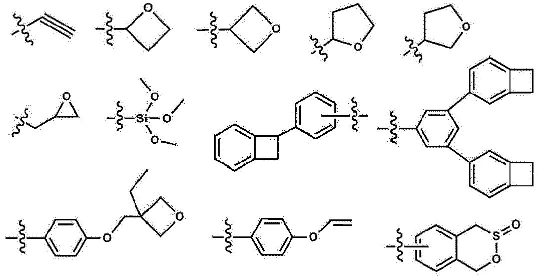

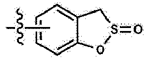

In the structures,
L11 is a direct bond; -O-; -S-; a substituted or unsubstituted alkylene group; a substituted or unsubstituted arylene group; or a substituted or unsubstituted heteroarylene group,
k is 1 or 2,
when k is 2, L11s are the same as or different from each other, and
R21 is a substituted or unsubstituted alkyl group.

According to one embodiment of the present disclosure, L11 is a direct bond; a methylene group; or an ethylene group.

In another embodiment, L11 is a direct bond.

According to one embodiment of the present disclosure, R21 is a methyl group; or an ethyl group.

According to another embodiment, R21 is a methyl group.

In the present disclosure, a term "deuterated" intends to mean that at least one available H is replaced by D. In a X% deuterated compound or group, X% of available H is replaced by D. In the deuterated compound or group, deuterium is present in 100 times or higher of its natural abundance level.

According to one embodiment of the present disclosure, one or more of a compound of Chemical Formula 1 or a copolymer of Chemical Formula 3 may be deuterated. Herein, the deuterated compound may be prepared in a similar manner of using a deuterated precursor material, or more generally, by treating an undeuterated compound with a deuterated solvent such as benzene-d6 under the presence of a Lewis acid H/D exchange catalyst such as trifluoromethanesulfonic acid, aluminum trichloride or ethyl aluminum dichloride.

In the present disclosure, a "deuteration ratio" or "deuterium substitution ratio" may be identified using known methods such as nuclear magnetic resonance (1H NMR), TLC/MS (thin-layer chromatography/mass spectrometry) or GC/MS (gas chromatography/mass spectrometry).

In the present disclosure, a "deuterated analogue" refers to a structural analogue of a compound or group in which one or more available hydrogens are replaced by deuterium.

In one embodiment of the present disclosure, at least one of the compound of Chemical Formula 1 or the copolymer of Chemical Formula 3 may be 10% to 100% deuterated.

In one embodiment of the present disclosure, the copolymer of Chemical Formula 3 is 5% to 100% deuterated.

In one embodiment of the present disclosure, the copolymer of Chemical Formula 3 is 40% to 100% deuterated.

In one embodiment of the present disclosure, the copolymer of Chemical Formula 3 is 50% to 100% deuterated.

According to one embodiment of the present disclosure, one or more of the compound of Chemical Formula 1 or the copolymer of Chemical Formula 3 may be deuterated. When a hydrogen position is substituted with deuterium, chemical properties of a compound hardly change. However, physical properties of the deuterated compound change since deuterium has twice the atomic weight of hydrogen. For example, the deuterated compound has decreased vibrational energy, and the decrease in the vibrational energy level may prevent a decrease in the intermolecular Van der Waals force or a decrease in the quantum efficiency due to collision caused from intermolecular vibration. Accordingly, a device including the deuterated compound has improved efficiency and lifetime.

Throughout the disclosure of the present application, a term "combination thereof" included in a Markush-type expression means a mixture or a combination of one or more selected from the group consisting of constituents described in the Markush-type expression, and means including one or more selected from the group consisting of the constituents.

Examples of substituents in the present disclosure are described below, however, the substituents are not limited thereto.

In the present disclosure, " ", "-----" and "*" each mean a linked site.

In the present disclosure, the term "substitution" means a hydrogen atom bonding to a carbon atom of a compound being changed to another substituent, and the position of substitution is not limited as long as it is a position at which the hydrogen atom is substituted, that is, a position at which a substituent is capable of substituting, and when two or more substituents substitute, the two or more substituents may be the same as or different from each other.

In the present disclosure, the term "substituted or unsubstituted" means being substituted with one or more substituents selected from the group consisting of deuterium; a halogen group; a cyano group; an alkyl group; a cycloalkyl group; an alkoxy group; a silyl group; an aryl group; a germanium group; a curing group; and a heteroaryl group, or being substituted with a substituent linking two or more substituents among the substituents illustrated above, or having no substituents.

In the present disclosure, the halogen group is a fluoro group (-F), a chloro group (-Cl), a bromo group (-Br) or an iodo group (-I).

In the present disclosure, the alkyl group may be linear or branched, and although not particularly limited thereto, the number of carbon atoms may be from 1 to 20. According to another embodiment, the number of carbon atoms of the alkyl group is from 1 to 10. Specific examples of the alkyl group may include a methyl group, an ethyl group, an n-propyl group, an isopropyl group, an n-butyl group, an isobutyl group, a tert-butyl group, an n-pentyl group, an n-hexyl group, an n-heptyl group and the like, but are not limited thereto.

In the present disclosure, the cycloalkyl group is not particularly limited, but may have 3 to 60 carbon atoms, and according to one embodiment, the number of carbon atoms of the cycloalkyl group is from 3 to 30. According to another embodiment, the number of carbon atoms of the cycloalkyl group is from 3 to 20. Specific examples of the cycloalkyl group may include a cyclopropyl group, a cyclobutyl group, a cyclopentyl group, a cyclohexyl group, a cycloheptyl group, a cyclooctyl group and the like, but are not limited thereto.

In the present disclosure, the alkoxy group may be linear or branched. The number of carbon atoms of the alkoxy group is not particularly limited, but may be from 1 to 20. Specific examples of the alkoxy group may include a methoxy group, an ethoxy group, an n-propoxy group, an n-butoxy group, a tert-butoxy group, an n-pentyloxy group, an n-hexyloxy group, an n-octyloxy group, an n-nonyloxy group, an n-decyloxy group and the like, but are not limited thereto.

In the present disclosure, the amino group means -NRR', and R and R' are the same as or different from each other and may be each independently an alkyl group, an aryl group, or a deuterated analogue thereof.

In the present disclosure, the aryloxy group means -OR, and R means an aryl group.

In the present disclosure, the germanium group means - GeRR'R", and R, R' and R" are the same as or different from each other and each independently hydrogen, deuterium, an alkyl group, a deuterated alkyl group, a fluoroalkyl group, a deuterated partial-fluorinated alkyl group, an aryl group or a deuterated aryl group.

In the present disclosure, the silyl group means - SiRR'R", and R, R' and R" are the same as or different from each other and each independently hydrogen, deuterium, an alkyl group, a deuterated alkyl group, a fluoroalkyl group, an aryl group or a deuterated aryl group. In some embodiments, when R, R', R" are each an alkyl group, one or more carbons in the alkyl group are replaced by Si.

In the present disclosure, the siloxane group means - SiR₂OSiR₃, and Rs are the same as or different from each other and each independently hydrogen, deuterium, an alkyl group, a deuterated alkyl group, a fluoroalkyl group, an aryl group or a deuterated aryl group. In some embodiments, when R is an alkyl group, one or more carbons in the alkyl group are replaced by Si.

In the present disclosure, the siloxy group means -OSiR₃, and Rs are the same as or different from each other and each independently hydrogen, deuterium, an alkyl group, a deuterated alkyl group, a fluoroalkyl group, an aryl group or a deuterated aryl group.

In the present disclosure, the aryl group is not particularly limited, but may have 6 to 60 carbon atoms, and the aryl group may be a monocyclic aryl group or a polycyclic aryl group. According to one embodiment, the number of carbon atoms of the aryl group is from 6 to 30. According to one embodiment, the number of carbon atoms of the aryl group is from 6 to 20. When the aryl group is a monocyclic aryl group, examples thereof may include a phenyl group, a biphenyl group, a terphenyl group and the like, but are not limited thereto. When the aryl group is a polycyclic aryl group, examples thereof may include a naphthyl group, an anthracenyl group, a phenanthrenyl group, a pyrenyl group, a perylenyl group, a triphenylenyl group, a chrysenyl group, a fluorenyl group and the like, but are not limited thereto.

In the present disclosure, the fluorenyl group may be substituted, and two substituents may bond to each other to form a spiro structure.

When the fluorenyl group is substituted, a spirofluorenyl group such as 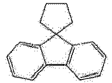 and 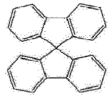 , and a substituted fluorenyl group such as 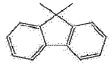 (9,9-dimethylfluorenyl group) and 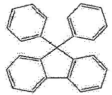 (9,9-diphenylfluorenyl group) may be included. However, the structure is not limited thereto.

In the present disclosure, the heteroaryl group is an aromatic cyclic group including one or more of N, O, P, S, Si or Se as a heteroatom, and although not particularly limited thereto, the number of carbon atoms may be from 2 to 60. According to one embodiment, the number of carbon atoms of the heteroaryl group is from 2 to 30. Examples of the heteroaryl group may include a pyridine group, a pyrrole group, a pyrimidine group, a pyridazine group, a furan group, a thiophene group, a benzothiophene group, a benzofuran group, a dibenzothiophene group, a dibenzofuran group and the like, but are not limited thereto.

In the present disclosure, the descriptions on the aryl group provided above may be applied to the arylene group except that the arylene group is divalent.

In the present disclosure, the descriptions on the heteroaryl group provided above may be applied to the heteroarylene group except that the heteroarylene group is divalent.

In the present disclosure, an aliphatic ring is a hydrocarbon ring that is not aromatic, and examples thereof may include the examples of the cycloalkyl group described above, an adamantly group and the like.

In the present disclosure, the descriptions on the aryl group provided above may be applied to the aromatic ring.

In the present disclosure, an "adjacent" group may mean a substituent substituting an atom directly linked to an atom substituted by the corresponding substituent, a substituent sterically most closely positioned to the corresponding substituent, or another substituent substituting an atom substituted by the corresponding substituent. For example, two substituents substituting ortho positions in a benzene ring, and two substituents substituting the same carbon in an aliphatic ring may be interpreted as groups "adjacent" to each other. In Chemical Formula 1 of the present disclosure, R1 and R2 may be adjacent groups, and R3 and R4 may be adjacent groups.

In the present disclosure, the "ring" in the substituted or unsubstituted ring formed by bonding to each other means a hydrocarbon ring; or a heteroring. The hydrocarbon ring may be aromatic, aliphatic, or a fused ring of aromatic and aliphatic. As for the heteroring, the descriptions on the heterocyclic group may be applied except for those that are divalent.

In the present disclosure, the descriptions on the aryl group provided above may be applied to the aromatic hydrocarbon ring except for those that are divalent.

In the present disclosure, the descriptions on the cycloalkyl group provided above may be applied to the aliphatic hydrocarbon ring except for those that are divalent.

In the present disclosure, a mole fraction means a ratio of the number of moles of a given component with respect to the total number of moles of all components.

In the present disclosure, a "monomer unit" intends to mean a repeating unit in a polymer or copolymer.

Hereinafter, Chemical Formula 1 will be described.

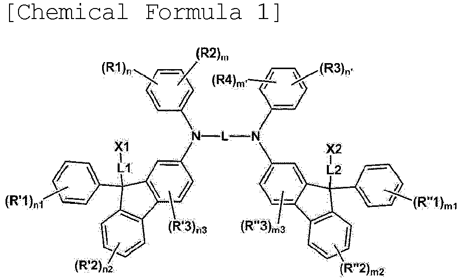

In Chemical Formula 1,
L is a substituted or unsubstituted C₆₋₆₀ arylene group; or a substituted or unsubstituted C₂₋₆₀ heteroarylene group including one or more heteroatoms selected from the group consisting of N, O and S,
R1 and R3 are the same as or different from each other, and each independently a halogen group,
R2 and R4 are the same as or different from each other, and each independently hydrogen; deuterium; or a C₁₋₁₀ alkyl group,
L1 and L2 are the same as or different from each other, and each independently a direct bond; or a methylene group,
X1 and X2 are the same as or different from each other, and each independently a curing group,
R'1, R'2, R'3, R"1, R"2 and R"3 are the same as or different from each other, and each independently hydrogen; deuterium; a substituted or unsubstituted C₁₋₆₀ alkyl group; a substituted or unsubstituted C₁₋₆₀ alkoxy group; a substituted or unsubstituted C₆₋₆₀ aryl group; or a C₂₋₆₀ heteroaryl group including one or more heteroatoms selected from the group consisting of N, O and S,
n and n' are each independently an integer of 1 to 5, m and m' are each independently 0 or 1, n+m is 5 or less, and n'+m' is 5 or less,
n1 and m1 are each independently an integer of 0 to 5, n2 and m2 are each independently an integer of 0 to 4, and n3 and m3 are each independently an integer of 0 to 3, and
when n, n', n1 to n3 and m1 to m3 are each 2 or greater, substituents in the two or more parentheses are the same as or different from each other.

According to one embodiment of the present disclosure, L is a substituted or unsubstituted C₆₋₃₀ arylene group; or a substituted or unsubstituted C₂₋₃₀ heteroarylene group including one or more heteroatoms selected from the group consisting of N, O and S.

According to one embodiment of the present disclosure, L is a substituted or unsubstituted phenylene group; a substituted or unsubstituted biphenylylene group; or a substituted or unsubstituted spirofluorenylene group.

In one embodiment of the present disclosure, L is any one of the following structures.

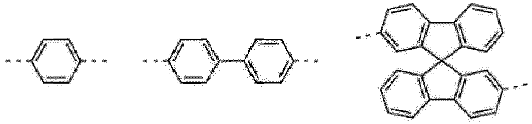

According to one embodiment of the present disclosure, R1 and R3 are each a fluoro group (-F).

In one embodiment of the present disclosure, R2 and R4 are the same as or different from each other, and each independently hydrogen; deuterium; or a methyl group.

According to one embodiment of the present disclosure, R1 and R3 are each a fluoro group, and R2 and R4 are the same as or different from each other and each independently hydrogen; deuterium; or a methyl group.

In one embodiment of the present disclosure, L1 and L2 are the same as or different from each other, and each independently a direct bond or a methylene group.

According to one embodiment of the present disclosure, X1 and X2 are the same as or different from each other, and each independently a curing group. Herein, the curing group may include the structures described above.

In another embodiment, X1 and X2 are each

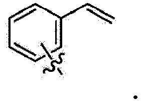

According to one embodiment of the present disclosure, R'1, R'2, R'3, R"1, R"2 and R"3 are the same as or different from each other, and each independently hydrogen; deuterium; or a substituted or unsubstituted C₁₋₆₀ alkyl group.

According to another embodiment, R'1 and R"1 are hydrogen; deuterium; or a methyl group.

According to one embodiment of the present disclosure, R'2, R'3, R"2 and R"3 are each hydrogen.

In another embodiment, R'1 and R"1 are a methyl group, and n1 and m1 are each independently an integer of 0 to 2.

According to one embodiment of the present disclosure, n2, n3, m2 and m3 are each independently 0 or 1.

In one embodiment of the present disclosure, Chemical Formula 1 is any one selected from among the following structures.

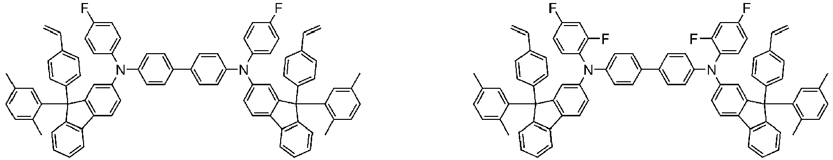

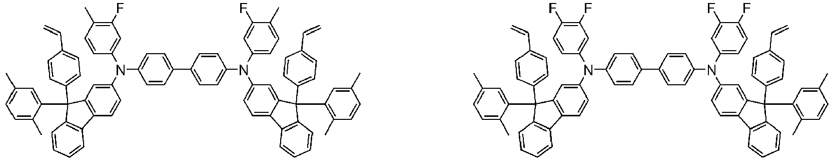

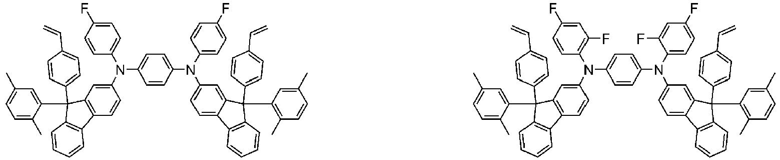

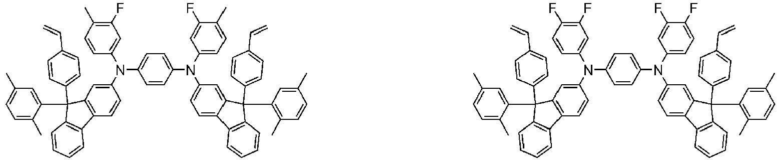

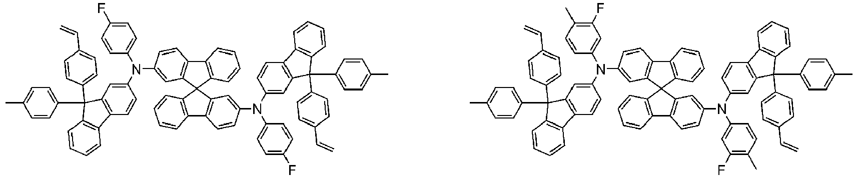

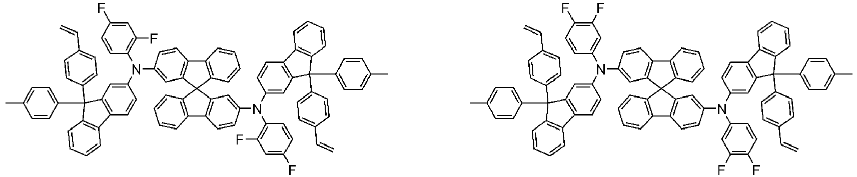

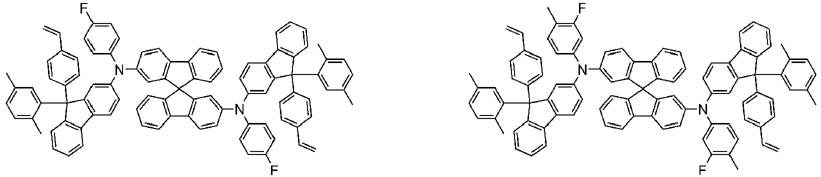

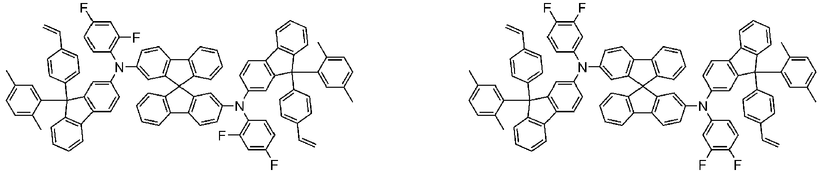

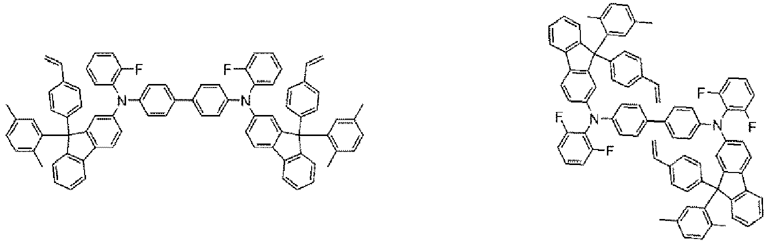

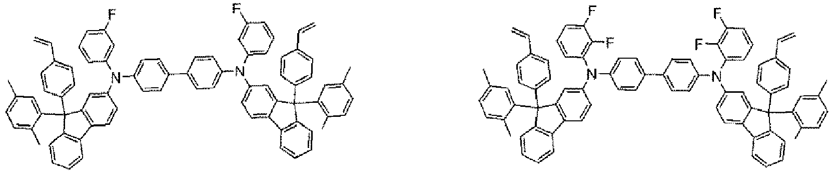

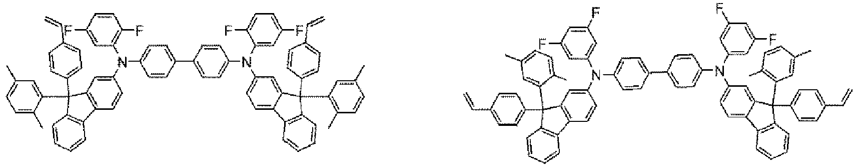

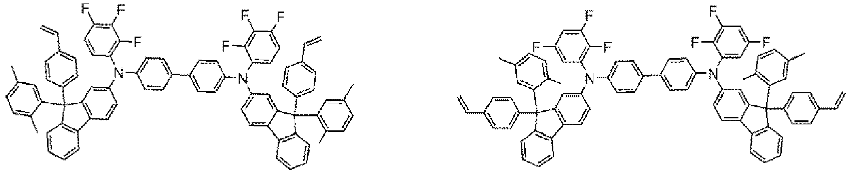

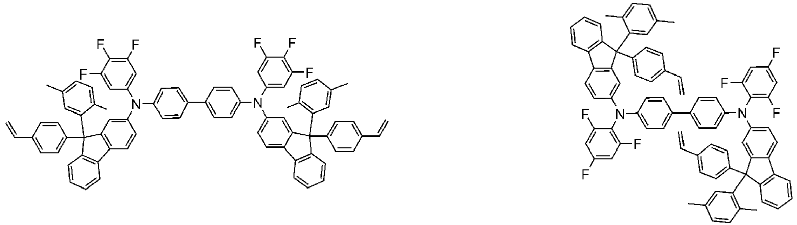

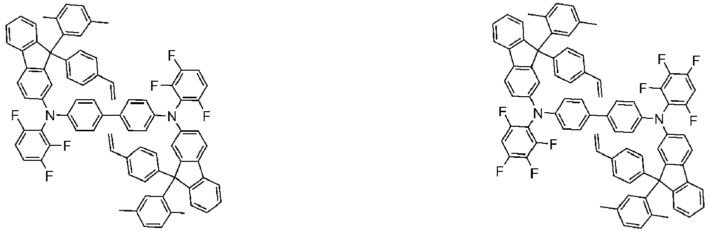

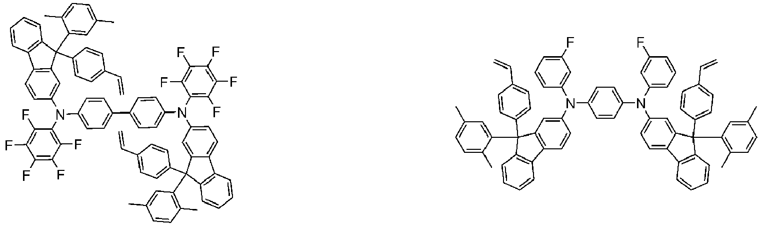

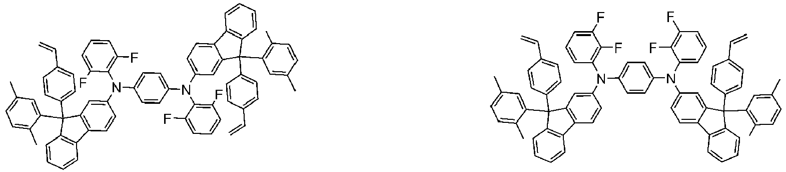

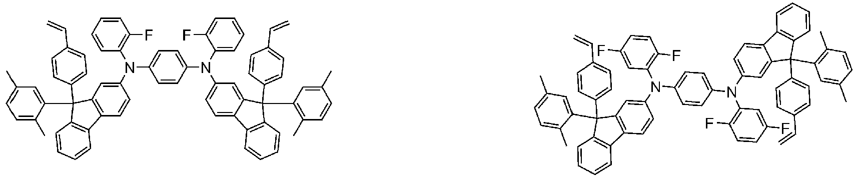

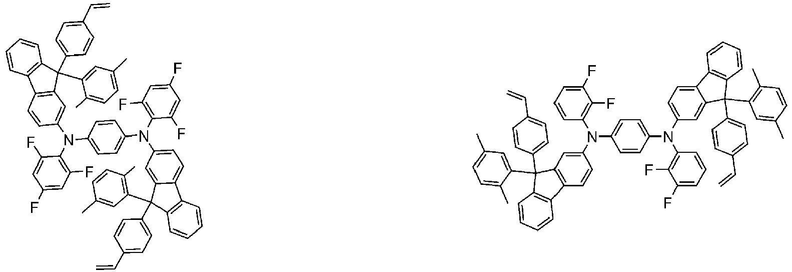

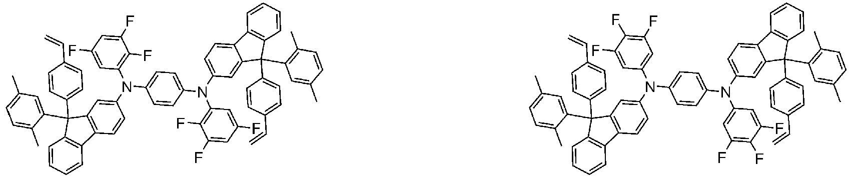

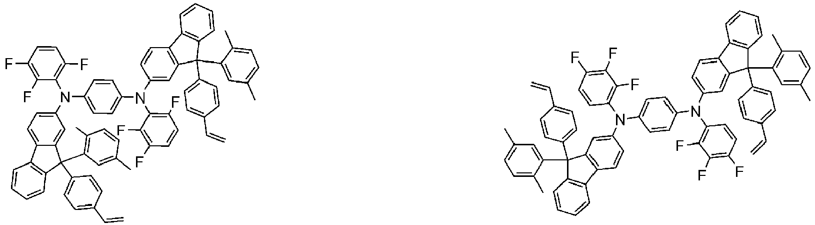

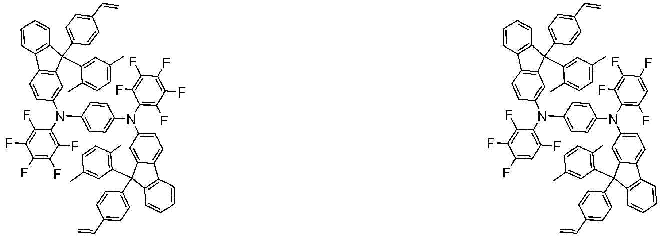

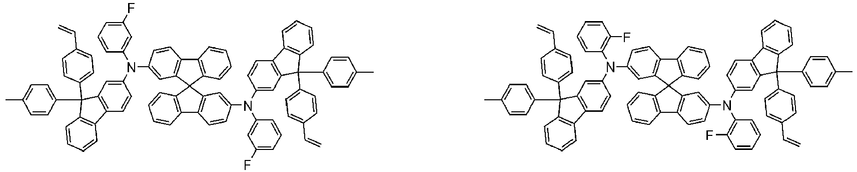

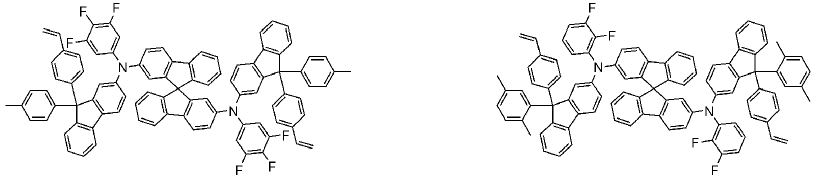

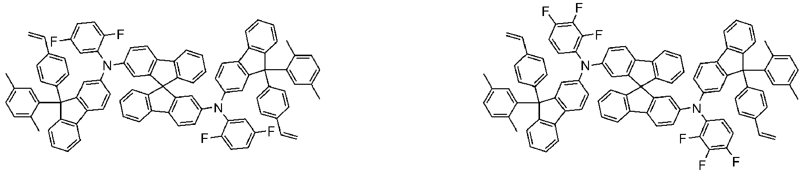

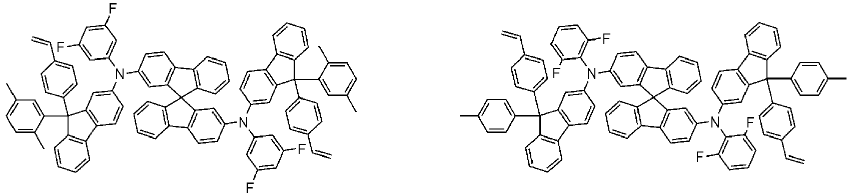

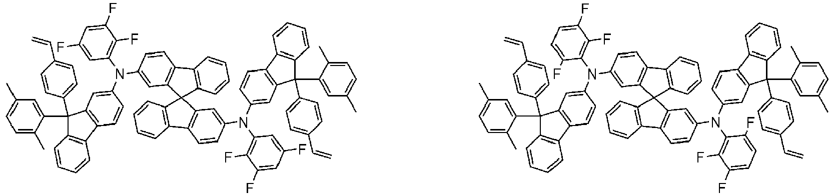

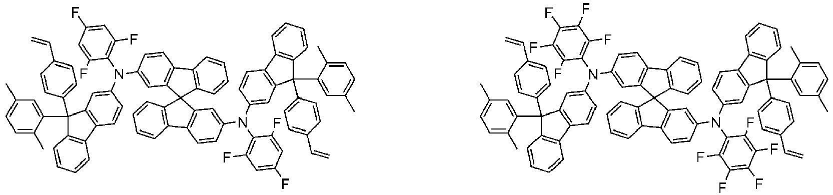

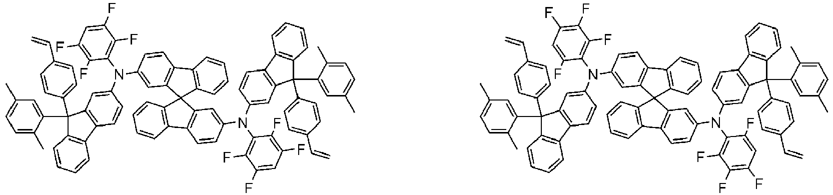

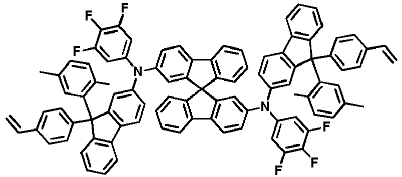

According to the present invention, the first organic material layer further includes an ionic compound including an anion group of the following Chemical Formula 2.

### [Chemical Formula 2]

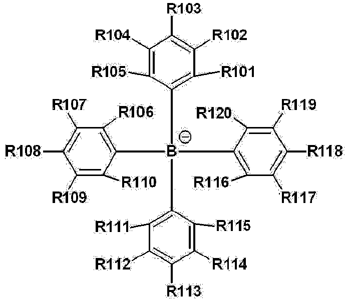

In Chemical Formula 2,
at least one of R101 to R120 is a curing group,
at least one of the rest of R101 to R120 that are not the curing group is F; a cyano group; or a substituted or unsubstituted fluoroalkyl group,
the rest of R101 to R120 that are not the curing group; the F; the cyano group; or the substituted or unsubstituted fluoroalkyl group are the same as or different from each other, and each independently hydrogen; deuterium; a nitro group; - C(O)R₂₀₁; -OR₂₀₂; -SR₂₀₃; -SO₃R₂₀₄; -COOR₂₀₅; -OC(O)R₂₀₆; - C(O)NR₂₀₇R₂₀₈; a substituted or unsubstituted alkyl group; a substituted or unsubstituted alkenyl group; a substituted or unsubstituted amine group; a substituted or unsubstituted aryl group; or a substituted or unsubstituted heterocyclic group, and
R₂₀₁ to R₂₀₈ are the same as or different from each other, and each independently hydrogen; deuterium; or a substituted or unsubstituted alkyl group.

Hereinafter, the ionic compound including the anion group of Chemical Formula 2 will be described.

According to one embodiment of the present disclosure, the anion group represented by Chemical Formula 2 includes a curing group in at least one of R101 to R120.

According to one embodiment of the present disclosure, the anion group represented by Chemical Formula 2 has one to four curing groups.

In another embodiment, the anion group represented by Chemical Formula 2 has one curing group.

According to another embodiment, the anion group represented by Chemical Formula 2 has two curing groups.

In another embodiment, the anion group represented by Chemical Formula 2 has four curing groups. The anion group represented by Chemical Formula 2 is not cured when not having a curing group, and device properties decline since a cationic group and the anion group of the present disclosure move between electrode layers. In addition, the curing rate of a coating composition increases and film retention is enhanced as the number of curing groups increases, and therefore, the compound with four curing groups is more preferred.

In one embodiment of the present disclosure, the anion group represented by Chemical Formula 2 has 8 to 19 Fs; cyano groups; or substituted or unsubstituted fluoroalkyl groups.

According to one embodiment of the present disclosure, the parts by weight of F in the anion group represented by Chemical Formula 2 is from 15 parts by weight to 50 parts by weight with respect to 100 parts by weight of the anion group.

According to one embodiment of the present disclosure, the anion group represented by Chemical Formula 2 has 8 to 19 Fs.

In one embodiment of the present disclosure, the first organic material layer may be a hole injection layer, and the ionic compound may be used as a dopant. Herein, as the content of F increases in the anion group, the force of attracting electrons from other compounds (host compounds) increases, which more favorably generates holes in the host, and as a result, performance in the hole injection layer is enhanced.

According to one embodiment of the present disclosure, the content of F may be analyzed using a COSA AQF-100 combustion furnace coupled to a Dionex ICS 2000 ion-chromatograph or identified through 19F NMR, a method generally used for analyzing F.

In one embodiment of the present disclosure, at least one benzene ring of the R101 to R105-bonding benzene ring, the R106 to R110-bonding benzene ring, the R111 to R115-bonding benzene ring and the R116 to R120-bonding benzene ring in Chemical Formula 2 is selected from among the following structural formulae.

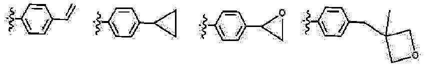

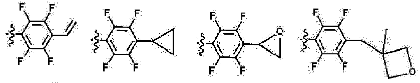

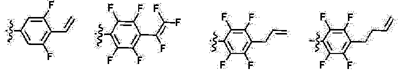

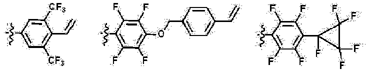

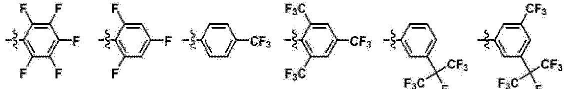

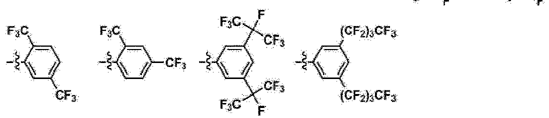

According to one embodiment of the present disclosure, the ionic compound includes a cationic group, and the cationic group is selected from among monovalent cation groups, onium compounds or the following structural formulae.

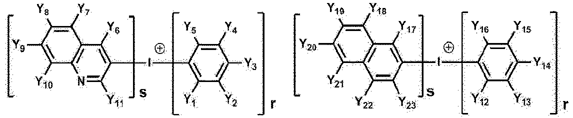

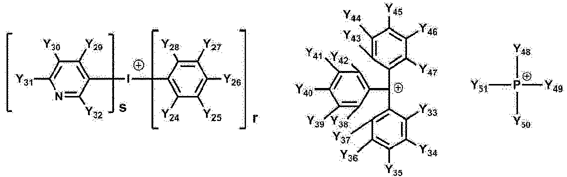

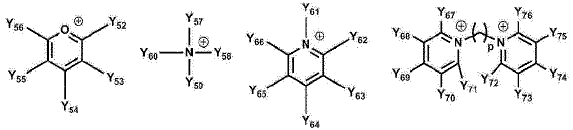

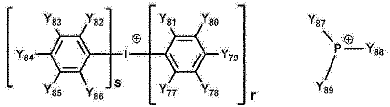

In the structural formulae,
Y₁ to Y₈₉ are the same as or different from each other, and each independently hydrogen; a cyano group; a nitro group; a halogen group; a hydroxyl group; -COOR₃₀₅; a substituted or unsubstituted alkyl group; a substituted or unsubstituted alkoxy group; a substituted or unsubstituted aryloxy group; a substituted or unsubstituted cycloalkyl group; a substituted or unsubstituted fluoroalkyl group; a substituted or unsubstituted aryl group; or a curing group,
R₃₀₅ is hydrogen; deuterium; or a substituted or unsubstituted alkyl group,
p is an integer of 0 to 10, and
r is 1 or 2, s is 0 or 1, and r+s=2.

In the present disclosure, the onium compound means a compound formed by hydrogen ions or other radicals coordinate bonding to an unshared electron pair of iodine, oxygen, sulfur, nitrogen, phosphorous and the like.

According to one embodiment of the present disclosure, Y₁ to Y₈₉ are the same as or different from each other, and each independently hydrogen; a cyano group; a nitro group; F; Cl; a hydroxyl group; -COOR₃₀₅; a methyl group; a methyl group substituted with a phenylmethoxy group; an ethyl group; a propyl group; a butyl group; a pentyl group; a hexyl group; a methoxy group; a phenyl-substituted methoxy group; a phenyloxy group; a cyclopropyl group; ethoxyethoxy; a phenyl group; a naphthyl group; or a curing group, and R₃₀₅ is a methyl group.

According to one embodiment of the present disclosure, examples of the monovalent cation group may include Na⁺, Li⁺, K⁺ and the like, but are not limited thereto.

In one embodiment of the present disclosure, the cationic group is selected from among the following structural formulae.

| | | | |
|---|---|---|---|
| 1-1 | 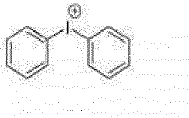 | 1-6 | 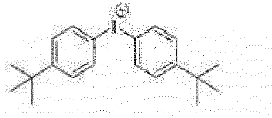 |
| 1-2 | 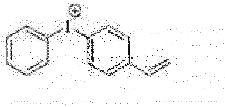 | 1-7 | 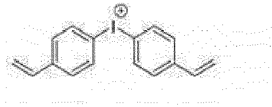 |
| 1-3 | 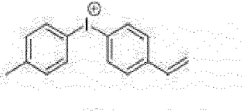 | 1-8 | 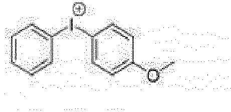 |
| 1-4 | 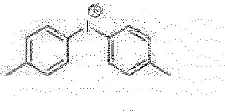 | 1-9 | 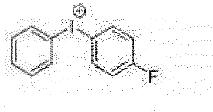 |
| 1-5 | 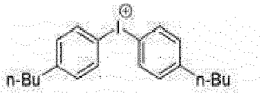 | 1-10 | 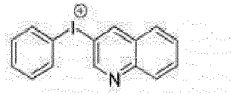 |

| | | | |
|---|---|---|---|
| 1-11 | 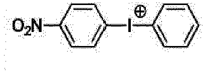 | 1-12 | 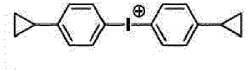 |
| 1-13 | 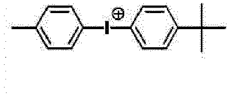 | 1-14 | 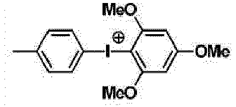 |
| 1-15 | 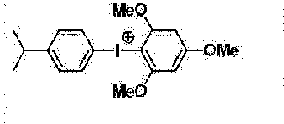 | 1-16 | 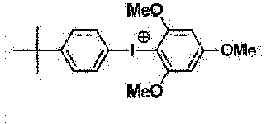 |
| 1-17 | 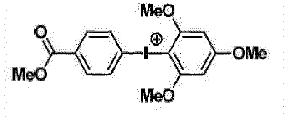 | 1-18 | 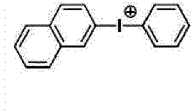 |
| 1-19 | 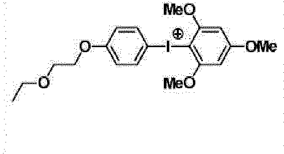 | 1-20 | 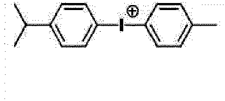 |
| 1-21 | 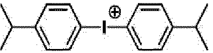 | 1-22 | 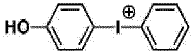 |
| 1-23 | 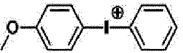 | 1-24 | 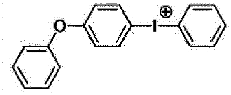 |
| 1-25 | 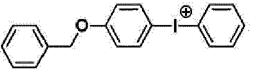 | 1-26 | 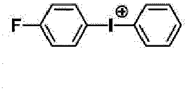 |
| 1-27 | 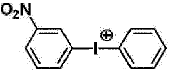 | 1-28 | 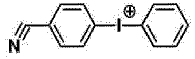 |
| 1-29 | 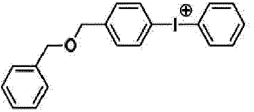 | 1-30 | 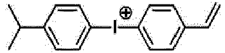 |

| | | | |
|---|---|---|---|
| 3-1 | 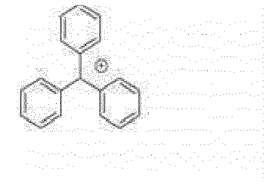 | 3-3 | 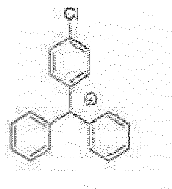 |
| 3-2 | 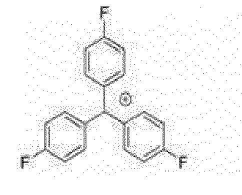 | | |

| | | | |
|---|---|---|---|
| 4-1 | 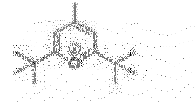 | 4-3 | 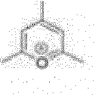 |
| 4-2 | 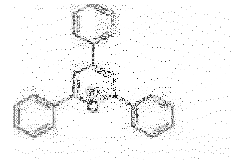 | | |

| | | | |
|---|---|---|---|
| 5-1 | 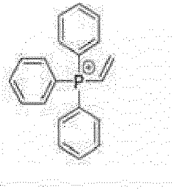 | 5-4 | 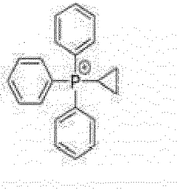 |
| 5-2 | 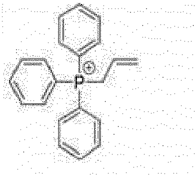 | 5-5 | 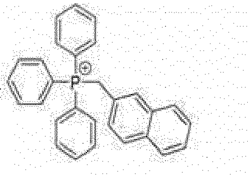 |
| 5-3 | 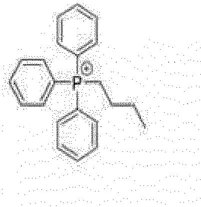 | 5-6 | 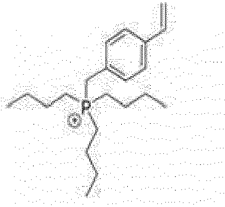 |

| | | | |
|---|---|---|---|
| 5-7 | 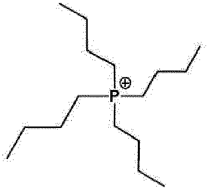 | 5-8 | 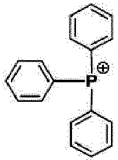 |

| | | | |
|---|---|---|---|
| 6-1 | 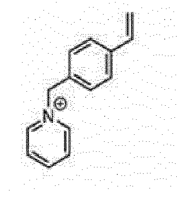 | 6-3 | 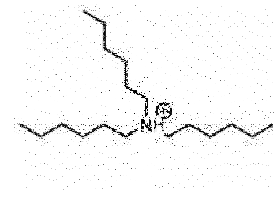 |
| 6-2 | 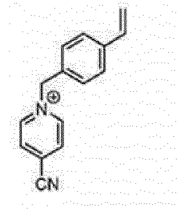 | 6-4 | 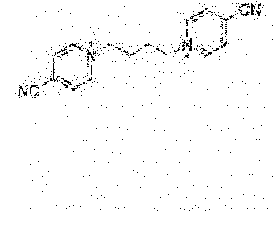 |
| 6-5 | 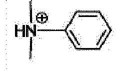 | 6-6 | 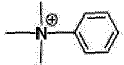 |
| 6-7 | 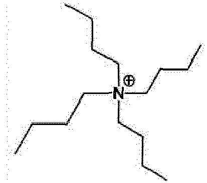 | | |

According to one embodiment of the present disclosure, the ionic compound is selected from among the following structural formulae.

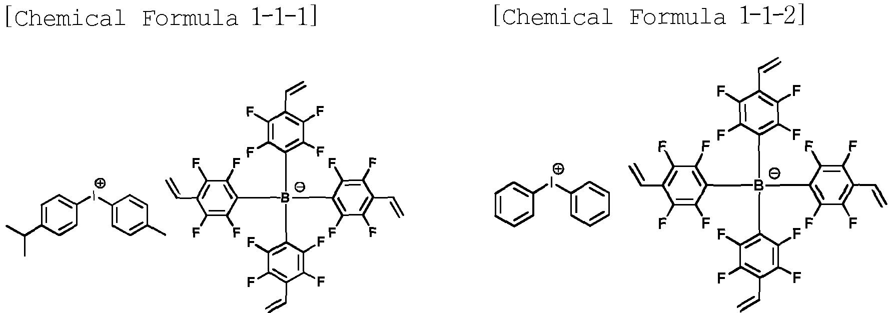

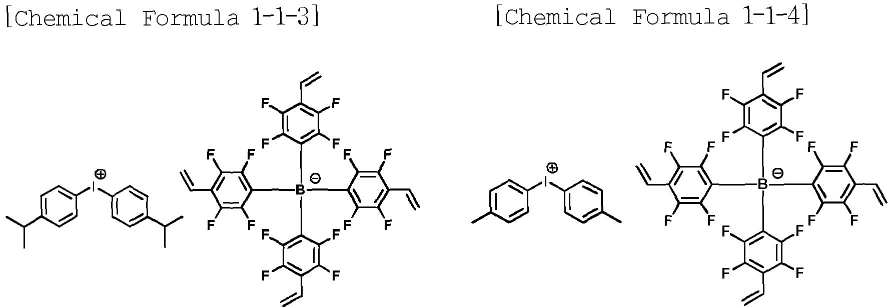

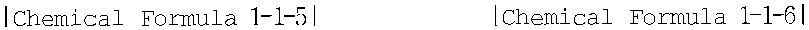

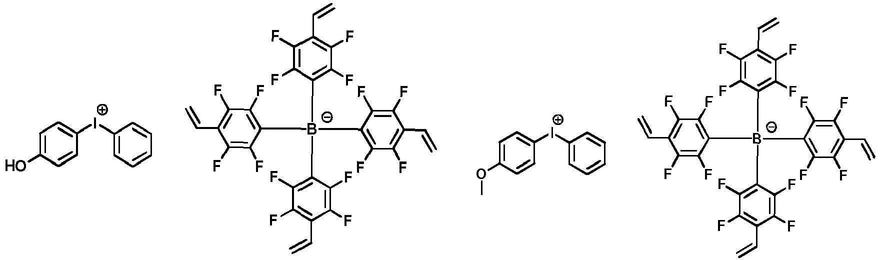

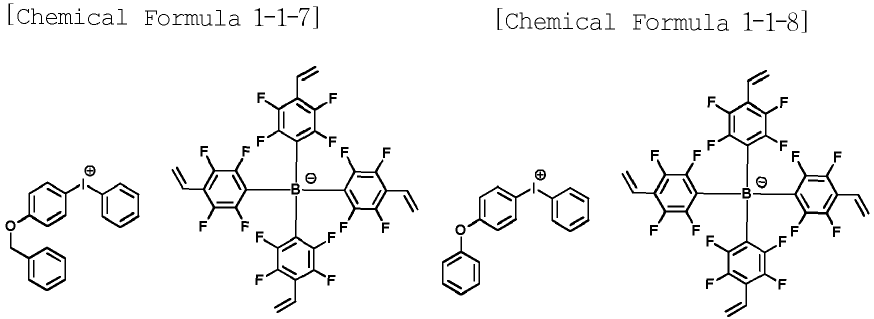

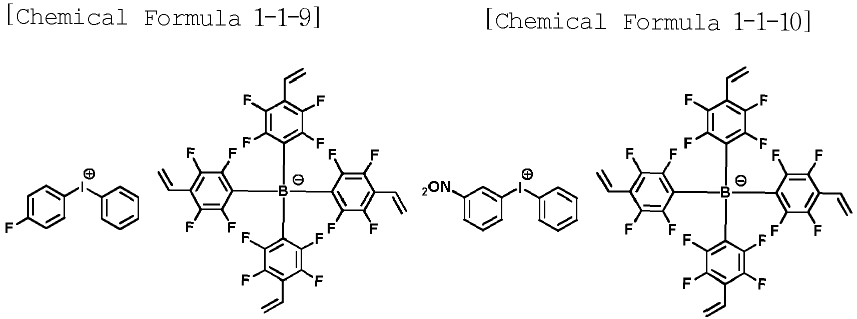

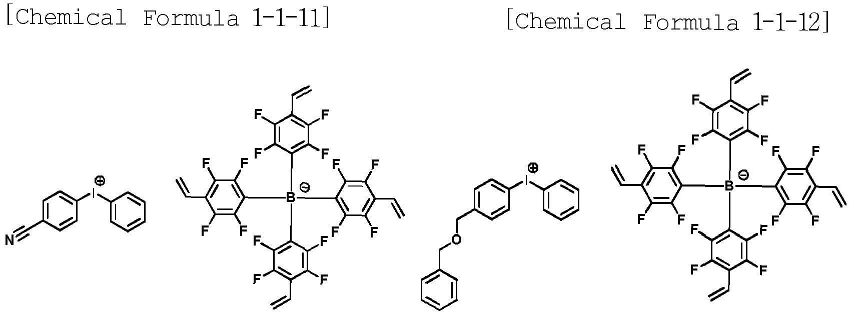

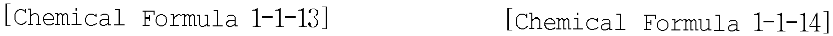

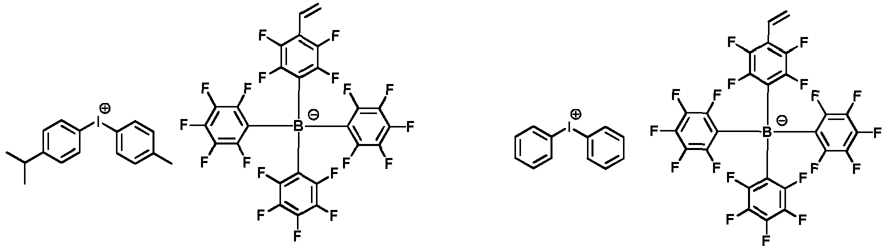

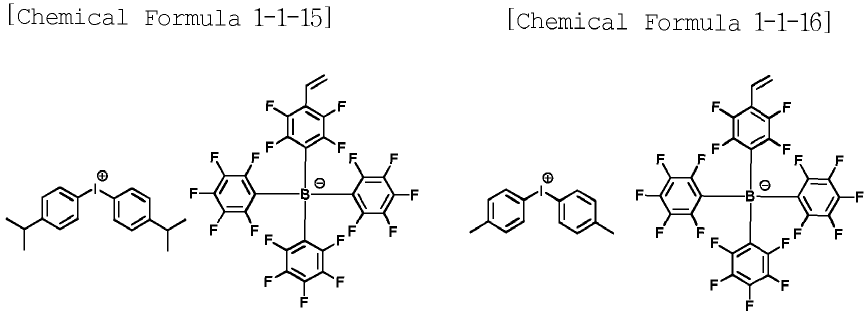

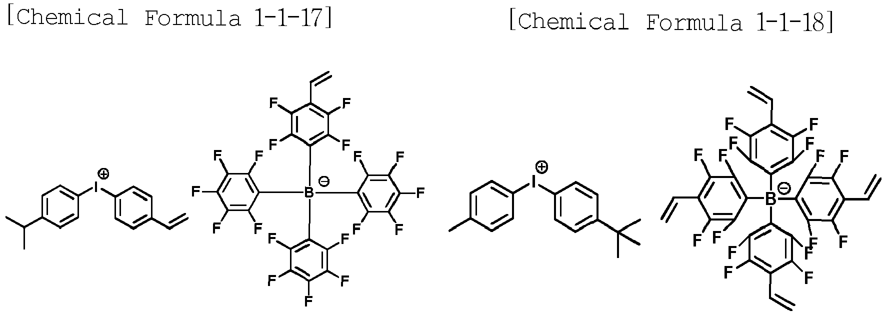

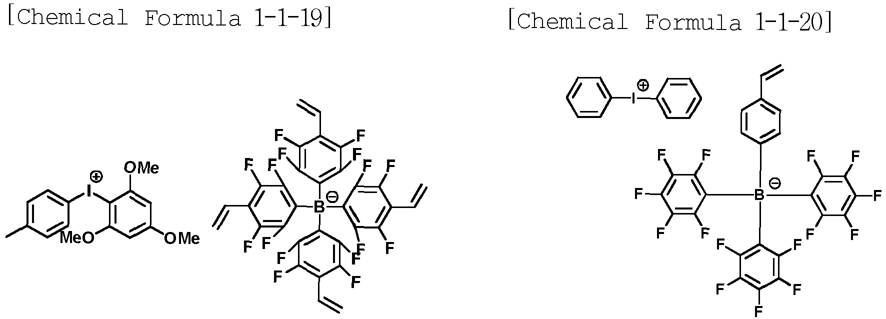

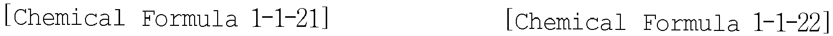

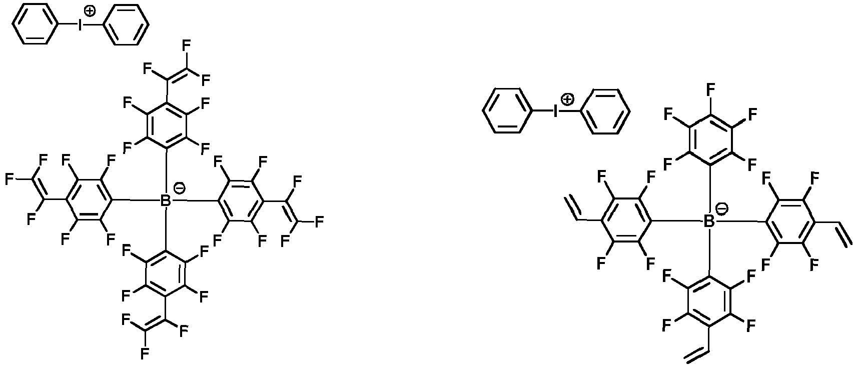

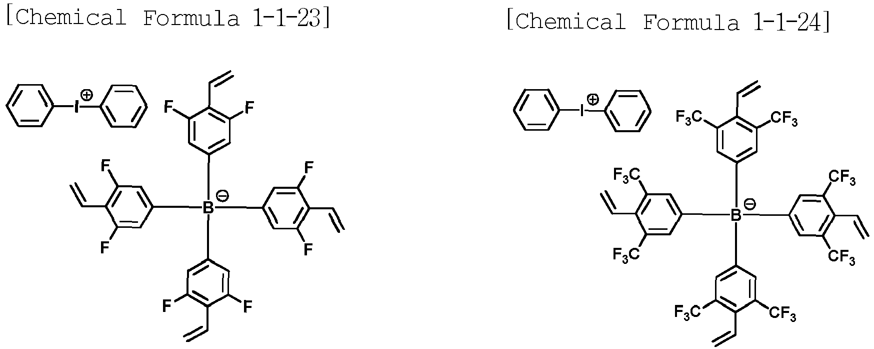

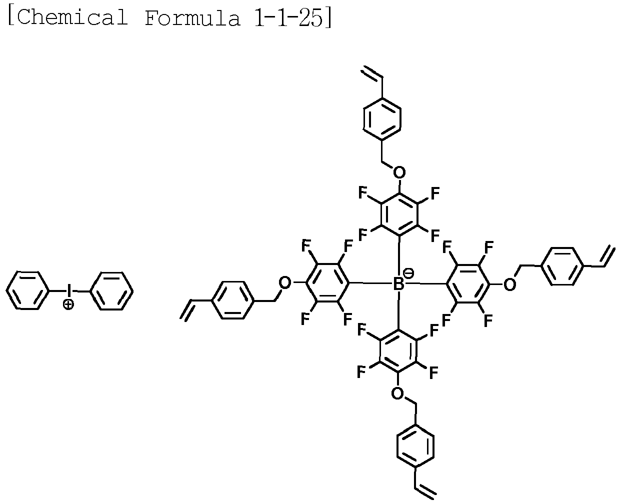

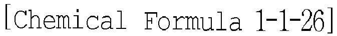

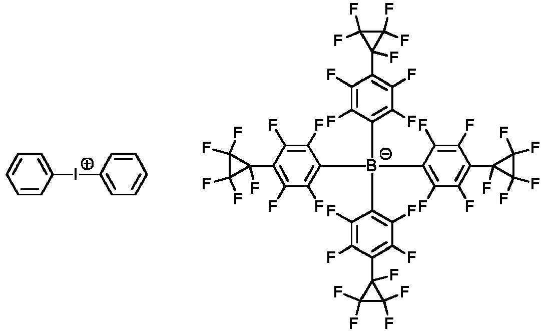

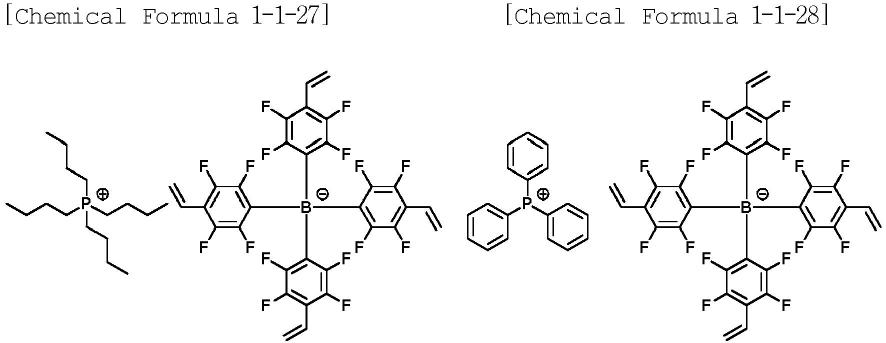

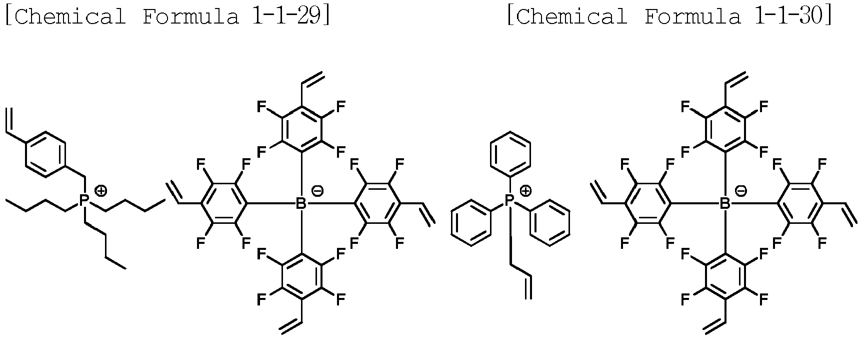

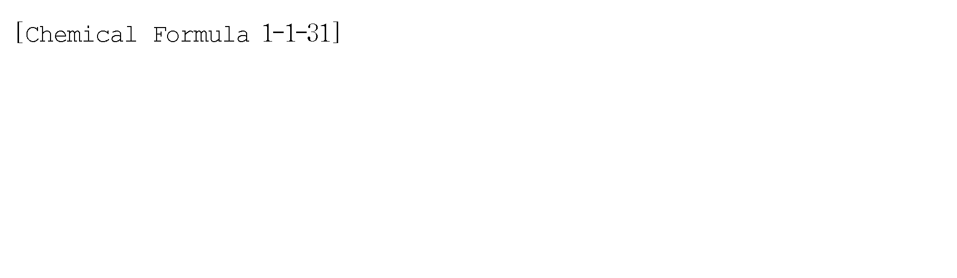

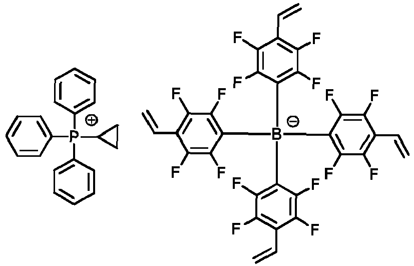

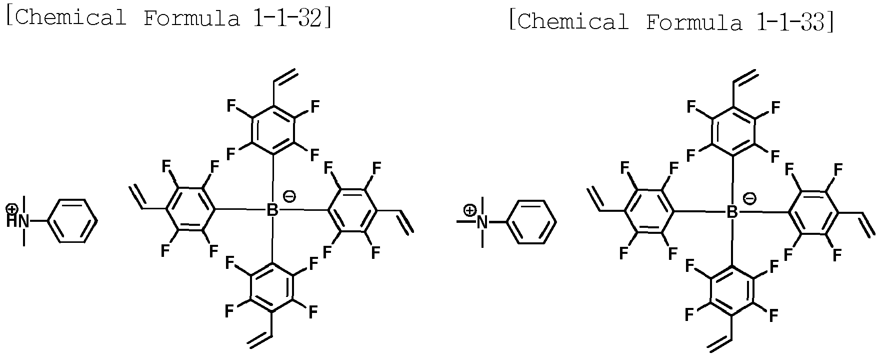

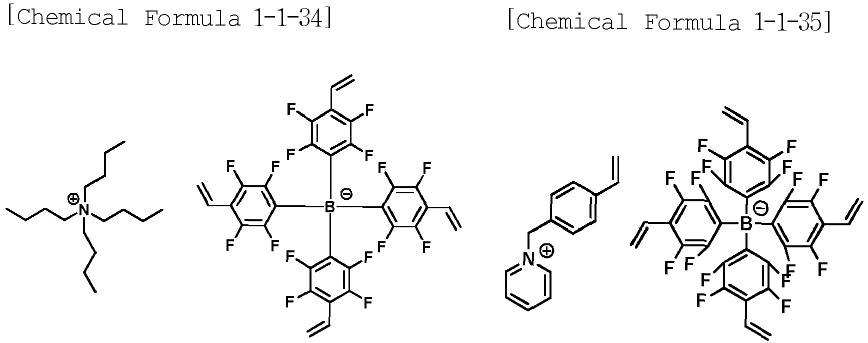

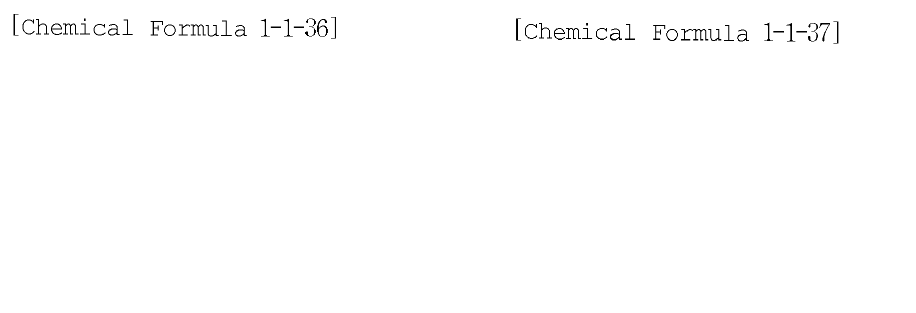

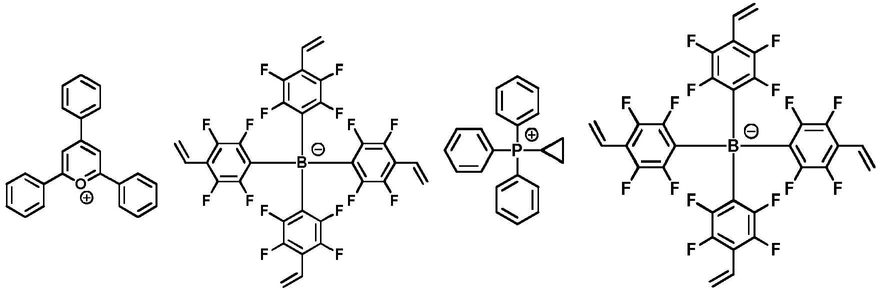

In one embodiment of the present disclosure, a composition including the compound of Chemical Formula 1 and the ionic compound including the anion group of Chemical Formula 2 includes the ionic compound including the anion group of Chemical Formula 2 in 5 parts by weight to 50 parts by weight with respect to 100 parts by weight of the compound of Chemical Formula 1.

Hereinafter, the copolymer of Chemical Formula 3 will be described.

According to the present invention, the copolymer of Chemical Formula 3 is represented as follows.

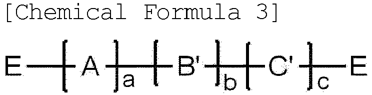

In Chemical Formula 3,
A is a monomer unit including at least one triarylamine group,
B' is a monomer unit having at least three bonding points in the copolymer,
C' is an aromatic monomer unit or a deuterated analogue thereof,
Es are the same as or different from each other, and each independently selected from the group consisting of hydrogen; deuterium; a halogen group; a substituted or unsubstituted alkyl group; a substituted or unsubstituted silyl group; a substituted or unsubstituted germanium group; a substituted or unsubstituted aryl group; a substituted or unsubstituted arylamino group; a substituted or unsubstituted siloxane group; and a substituted or unsubstituted curing group, and
a, b and c are a mole fraction, a+b+c=1, a≠0, and b≠0.
a, b and c are the same as or different from each other.

According to another embodiment, Chemical Formula 3 may be represented by the following Chemical Formula 3'.

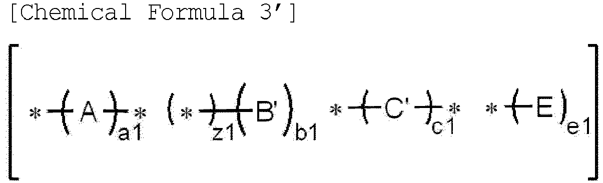

In Chemical Formula 3',
A is a monomer unit including at least one triarylamine group,
B' is a monomer unit having at least three bonding points in the copolymer,
C' is an aromatic monomer unit or a deuterated analogue thereof,
Es are the same as or different from each other, and each independently selected from the group consisting of hydrogen; deuterium; a halogen group; a substituted or unsubstituted alkyl group; a substituted or unsubstituted aryl group; a substituted or unsubstituted arylamino group; a substituted or unsubstituted siloxane group; and a substituted or unsubstituted curing group,
a1, b1, c1 and e1 are a mole fraction, a1+b1+c1+e1=1, a1≠0, and b1≠0,
z1 is an integer of 3 or greater, and
* means an attaching point in the copolymer.
a1, b1, c1 and e1 are the same as or different from each other.

According to one embodiment of the present disclosure, all the embodiments on A, B', C' and E described below for Chemical Formula 3 apply equally to Chemical Formula 3'.

In one embodiment of the present disclosure, A, B' and optional C' units are arranged in a regular alternating pattern.

In one embodiment of the present disclosure, A, B' and optional C' units are arranged in a block form.

In one embodiment of the present disclosure, A, B' and optional C' units are arranged randomly.

According to one embodiment of the present disclosure, the copolymer of Chemical Formula 3 may be deuterated. Herein, the deuteration may be present on one or more of the monomer units A, B' and C'. In addition, the deuteration may be present on the copolymer skeleton, on the pendant group (substituent), or on both.

According to one embodiment of the present disclosure, the copolymer of Chemical Formula 3 may have a weight average molecular weight (Mw) of 10,000 g/mol to 5,000,000 g/mol, 10,000 g/mol to 2,000,000 g/mol, or 10,000 g/mol to 500,000 g/mol.

In the present disclosure, the term weight average molecular weight (Mw) means a molecular weight converted with respect to standard polystyrene measured using GPC (gel permeation chromatography).

In the present disclosure, the monomer unit A is a monomer unit including at least one triarylamine group. The monomer unit A has two bonding points in the copolymer.

According to one embodiment of the present disclosure, A is represented by the following Chemical Formula A-1.

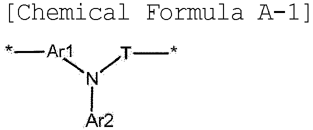

In Chemical Formula A-1,
Ar1is a substituted or unsubstituted arylene group or deuterated arylene group,
Ar2is a substituted or unsubstituted aryl group or deuterated aryl group,
T is selected from the group consisting of a direct bond; a substituted or unsubstituted arylene group; and a deuterated arylene group, and
* represents a bonding point in the copolymer.

In one embodiment of the present disclosure, A is represented by the following Chemical Formula A-2.

### [Chemical Formula A-2]

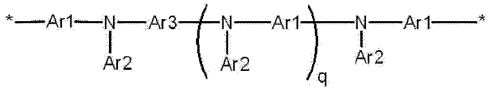

In Chemical Formula A-2,
Ar1s are the same as or different from each other, and each independently a substituted or unsubstituted arylene group or arylene group substituted with deuterium,
Ar2s are the same as or different from each other, and each independently a substituted or unsubstituted aryl group or deuterated aryl group,
Ar3is a substituted or unsubstituted aryl group or deuterated arylene group,
q is an integer of 0 or greater, and
* represents a bonding point in the copolymer.

According to one embodiment of the present disclosure, Chemical Formula A-2 is represented by the following Chemical Formula A-2-1.

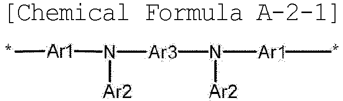

In Chemical Formula A-2-1, substituents have the same definitions as in Chemical Formula A-2.

According to one embodiment of the present disclosure, Chemical Formula A-2 is represented by the following Chemical Formula A-2-2.

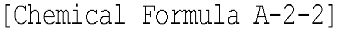

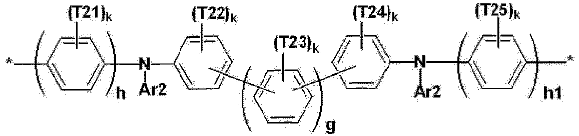

In Chemical Formula A-2-2,
Ar2s are the same as or different from each other, and each independently a substituted or unsubstituted aryl group or deuterated aryl group,
T21 to T25 are the same as or different from each other, and each independently selected from the group consisting of hydrogen; F; a cyano group; an alkyl group; a fluoroalkyl group; an aryl group; a heteroaryl group; an amino group; a silyl group; a germanium group; an alkoxy group; an aryloxy group; a fluoroalkoxy group; a siloxane group; a siloxy group; a deuterated alkyl group; a deuterated partial-fluorinated alkyl group; a deuterated aryl group; a deuterated heteroaryl group; a deuterated amino group; a deuterated silyl group; a deuterated germanium group; a deuterated alkoxy group; a deuterated aryloxy group; a deuterated fluoroalkoxy group; a deuterated siloxane group; a deuterated siloxy group; and a curing group, and herein, adjacent groups selected from among T21 to T25 may bond to each other to form a 5-membered or 6-membered aromatic ring,
ks are each independently an integer of 0 to 4, g is an integer of 0 to 3, and h and h1 are each independently 1 or 2, and
* represents a bonding point in the copolymer.

In one embodiment of the present disclosure, A is represented by the following Chemical Formula A-3.

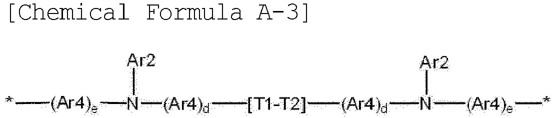

In Chemical Formula A-3,
Ar2s are the same as or different from each other, and each independently a substituted or unsubstituted aryl group or deuterated aryl group,
Ar4s are the same as or different from each other, and each independently selected from the group consisting of a substituted or unsubstituted phenylene group; a substituted or unsubstituted naphthylene group; and deuterated analogues thereof,
T1 and T2 are the same as or different from each other, and each independently a conjugated moiety linked in a nonplanar configuration, or a deuterated analogue thereof,
ds are each independently an integer of 1 to 6,
es are each independently an integer of 1 to 6, and
* represents a bonding point in the copolymer.

In one embodiment of the present disclosure, A is represented by the following Chemical Formula A-4 or A-5.

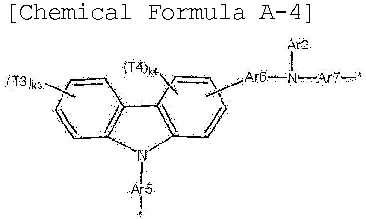

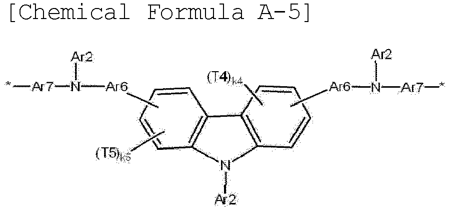

In Chemical Formulae A-4 and A-5,
Ar2s are the same as or different from each other, and each independently a substituted or unsubstituted aryl group or deuterated aryl group,
Ar5, Ar6 and Ar7 are the same as or different from each other, and each independently a substituted or unsubstituted arylene group or deuterated arylene group,
T3 to T5 are the same as or different from each other, and each independently selected from the group consisting of hydrogen; deuterium; F; a cyano group; an alkyl group; a fluoroalkyl group; an aryl group; a heteroaryl group; an amino group; a silyl group; a germanium group; an alkoxy group; an aryloxy group; a fluoroalkoxy group; a siloxane group; a siloxy group; a deuterated alkyl group; a deuterated partial-fluorinated alkyl group; a deuterated aryl group; a deuterated heteroaryl group; a deuterated amino group; a deuterated silyl group; a deuterated germanium group; a deuterated alkoxy group; a deuterated aryloxy group; a deuterated fluoroalkoxy group; a deuterated siloxane group; a deuterated siloxy group; and a curing group, and herein, adjacent groups selected from among T3, T4 and T5 may bond to each other to form a ring,
k3 is an integer of 0 to 4, and k4 and k5 are each an integer of 0 to 3, and
* represents a bonding point in the copolymer.

According to one embodiment of the present disclosure, Ar1 is selected from the group consisting of a naphthylene group, an anthracenylene group, a divalent naphthylphenyl group, a divalent phenylnaphthyl group, a divalent fluorenyl group, substituted derivatives thereof, and deuterated analogues thereof.

According to one embodiment of the present disclosure, Ar1 is an arylene group substituted with one or more substituents selected from the group consisting of deuterium; F; a cyano group; an alkyl group; a fluoroalkyl group; an aryl group; a heteroaryl group; an amino group; a silyl group; a germanium group; an alkoxy group; an aryloxy group; a fluoroalkoxy group; a siloxane group; a siloxy group; a curing group; a deuterated alkyl group; a deuterated partial-fluorinated alkyl group; a deuterated aryl group; a deuterated heteroaryl group; a deuterated amino group; a deuterated silyl group; a deuterated germanium group; a deuterated alkoxy group; a deuterated aryloxy group; a deuterated fluoroalkoxy group; a deuterated siloxane group; a deuterated siloxy group; and a deuterated curing group. According to another embodiment, the substituent is selected from the group consisting of deuterium, an alkyl group, an arylamino group, an aryl group, a deuterated alkyl group, a deuterated arylamino group and a deuterated aryl group.

According to one embodiment of the present disclosure, Ar1 is an arylene group.

According to one embodiment of the present disclosure, Ar1 is selected from the group consisting of a phenylene group; a biphenylene group; a terphenylene group; a 1-naphthylene group; a 2-naphthylene group; an anthracenylene group; a divalent fluorenyl group; deuterated analogues thereof, and derivatives thereof having one or more substituents. According to another embodiment, the one or more substituents are selected from the group consisting of a fluoro group, an alkyl group, an alkoxy group, a silyl group, a germanium group, a siloxy group, a substituent having a curing group and deuterated analogues thereof.

According to one embodiment of the present disclosure, Ar1 is an arylene group having 6 to 30 carbon atoms unsubstituted or substituted with an alkyl group having 1 to 20 carbon atoms or an arylamine group having 6 to 30 carbon atoms.

In another embodiment, Ar1 is a phenylene group unsubstituted or substituted with an alkyl group having 1 to 20 carbon atoms or an arylamine group having 6 to 30 carbon atoms; a biphenylene group unsubstituted or substituted with an alkyl group having 1 to 20 carbon atoms or an arylamine group having 6 to 30 carbon atoms; a terphenylene group unsubstituted or substituted with an alkyl group having 1 to 20 carbon atoms or an arylamine group having 6 to 30 carbon atoms; or a naphthylene group unsubstituted or substituted with an alkyl group having 1 to 20 carbon atoms or an arylamine group having 6 to 30 carbon atoms.

The descriptions on the embodiments of Ar1 apply equally to Ar3, Ar5, Ar6 and Ar7.

According to one embodiment of the present disclosure, Ar2 is selected from the group consisting of a naphthyl group, an anthracenyl group, a naphthylphenyl group, a phenylnaphthyl group, a fluorenyl group, substituted derivatives thereof, and deuterated analogues thereof.

According to one embodiment of the present disclosure, Ar2 is an aryl group.

According to one embodiment of the present disclosure, Ar2 is selected from the group consisting of a phenyl group; a biphenyl group; a terphenyl group; a 1-naphthyl group; a 2-naphthyl group; an anthracenyl group; a fluorenyl group; deuterated analogues thereof, and derivatives thereof having one or more substituents. According to another embodiment, the one or more substituents are selected from the group consisting of a fluoro group, an alkyl group, an alkoxy group, a silyl group, a germanium group, a siloxy group, a substituent having a curing group and deuterated analogues thereof.

According to one embodiment of the present disclosure, Ar2 is an aryl group having 6 to 30 carbon atoms unsubstituted or substituted with an alkyl group having 1 to 20 carbon atoms or an arylamine group having 6 to 30 carbon atoms.

In another embodiment, Ar2 is a phenyl group unsubstituted or substituted with an alkyl group having 1 to 20 carbon atoms or an arylamine group having 6 to 30 carbon atoms; a biphenyl group unsubstituted or substituted with an alkyl group having 1 to 20 carbon atoms or an arylamine group having 6 to 30 carbon atoms; a terphenyl group unsubstituted or substituted with an alkyl group having 1 to 20 carbon atoms or an arylamine group having 6 to 30 carbon atoms; or a naphthyl group unsubstituted or substituted with an alkyl group having 1 to 20 carbon atoms or an arylamine group having 6 to 30 carbon atoms.

According to one embodiment of the present disclosure, T is a direct bond; or an arylene group having 6 to 30 carbon atoms.

In one embodiment of the present disclosure, T3 to T5 are the same as or different from each other, and each independently hydrogen or deuterium.

According to one embodiment of the present disclosure, when d is 2 or greater, substituents in the two or more parentheses are the same as or different from each other.

According to one embodiment of the present disclosure, d is 1 or 2.

According to one embodiment of the present disclosure, when e is 2 or greater, substituents in the two or more parentheses are the same as or different from each other.

According to one embodiment of the present disclosure, e is 1 or 2.

According to one embodiment of the present disclosure, when k3 to k5 are each 2 or greater, substituents in the two or more parentheses are the same as or different from each other.

According to one embodiment of the present disclosure, when q is 2 or greater, substituents in the two or more parentheses are the same as or different from each other.

According to one embodiment of the present disclosure, q is an integer of 0 to 2.

According to another embodiment, q is 0 or 1.

According to one embodiment of the present disclosure, T21 to T25 are the same as or different from each other, and each independently hydrogen; deuterium; a C₁₋₁₀ alkyl group; or a C₁₋₁₀ deuterated alkyl group.

According to another embodiment, T21 to T25 are the same as or different from each other, and each independently a C₁₋₁₀ silyl group; or a deuterated C₁₋₁₀ silyl group.

In another embodiment, T21 to T25 are the same as or different from each other, and each independently a C₆₋₂₀ aryl group; a C₆₋₂₀ deuterated aryl group; or a C₃₋₂₀ heteroaryl group.

In another embodiment, T21 to T25 are the same as or different from each other, and each independently an amino group; or a deuterated amino group.

According to one embodiment of the present disclosure, when k, g, h and h1 are 2 or 2 or greater, substituents in the two or more parentheses are the same as or different from each other.

According to one embodiment of the present disclosure, k is an integer of 0 to 2.

According to one embodiment of the present disclosure, g is an integer of 0 to 2.

In one embodiment of the present disclosure, g is 1.

According to one embodiment of the present disclosure, T1 and T2 are the same as or different from each other, and each independently a substituted or unsubstituted arylene group having 6 to 30 carbon atoms.

According to another embodiment, T1 and T2 are the same as or different from each other, and each independently an arylene group having 6 to 30 carbon atoms unsubstituted or substituted with an alkyl group having 1 to 20 carbon atoms.

According to another embodiment, T1 and T2 are the same as or different from each other, and each independently a naphthylene group unsubstituted or substituted with an alkyl group having 1 to 20 carbon atoms.

According to one embodiment of the present disclosure, the monomer unit A may be any one of the following structures.

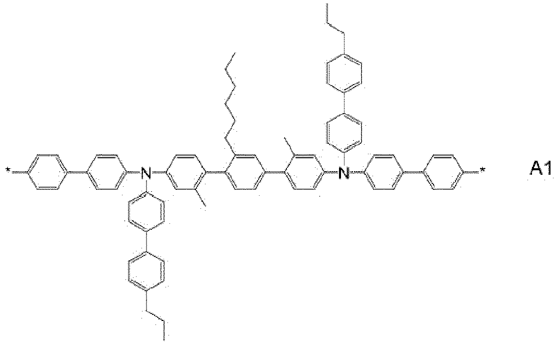

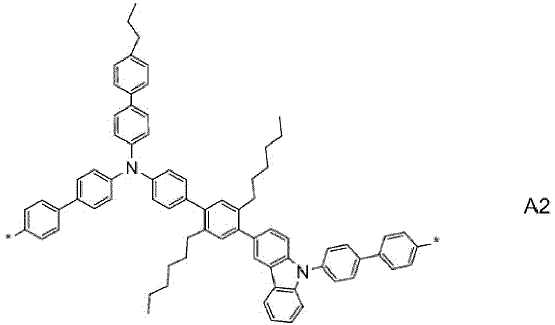

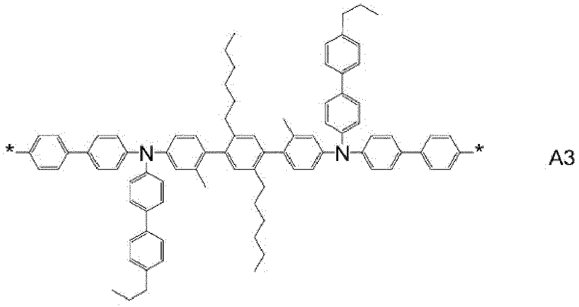

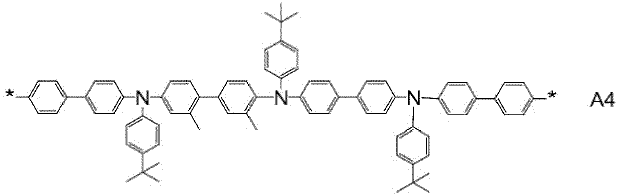

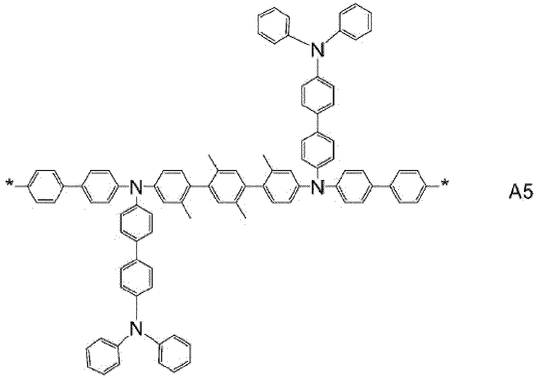

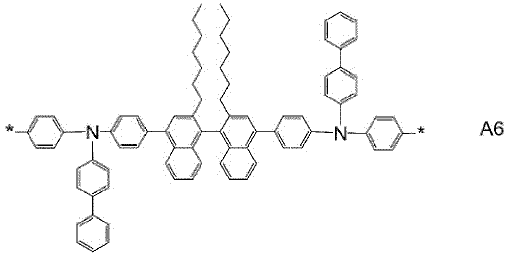

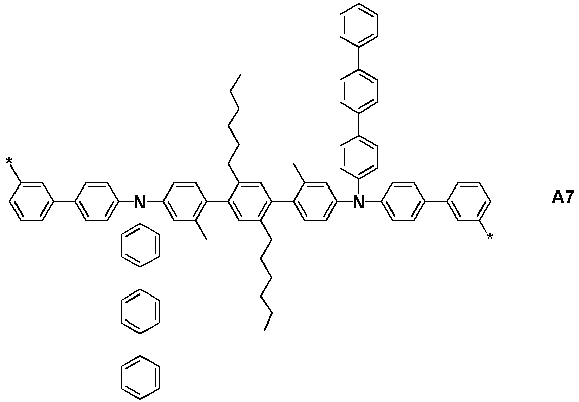

In one embodiment of the present disclosure, the monomer unit B' is a polyfunctional monomer unit having at least three bonding points in the copolymer.

According to another embodiment, the monomer unit B' has three to six bonding points.

In another embodiment, the monomer unit B' has three bonding points.

In another embodiment, the monomer unit B' has four bonding points.

In another embodiment, the monomer unit B' has five bonding points.

In another embodiment, the monomer unit B' has six bonding points.

According to one embodiment of the present disclosure, the monomer unit B' is represented by the following Chemical Formula B'-A.

[Chemical Formula B'-A] Cy1-(Cy2-*)s

In Chemical Formula B'-A,
Cy1 is selected from the group consisting of C, Si, Ge, N, an aliphatic cyclic group, an aromatic cyclic group, a deuterated aliphatic cyclic group or a deuterated aromatic cyclic group having at least three bonding positions,
Cy2s are the same as or different from each other, and each independently a direct bond; an alkylene group; an arylene group; a deuterated alkylene group; or a deuterated arylene group,
however, when Cy2 is a direct bond, an alkylene group or a deuterated alkylene group, Cy1 is an aromatic cyclic group or a deuterated aromatic cyclic group,
s is an integer of 3 to the maximum number of available bonding positions of Cy1, and
* represents a bonding point in the copolymer.

According to one embodiment of the present disclosure, Cy1 is C, Si, N, an aliphatic cyclic group having 3 to 30 carbon atoms, or an aromatic cyclic group having 6 to 30 carbon atoms.

According to one embodiment of the present disclosure, s is an integer of 3 to 5, and substituents in the parentheses are the same as or different from each other.

In another embodiment, s is 3 or 4.

According to one embodiment of the present disclosure, Cy2s are the same as or different from each other, and each independently a direct bond; or an arylene group having 6 to 30 carbon atoms.

In another embodiment, Cy2s are the same as or different from each other, and each independently a direct bond; a phenylene group; or a biphenylene group.

In one embodiment of the present disclosure, the monomer unit B' is represented by any one of the following Chemical Formulae B'-1 to B'-9.

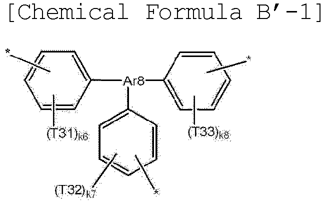

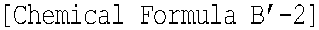

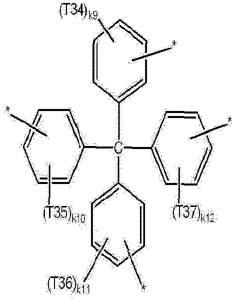

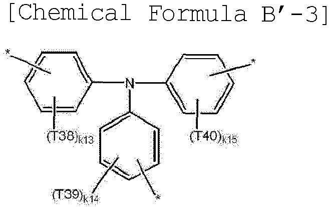

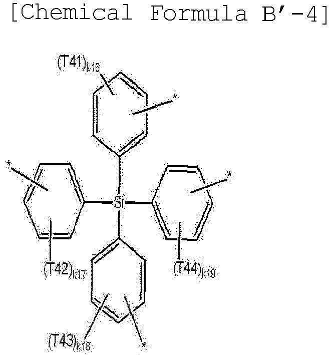

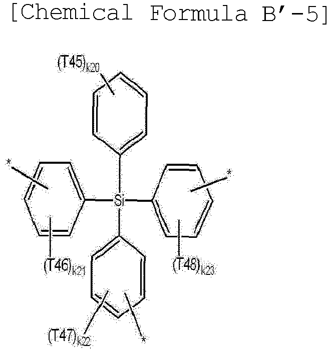

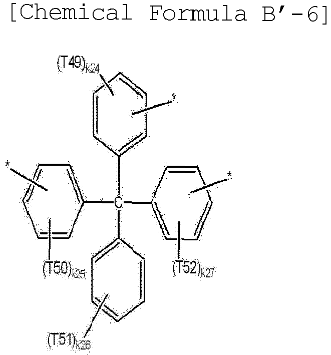

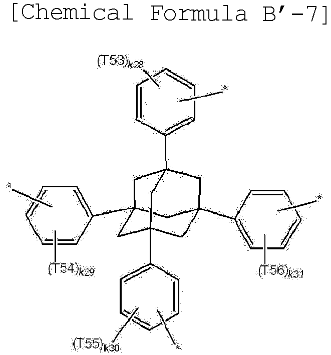

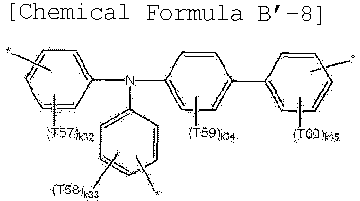

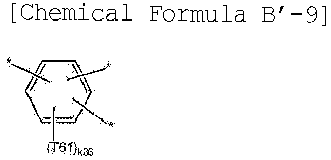

In Chemical Formulae B'-1 to B'-9,
Ar8 is an aromatic cyclic group or a deuterated aromatic cyclic group having at least three bonding points,
T31 to T61 are the same as or different from each other, and each independently selected from the group consisting of deuterium; F; a cyano group; an alkyl group; a fluoroalkyl group; an aryl group; a heteroaryl group; an amino group; a silyl group; a germanium group; an alkoxy group; an aryloxy group; a fluoroalkoxy group; a siloxane group; a siloxy group; a deuterated alkyl group; a deuterated partial-fluorinated alkyl group; a deuterated aryl group; a deuterated heteroaryl group; a deuterated amino group; a deuterated silyl group; a deuterated germanium group; a deuterated alkoxy group; a deuterated aryloxy group; a deuterated fluoroalkoxy group; a deuterated siloxane group; a deuterated siloxy group; and a curing group, and herein, adjacent groups selected from among T31 to T61 may bond to each other to form a 5-membered or 6-membered aromatic ring,
k6 to k19, k21 to k25 and k27 to k35 are each independently an integer of 0 to 4, k20 and k26 are each independently an integer of 0 to 5, and k36 is an integer of 0 to 3, and
* represents a bonding point in the copolymer.

According to one embodiment of the present disclosure, when k6 to k36 are each 2 or greater, substituents in the two or more parentheses are the same as or different from each other.

According to one embodiment of the present disclosure, Ar8 is benzene having at least three bonding points.

According to one embodiment of the present disclosure, T31 to T61 are each hydrogen or deuterium.

According to one embodiment of the present disclosure, the monomer unit B' may be any one of the following structures.

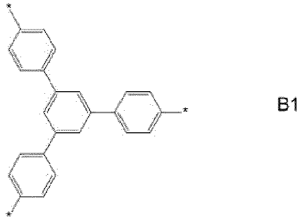

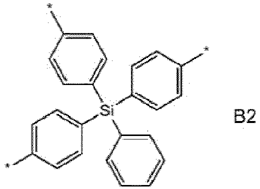

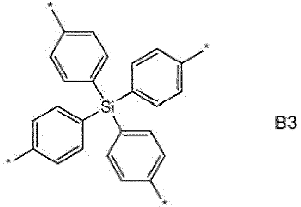

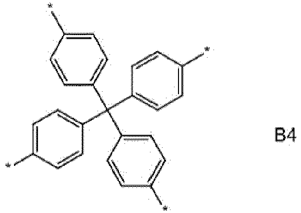

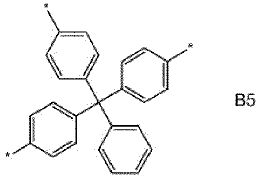

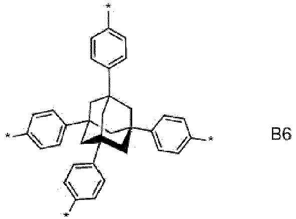

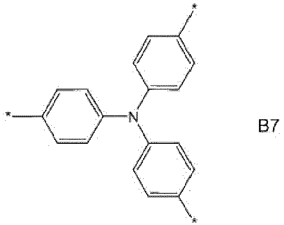

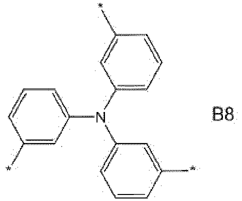

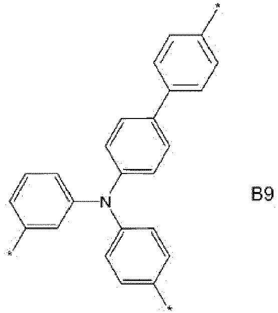

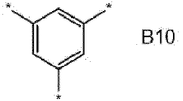

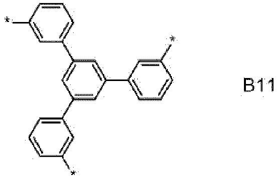

According to one embodiment of the present disclosure, the monomer unit C' is an aromatic monomer unit or a deuterated analogue thereof.

In one embodiment of the present disclosure, the monomer unit C' is a difunctional monomer unit having two bonding points.

According to one embodiment of the present disclosure, the monomer unit C' includes a curing group or a deuterated curing group.

In one embodiment of the present disclosure, the monomer unit C' may be one of the following chemical formulae.

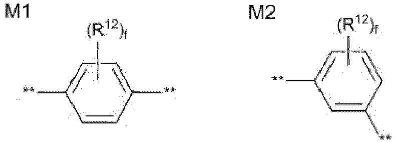

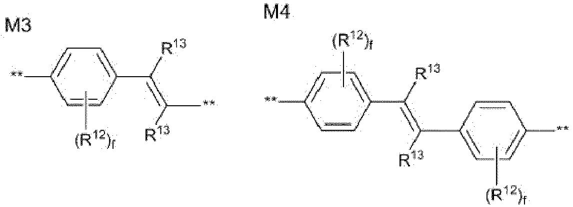

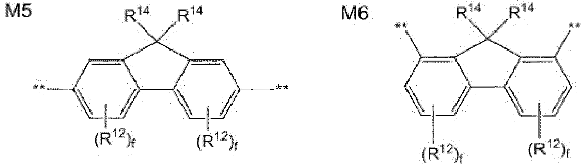

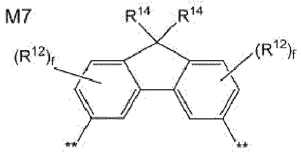

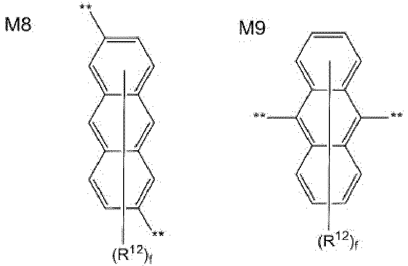

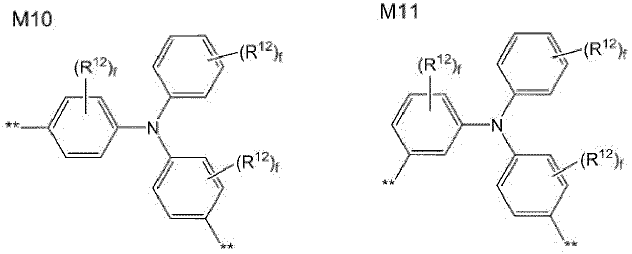

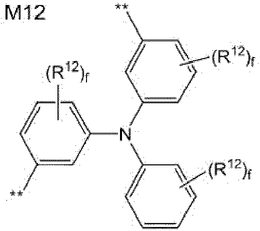

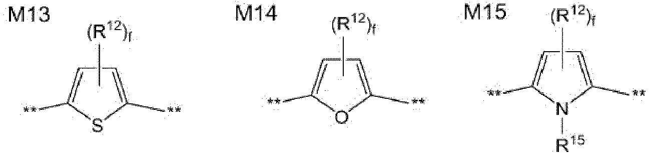

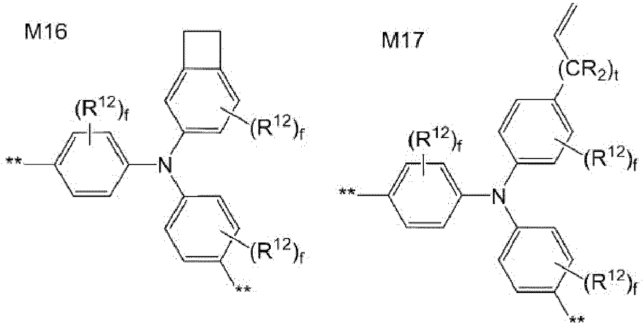

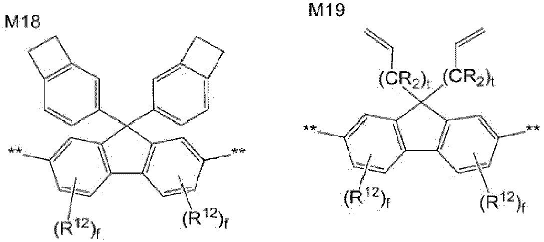

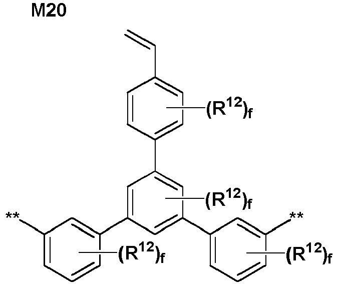

In Chemical Formulae M1 to M20,
R¹²s are the same as or different from each other, and each independently selected from the group consisting of deuterium; an alkyl group; a silyl group; a germanium group; an aryl group; a deuterated alkyl group; a deuterated silyl group; a deuterated germanium group; and a deuterated aryl group,
R¹³s are the same as or different from each other, and each independently selected from the group consisting of hydrogen; deuterium; an alkyl group; and a deuterated alkyl group,
R¹⁴s are the same as or different from each other, and each independently selected from the group consisting of an alkyl group; an aryl group; and deuterated analogues thereof,
R¹⁵ is selected from the group consisting of an aryl group and a deuterated aryl group,
R is hydrogen; deuterium; or an alkyl group,
fs are each independently an integer of 0 to the maximum number of available bonding positions of the substituents,
t is an integer of 0 to 20, and
** means a bonding point.

In one embodiment of the present disclosure, when f and t are each 2 or greater, substituents in the two or more parentheses are the same as or different from each other.

According to one embodiment of the present disclosure, f is an integer of 0 to 2.

In one embodiment of the present disclosure, t is an integer of 1 to 3.

In one embodiment of the present disclosure, R¹²s are the same as or different from each other, and each independently deuterium; an alkyl group having 1 to 20 carbon atoms; or an aryl group having 6 to 30 carbon atoms.

In one embodiment of the present disclosure, R¹³s are the same as or different from each other, and each independently hydrogen; deuterium; an alkyl group having 1 to 20 carbon atoms; or a deuterated alkyl group having 1 to 20 carbon atoms.

In one embodiment of the present disclosure, R¹⁵ is an aryl group having 6 to 30 carbon atoms; or a deuterated aryl group having 6 to 30 carbon atoms.

In one embodiment of the present disclosure, R¹⁴s are the same as or different from each other, and each independently an alkyl group having 1 to 20 carbon atoms; or an aryl group having 6 to 30 carbon atoms.

According to one embodiment of the present disclosure, R is hydrogen; deuterium; or an alkyl group having 1 to 20 carbon atoms.

According to one embodiment of the present disclosure, the monomer unit C' may be selected from among the following structures.

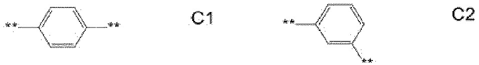

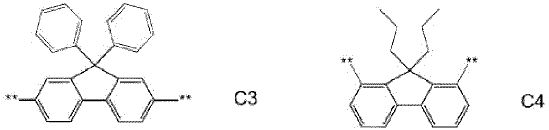

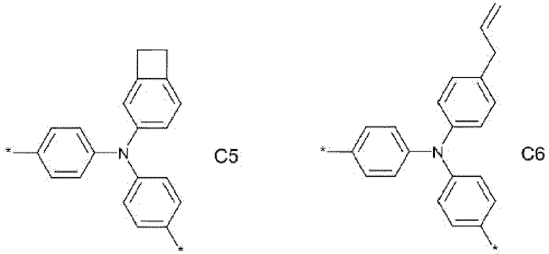

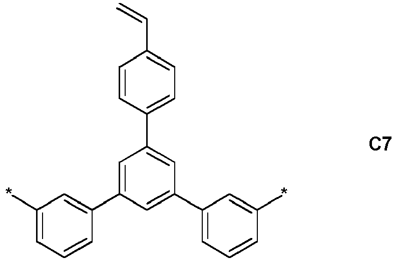

According to one embodiment of the present disclosure, the unit E is an end-capping unit for the copolymer.

In one embodiment of the present disclosure, the unit E is a monofunctional unit having one bonding point.

According to one embodiment of the present disclosure, the unit E is hydrogen or deuterium.

According to one embodiment of the present disclosure, the unit E is a monofunctional monomer unit.

According to one embodiment of the present disclosure, the unit E is a curing group or a deuterated curing group.

According to one embodiment of the present disclosure, the unit E is an aryl group or a deuterated aryl group.

According to one embodiment of the present disclosure, the unit E is selected from among an aryl group; an arylamino group; a curing group; and deuterated analogues thereof.

According to one embodiment of the present disclosure, the unit E is selected from the group consisting of a phenyl group; a biphenyl group; a diphenylamino group; substituted derivatives thereof and deuterated analogues thereof. Herein, the substituent is a C₁₋₁₀ alkyl group, a curing group, or a deuterated analogue thereof.

According to one embodiment of the present disclosure, the unit E may be any one of the following structures.

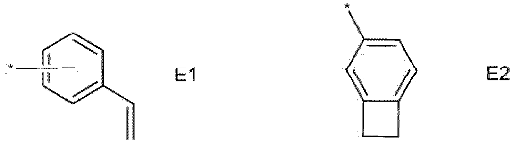

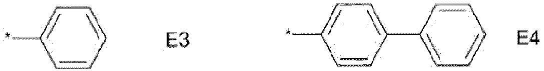

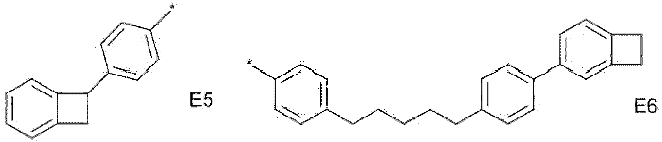

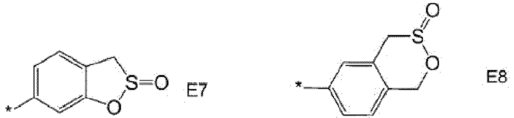

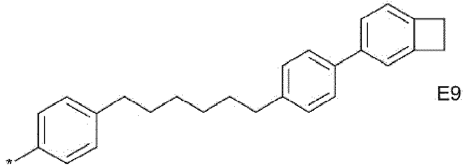

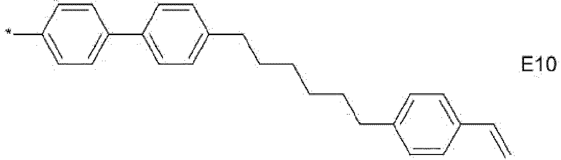

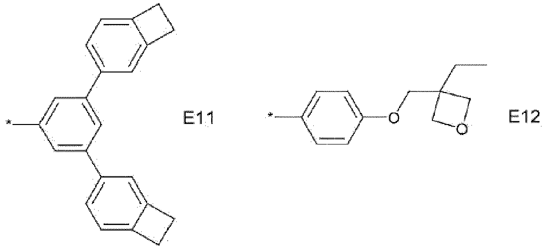

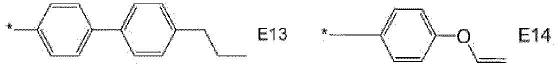

Herein, * represents a bonding point in the copolymer.

According to one embodiment of the present disclosure, a of Chemical Formula 3 is 0.50 or greater.

According to one embodiment of the present disclosure, a of Chemical Formula 3 is from 0.50 to 0.99.

According to one embodiment of the present disclosure, a of Chemical Formula 3 is from 0.60 to 0.90.

According to one embodiment of the present disclosure, a of Chemical Formula 3 is from 0.65 to 0.80.

According to one embodiment of the present disclosure, b of Chemical Formula 3 is 0.05 or greater, and according to some embodiments, b is 0.10 or greater.

According to one embodiment of the present disclosure, b of Chemical Formula 3 is from 0.01 to 0.50.

According to one embodiment of the present disclosure, b of Chemical Formula 3 is from 0.05 to 0.45.

According to one embodiment of the present disclosure, b of Chemical Formula 3 is from 0.10 to 0.40.

According to one embodiment of the present disclosure, b of Chemical Formula 3 is from 0.20 to 0.35.

According to one embodiment of the present disclosure, c of Chemical Formula 3 is 0.

According to one embodiment of the present disclosure, c of Chemical Formula 3 is from 0 to 0.20.

According to one embodiment of the present disclosure, c of Chemical Formula 3 is from 0.01 to 0.20.

According to one embodiment of the present disclosure, c of Chemical Formula 3 is from 0.05 to 0.15.

In one embodiment of the present disclosure, a molar ratio of A+B' to E is in a range of 40:60 to 98:2; 50:50 to 90:10 or 60:40 to 80:20.

According to one embodiment of the present disclosure, a1 is from 0.30 to 0.90 in Chemical Formula 3'.

According to one embodiment of the present disclosure, a1 is from 0.40 to 0.80 in Chemical Formula 3'.

According to one embodiment of the present disclosure a1 is from 0.50 to 0.80 in Chemical Formula 3'.

According to one embodiment of the present disclosure, b1 is from 0.05 to 0.40 in Chemical Formula 3'.

According to one embodiment of the present disclosure, b1 is from 0.10 to 0.30 in Chemical Formula 3'.

According to one embodiment of the present disclosure, b1 is from 0.10 to 0.20 in Chemical Formula 3'.

According to one embodiment of the present disclosure, c1 is 0 in Chemical Formula 3'.

According to one embodiment of the present disclosure, c1 is from 0 to 0.15 in Chemical Formula 3'.

According to one embodiment of the present disclosure, c1 is from 0.01 to 0.15 in Chemical Formula 3'.

According to one embodiment of the present disclosure, c1 is from 0.05 to 0.12 in Chemical Formula 3'.

According to one embodiment of the present disclosure, c1 is from 0.05 to 0.60 in Chemical Formula 3'.

According to one embodiment of the present disclosure, c1 is from 0.10 to 0.50 in Chemical Formula 3'.

According to one embodiment of the present disclosure, c1 is from 0.15 to 0.35 in Chemical Formula 3'.

According to one embodiment of the present disclosure, e1 is from 0.05 to 0.60 in Chemical Formula 3'.

According to one embodiment of the present disclosure, e1 is from 0.10 to 0.50 in Chemical Formula 3'.

According to one embodiment of the present disclosure, e1 is from 0.15 to 0.35 in Chemical Formula 3'.

According to one embodiment of the present disclosure, examples of the copolymer of Chemical Formula 3 are shown below using the form of Chemical Formula 3'.

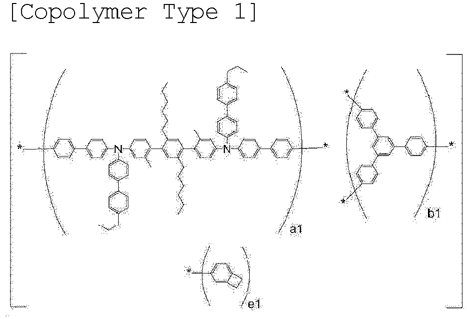

In Copolymer Type 1, c1 is 0 and the monomer unit C' is not present. The end-capping unit E is a curing group.

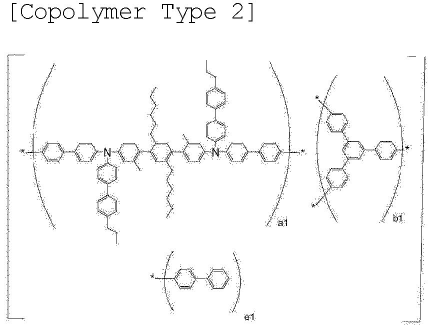

In Copolymer Type 2, c1 is 0 and the monomer unit C' is not present. The end-capping unit E is an aryl group.

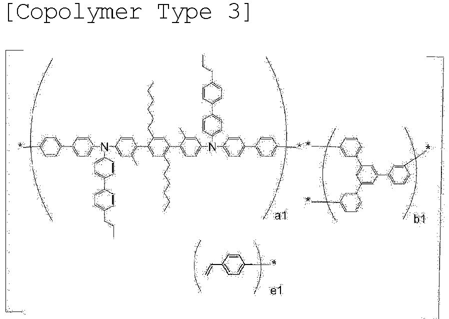

In Copolymer Type 3, c1 is 0 and the monomer unit C' is not present. The end-capping unit E is a curing group.

### [Copolymer Type 4]

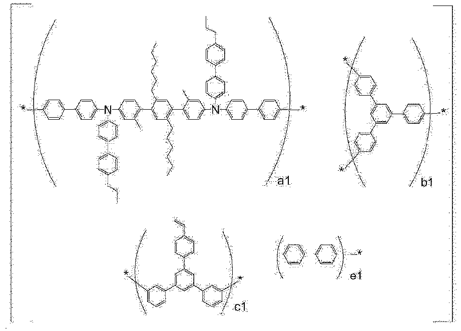

In Copolymer Type 4, the monomer unit C' is present and includes a curing group. The end-capping unit E is an aryl group.

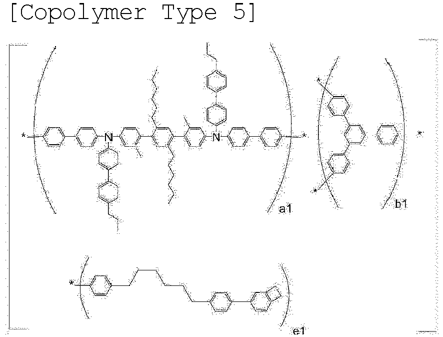

In Copolymer Type 5, c1 is 0 and the monomer unit C' is not present. The end-capping unit E is a curing group.

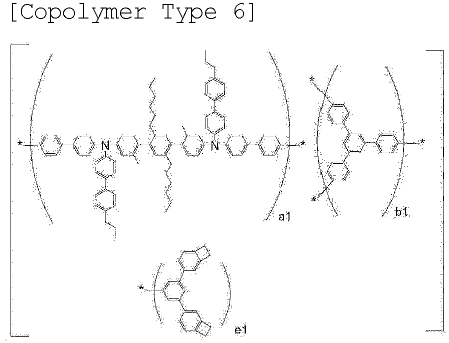

In Copolymer Type 6, c1 is 0 and the monomer unit C' is not present. The end-capping unit E is a curing group.

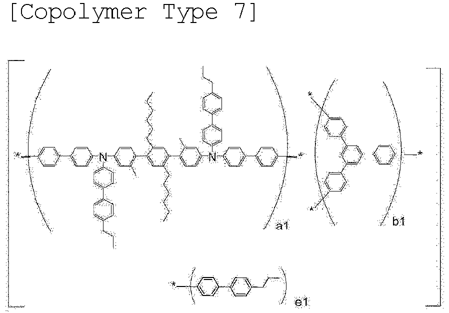

In Copolymer Type 7, c1 is 0 and the monomer unit C' is not present. The end-capping unit E is an aryl group.

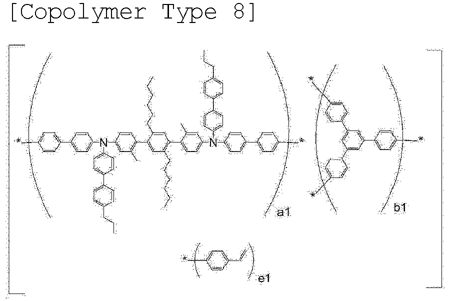

In Copolymer Type 8, c1 is 0 and the monomer unit C' is not present. The end-capping unit E is a curing group.

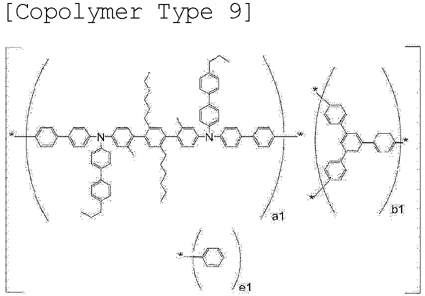

In Copolymer Type 9, c1 is 0 and the monomer unit C' is not present. The end-capping unit E is an aryl group.

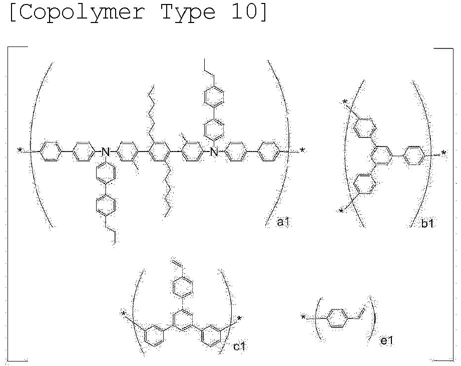

In Copolymer Type 10, the monomer unit C' is present and includes a curing group. The end-capping unit E is a curing group.

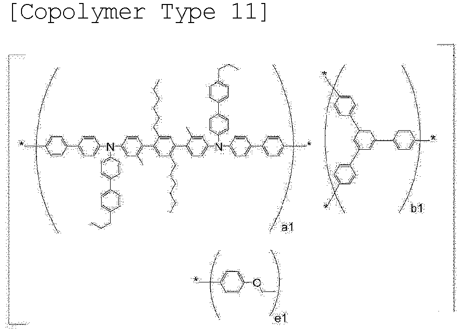

In Copolymer Type 11, c1 is 0 and the monomer unit C' is not present. The end-capping unit E is a curing group.

### [Copolymer Type 12]

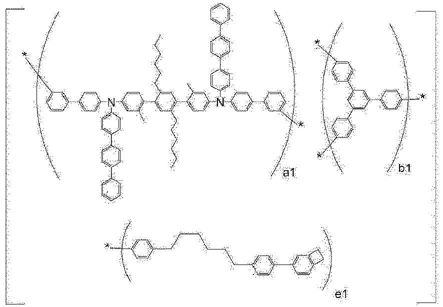

In Copolymer Type 12, c1 is 0 and the monomer unit C' is not present. The end-capping unit E includes a curing group.

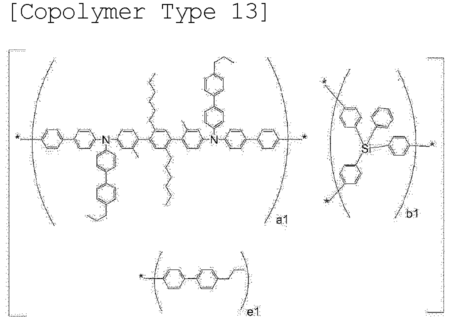

In Copolymer Type 13, c1 is 0 and the monomer unit C' is not present. The end-capping unit E is an aryl group.

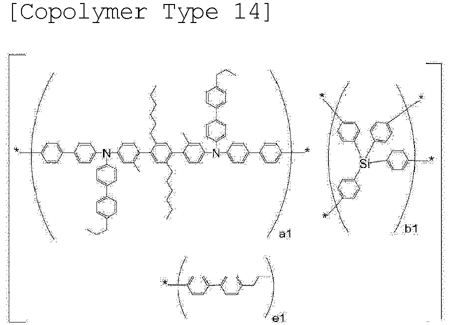

In Copolymer Type 14, c1 is 0 and the monomer unit C' is not present. The monomer unit B' is tetrafunctional. The end-capping unit E is an aryl group.

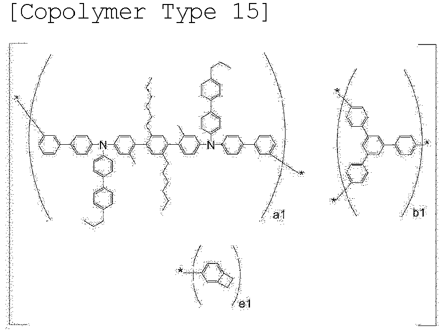

In Copolymer Type 15, c1 is 0 and the monomer unit C' is not present. The end-capping unit E is a curing group.

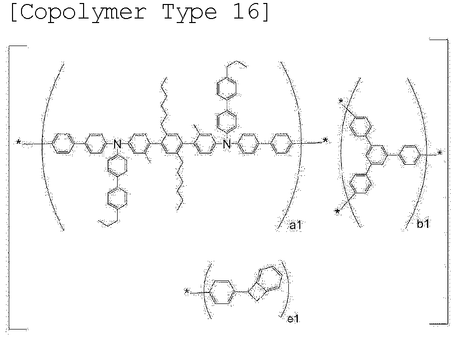

In Copolymer Type 16, c1 is 0 and the monomer unit C' is not present. The end-capping unit E is a curing group.

### [Copolymer Type 17]

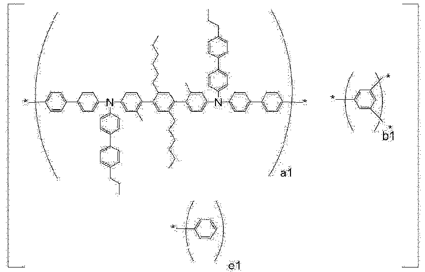

In Copolymer Type 17, c1 is 0 and the monomer unit C' is not present. The end-capping unit E is an aryl group.

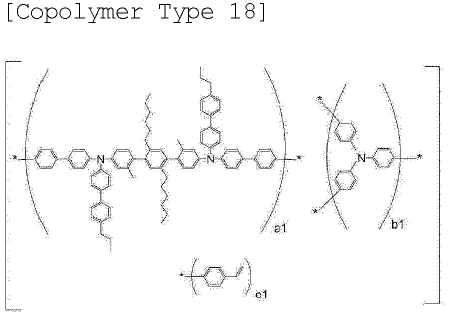

In Copolymer Type 18, c1 is 0 and the monomer unit C' is not present. The end-capping unit E is a curing group.

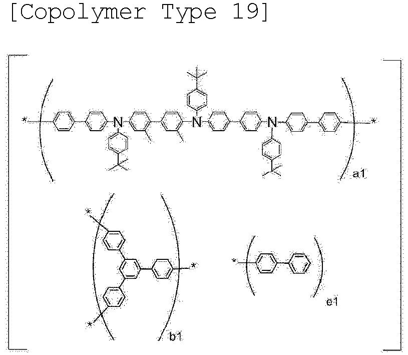

In Copolymer Type 19, c1 is 0 and the monomer unit C' is not present. The end-capping unit E is an aryl group.

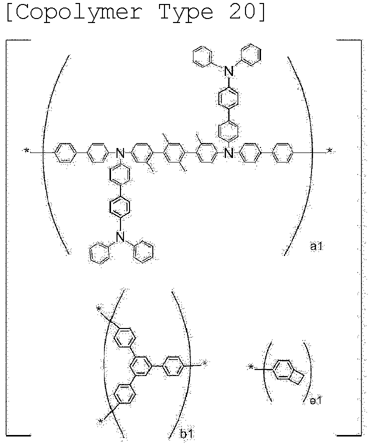

In Copolymer Type 20, c1 is 0 and the monomer unit C' is not present. The end-capping unit E is a curing group.

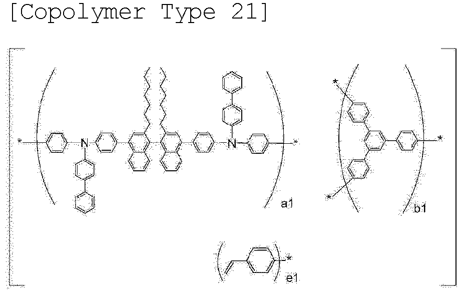

In Copolymer Type 21, c1 is 0 and the monomer unit C' is not present. The end-capping unit E is a curing group.

The copolymer of Chemical Formula 3 may be prepared using any technique and known polymerization techniques yielding a C-C or C-N bond. A variety of such techniques such as metal-catalyzed oxidative direct arylation as well as Suzuki, Yamamoto, Stille and metal-catalyzed C-N coupling are known.

Techniques for controlling a molecular weight of the copolymer of the present disclosure are well known in the art. The molecular weight of the copolymer described in the present disclosure may generally be controlled by the ratio of the monomers in the polymerization reaction. According to another embodiment, the molecular weight may be controlled using a quenching reaction.

In one embodiment of the present disclosure, the composition may be a liquid phase. The "liquid phase" means being in a liquid state at room temperature and atmospheric pressure.

In one embodiment of the present disclosure, the composition including the compound of Chemical Formula 1 further includes a solvent.

According to one embodiment of the present disclosure, the composition including the compound of Chemical Formula 1 may further include the ionic compound including the anion group of Chemical Formula 2, and the composition further includes a solvent.

According to one embodiment of the present disclosure, the composition including the copolymer of Chemical Formula 3 further includes a solvent.

In one embodiment of the present disclosure, examples of the solvent may include chlorine-based solvents such as chloroform, methylene chloride, 1,2-dichloroethane, 1,1,2-trichloroethane, chlorobenzene or o-dichlorobenzene; ether-based solvents such as tetrahydrofuran or dioxane; aromatic hydrocarbon-based solvents such as toluene, xylene, trimethylbenzene or mesitylene; aliphatic hydrocarbon-based solvents such as cyclohexane, methylcyclohexane, n-pentane, n-hexane, n-heptane, n-octane, n-nonane or n-decane; ketone-based solvents such as acetone, methyl ethyl ketone, cyclohexanone, isophorone, tetralone, decalone or acetylacetone; ester-based solvents such as ethyl acetate, butyl acetate or ethyl cellosolve acetate; polyalcohols such as ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerin or 1,2-hexanediol, and derivatives thereof; alcohol-based solvents such as methanol, ethanol, propanol, isopropanol or cyclohexanol; sulfoxide-based solvents such as dimethyl sulfoxide; amide-based solvents such as N-methyl-2-pyrrolidone or N,N-dimethylformamide; tetraline, and the like, however, the solvent is not limited thereto as long as it is a solvent capable of dissolving or dispersing the compound of Chemical Formula 1 according to one embodiment of the present disclosure.

In another embodiment, the solvent may be used either alone as one type, or as a mixture of two or more solvent types.

In another embodiment, the solvent has a boiling point of preferably 40°C to 250°C and more preferably 60°C to 230°C, however, the boiling point is not limited thereto.

In another embodiment, the composition including the compound of Chemical Formula 1 and the ionic compound including the anion group of Chemical Formula 2 has viscosity of 2 cP to 15 cP at room temperature.

In another embodiment, the composition including the copolymer of Chemical Formula 3 has viscosity of 2 cP to 15 cP at room temperature.

In one embodiment of the present disclosure, the composition including the compound of Chemical Formula 1 and the ionic compound including the anion group of Chemical Formula 2 has a concentration of 0.5 wt/v% to 10 wt/v%.

In one embodiment of the present disclosure, the composition including the copolymer of Chemical Formula 3 has a concentration of 0.1 wt/v% to 10 wt/v%.

In one embodiment of the present disclosure, the composition may further include one, two or more types of additives selected from the group consisting of thermal polymerization initiators and photopolymerization initiators.

Examples of the thermal polymerization initiator may include peroxides such as methyl ethyl ketone peroxide, methyl isobutyl ketone peroxide, acetylacetone peroxide, methylcyclohexanone peroxide, cyclohexanone peroxide, isobutyryl peroxide, 2,4-dichlorobenzoyl peroxide, bis-3,5,5-trimethyl hexanoyl peroxide, lauryl peroxide, benzoyl peroxide, p-chlorobenzoyl peroxide, dicumyl peroxide, 2,5-dimethyl-2,5-(t-butyloxy)-hexane, 1,3-bis(t-butylperoxy-isopropyl)benzene, t-butyl cumyl peroxide, di-t-butyl peroxide, 2,5-dimethyl-2,5-(di-t-butylperoxy)hexane-3, tris-(t-butylperoxy)triazine, 1,1-di-t-butylperoxy-3,3,5-trimethylcyclohexane, 1,1-di-t-butylperoxycyclohexane, 2,2-di(t-butylperoxy)butane, 4,4-di-t-butylperoxy valeric acid n-butyl ester, 2,2-bis(4,4-t-butylperoxycyclohexyl)propane, t-butyl peroxyisobutyrate, di-t-butyl peroxyhexahydroterephthalate, t-butylperoxy-3,5,5-trimethylhexate, t-butyl peroxybenzoate or di-t-butyl peroxytrimethyl adipate; or azo-based such as azobis isobutylnitrile, azobis dimethylvaleronitrile or azobis cyclohexyl nitrile, but are not limited thereto.

Examples of the photopolymerization initiator may include acetophenone-based or ketal-based photopolymerization initiators such as diethoxyacetophenone, 2,2-dimethoxy-1,2-diphenyl ethan-1-one, 1-hydroxy-cyclohexyl-phenyl-ketone, 4-(2-hydroxyethoxy)phenyl-(2-hydroxy-2-propyl)ketone, 2-benzyl-2-dimethylamino-1-(4-morpholinophenyl)butanone-1,2-hydroxy-2-methyl-1-phenylpropan-1-one, 2-methyl-2-morpholino(4-methylthiophenyl)propan-1-one or 1-phenyl-1,2-propanedion-2-(o-ethoxycarbonyl)oxime; benzoin ether-based photopolymerization initiators such as benzoin, benzoin methyl ether, benzoin ethyl ether, benzoin isobutyl ether or benzoin isopropyl ether; benzophenone-based photopolymerization initiators such as benzophenone, 4-hydroxybenzophenone, 2-benzoylnaphthalene, 4-benzoylbiphenyl, 4-benzoyl phenyl ether, acrylated benzophenone or 1,4-benzoylbenzene; and thioxanthone-based photopolymerization initiators such as 2-isopropylthioxanthone, 2-chlorothioxanthone, 2,4-dimethylthioxanthone, 2,4-diethylthioxanthone or 2,4-dichlorothioxanthone; and, as other photopolymerization initiators, ethyl anthraquinone, 2,4,6-trimethylbenzoyldiphenylphosphine oxide, 2,4,6-trimethylbenzoylphenylethoxyphosphine oxide, bis(2,4,6-trimethylbenzoyl)phenylphosphine oxide, bis(2,4-dimethoxybenzoyl)-2,4,4-trimethylpentylphosphine oxide, methylphenylglyoxyester, 9,10-phenanthrene, acridine-based compounds, triazine-based compounds, imidazole-based compounds, and the like, but are not limited thereto.

In addition, a material having a photopolymerization accelerating effect may be used either alone or in combination with the photopolymerization initiator. Examples thereof may include triethanolamine, methyl diethanolamine, ethyl 4-dimethylamino benzoate, isoamyl 4-dimethylamino benzoate, (2-dimethylamino)ethyl benzoate, 4,4'-dimethylaminobenzophenon and the like, but are not limited thereto.

According to one embodiment of the present disclosure, the first organic material layer is a hole injection layer, and the second organic material layer is a hole transfer layer.

According to one embodiment of the present disclosure, the first organic material layer is provided in contact with the anode, and the second organic material layer is provided in contact with the first organic material layer.

In one embodiment of the present disclosure, a third organic material layer may be included between the second organic material layer and the light emitting layer.

According to one embodiment of the present disclosure, the organic light emitting device may further include, in addition to the first organic material layer, the second organic material layer and the light emitting layer, one, two or more layers selected from the group consisting of a hole injection layer, a hole transfer layer, an electron transfer layer, an electron injection layer, a light emitting layer, an electron injection and transfer layer, a hole injection and transfer layer, an electron blocking layer and a hole blocking layer.

In another embodiment, the organic light emitting device may be an organic light emitting device having a structure in which an anode, one or more organic material layers and a cathode are consecutively laminated on a substrate (normal type).

In another embodiment, the organic light emitting device may be an organic light emitting device having a structure in a reverse direction in which a cathode, one or more organic material layers and an anode are consecutively laminated on a substrate (inverted type).

The organic material layer of the organic light emitting device of the present disclosure may be formed in a single layer structure, but may be formed in a multilayer structure in which two or more organic material layers are laminated. For example, the organic light emitting device of the present disclosure may have a structure including a hole injection layer, a hole transfer layer, a light emitting layer, an electron transfer layer, an electron injection layer, a hole injection and transfer layer, an electron injection and transfer layer and the like as the organic material layer. However, the structure of the organic light emitting device is not limited thereto, and may include a smaller number of organic layers.

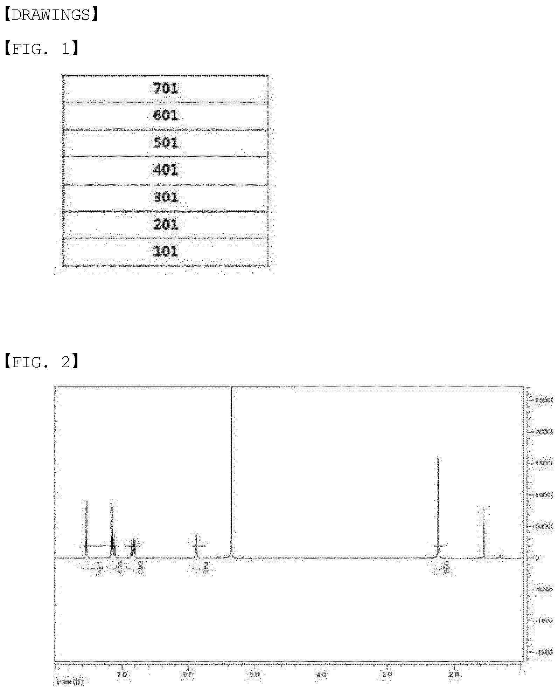

For example, a structure of the organic light emitting device according to one embodiment of the present disclosure is illustrated in FIG. 1.

FIG. 1 illustrates a structure of the organic light emitting device in which an anode (201), a hole injection layer (301), a hole transfer layer (401), a light emitting layer (501), an electron injection and transfer layer (601) and a cathode (701) are consecutively laminated on a substrate (101). Herein, the electron injection and transfer layer means a layer carrying out electron injection and electron transfer at the same time. The hole injection layer (301) of FIG. 1 may include the composition including the compound of Chemical Formula 1 and the ionic compound or a cured material thereof, and the hole transfer layer (401) may include the composition including the copolymer of Chemical Formula 3 or a cured material thereof.

FIG. 1 illustrates the organic light emitting device, however, the organic light emitting device is not limited thereto.

When the organic light emitting device includes a plurality of organic material layers, the organic material layers may be formed with materials the same as or different from each other.

The organic light emitting device of the present disclosure may be manufactured using materials and methods known in the art, except that, of the organic material layers, the first organic material layer is formed using the composition including the compound of Chemical Formula 1 and the ionic compound, and the second organic material layer is formed using the composition including the copolymer of Chemical Formula 3.

For example, the organic light emitting device of the present disclosure may be manufactured by consecutively laminating an anode, an organic material layer and a cathode on a substrate. Herein, the organic light emitting device may be manufactured by forming an anode on a substrate by depositing a metal, a metal oxide having conductivity, or an alloy thereof using a physical vapor deposition (PVD) method such as sputtering or e-beam evaporation, forming an organic material layer including one or more of a hole injection layer, a hole transfer layer, a light emitting layer, an electron injection layer, an electron transfer layer, a hole injection and transfer layer and an electron injection and transfer layer thereon through a solution process, a deposition process or the like, and then depositing a material usable as a cathode thereon. In addition to such a method, the organic light emitting device may also be manufactured by consecutively depositing a cathode material, an organic material layer and an anode material on a substrate.

In addition, one embodiment of the present disclosure provides a method for manufacturing an organic light emitting device formed using the compositions.

Specifically, the method in one embodiment of the present disclosure includes preparing a substrate; forming an anode on the substrate; forming a first organic material layer on the anode; forming a second organic material layer on the first organic material layer; forming a light emitting layer on the second organic material layer; and forming a cathode on the light emitting layer.

In one embodiment of the present disclosure, the first organic material layer and/or the second organic material layer are formed using spin coating or inkjetting.

In one embodiment of the present disclosure, the first organic material layer and/or the second organic material layer are formed using a printing method.

In an embodiment of the present disclosure, the printing method may include, for example, inkjet printing, nozzle printing, offset printing, transfer printing, screen printing or the like, but is not limited thereto.

According to one embodiment of the present disclosure, a solution process is suited as a method for forming the first organic material layer and the second organic material layer, and spin coating, inkjetting or a printing method may be used, which is economically effective in terms of time and costs when manufacturing the device.

In one embodiment of the present disclosure, the forming of a first organic material layer includes coating a composition of the first organic material layer; and heat treating or light treating the coated composition.

In one embodiment of the present disclosure, the forming of a second organic material layer includes coating a composition of the second organic material layer; and heat treating or light treating the coated composition.

In one embodiment of the present disclosure, the heat treating may be conducted through heat treatment, and a temperature of the heat treatment in the heat treating may be from 85°C to 250°C, may be from 100°C to 250°C according to one embodiment, and may be from 150°C to 250°C in another embodiment.

In another embodiment, a time of the heat treatment in the heat treating may be from 1 minute to 2 hours, may be from 1 minute to 1 hour according to one embodiment, and may be from 20 minutes to 1 hour in another embodiment.

According to one embodiment of the present disclosure, an atmosphere of the heat treatment while forming the first organic material layer and/or the second organic material layer may be an inert gas atmosphere such as argon or nitrogen, or the air, but is not limited thereto.

When including the heat treating or light treating in the forming of a first organic material layer and/or a second organic material layer, a plurality of the compounds included in the composition form crosslinks, and an organic material layer including a thin-filmed structure may be provided. This may prevent the organic material layer formed using the composition from being dissolved by a solvent, being morphologically influenced or being decomposed when laminating other layers on the surface of the organic material layer.

Accordingly, when the organic material layer formed using the composition is formed including the heat treating or light treating, resistance for a solvent increases, and a multilayer may be formed by repeatedly performing solution deposition and crosslinking methods, and lifetime properties of the device may be enhanced by increasing stability.

In one embodiment of the present disclosure, the composition including the compound of Chemical Formula 1 and the ionic compound, or the composition including the copolymer of Chemical Formula 3 may be a composition mixed to a polymer binder and dispersed.

In one embodiment of the present disclosure, as the polymer binder, those that do not extremely inhibit charge transfer are preferred, and those that do not have strong absorption for visible light are preferably used. Examples of the polymer binder may include poly(N-vinylcarbazole), polyaniline and derivatives thereof, polythiophene and derivatives thereof, poly(p-phenylenevinylene) and derivatives thereof, poly(2,5-thienylenevinylene) and derivatives thereof, polycarbonate, polyacrylate, polymethyl acrylate, polymethyl methacrylate, polystyrene, polyvinyl chloride, polysiloxane and the like.

The composition of the first organic material layer according to one embodiment of the present disclosure may further include, in addition to the compound of Chemical Formula 1, the ionic compound including the anion group of Chemical Formula 2 or other monomers (compounds).

The composition of the second organic material layer according to one embodiment of the present disclosure may use the copolymer of Chemical Formula 3 alone, or may include other monomers or other copolymers.

As the anode material, materials having large work function are normally preferred so that hole injection to an organic material layer is smooth. Specific examples of the anode material usable in the present disclosure include metals such as vanadium, chromium, copper, zinc and gold, or alloys thereof; metal oxides such as zinc oxide, indium oxide, indium tin oxide (ITO) and indium zinc oxide (IZO); combinations of metals and oxides such as ZnO:Al or SnO₂:Sb; conductive polymers such as poly(3-methylthiophene), poly[3,4-(ethylene-1,2-dioxy)thiophene] (PEDOT), polypyrrole and polyaniline, and the like, but are not limited thereto.

As the cathode material, materials having small work function are normally preferred so that electron injection to an organic material layer is smooth. Specific examples of the cathode material include metals such as barium magnesium, calcium, sodium, potassium, titanium, indium, yttrium, lithium, gadolinium, aluminum, silver, tin and lead, or alloys thereof; multilayer structure materials such as LiF/Al or LiO₂/Al, and the like, but are not limited thereto.

The hole injection layer is a layer that injects holes from an electrode, and the hole injection material is preferably a compound that has an ability to transfer holes and thereby has a hole injection effect in an anode and an excellent hole injection effect for a light emitting layer or a light emitting material, prevents excitons generated in the light emitting layer from moving to an electron injection layer or an electron injection material, and in addition thereto, has an excellent thin film forming ability. The highest occupied molecular orbital (HOMO) of the hole injection material is preferably in between the work function of an anode material and the HOMO of surrounding organic material layers. Specific examples of the hole injection material include the compound of Chemical Formula 1 described above, metal porphyrins, oligothiophene, arylamine-based organic materials, hexanitrile hexaazatriphenylene-based organic materials, quinacridone-based organic materials, perylene-based organic materials, anthraquinone, and polyaniline- and polythiophene-based conductive polymers, and the like, but are not limited thereto.

The hole transfer layer is a layer that receives holes from a hole injection layer and transfers the holes to a light emitting layer, and as the hole transfer material, materials capable of receiving holes from an anode or a hole injection layer, moving the holes to a light emitting layer, and having high mobility for the holes are suited. Specific examples thereof include arylamine-based organic materials, conductive polymers, block copolymers having conjugated parts and nonconjugated parts together, and the like, but are not limited thereto.

The hole injection and transfer layer may include the materials of the hole transfer layer and the hole injection layer described above.

The light emitting material is a material capable of emitting light in a visible light region by receiving holes and electrons from a hole transfer layer and an electron transfer layer, respectively, and binding the holes and the electrons, and is preferably a material having favorable quantum efficiency for fluorescence or phosphorescence. Specific examples thereof include 8-hydroxyquinoline aluminum complexes (Alq₃); carbazole-based compounds; dimerized styryl compounds; BAlq; 10-hydroxybenzoquinoline-metal compounds; benzoxazole-, benzothiazole- and benzimidazole-based compounds; poly(p-phenylenevinylene) (PPV)-based polymers; spiro compounds; polyfluorene, rubrene, or the like, but are not limited thereto.

The light emitting layer may include a host material and a dopant material. The host material includes fused aromatic ring derivatives, heteroring-containing compounds or the like. Specifically, the fused aromatic ring derivative includes anthracene derivatives, pyrene derivatives, naphthalene derivatives, pentacene derivatives, phenanthrene compounds, fluoranthene compounds and the like, and the heteroring-containing compound includes carbazole derivatives, dibenzofuran derivatives, ladder-type furan compounds, pyrimidine derivatives and the like, however, the material is not limited thereto.

The dopant material includes aromatic amine derivatives, styrylamine compounds, boron complexes, fluoranthene compounds, metal complexes and the like. Specifically, the aromatic amine derivative is a fused aromatic ring derivative having a substituted or unsubstituted arylamino group and includes arylamino group-including pyrene, anthracene, chrysene, peryflanthene and the like, and the styrylamine compound is a compound in which substituted or unsubstituted arylamine is substituted with at least one arylvinyl group, and one, two or more substituents selected from the group consisting of an aryl group, a silyl group, an alkyl group, a cycloalkyl group and an arylamino group are substituted or unsubstituted. Specifically, styrylamine, styryldiamine, styryltriamine, styryltetramine or the like is included, however, the styrylamine compound is not limited thereto. In addition, the metal complex includes iridium complexes, platinum complexes or the like, but is not limited thereto.

The electron transfer layer is a layer that receives electrons from an electron injection layer and transfers the electrons to a light emitting layer, and as the electron transfer material, materials capable of favorably receiving electrons from a cathode, moving the electrons to a light emitting layer, and having high mobility for the electrons are suited. Specific examples thereof include Al complexes of 8-hydroxyquinoline; complexes including Alq₃; organic radical compounds; hydroxyflavon-metal complexes, or the like, but are not limited thereto. The electron transfer layer may be used together with any desired cathode material as used in the art. Particularly, examples of the suitable cathode material include common materials that have small work function, and in which an aluminum layer or a silver layer follows. Specifically, the cathode material includes cesium, barium, calcium, ytterbium and samarium, and in each case, an aluminum layer or a silver layer follows.

The electron injection layer is a layer that injects electrons from an electrode, and as the electron injection material, compounds that has an ability to transfer electrons, has an electron injection effect from a cathode, has an excellent electron injection effect for a light emitting layer or a light emitting material, prevents excitons generated in the light emitting layer from moving to a hole injection layer, and in addition thereto, has an excellent thin film forming ability are preferred. Specific examples thereof include fluorenone, anthraquinodimethane, diphenoquinone, thiopyran dioxide, oxazole, oxadiazole, triazole, imidazole, perylene tetracarboxylic acid, fluorenylidene methane, anthrone or the like, and derivatives thereof, metal complex compounds, nitrogen-containing 5-membered ring derivatives, and the like, but are not limited there.

The electron injection and transfer layer may include the materials of the electron transfer layer and the electron injection layer described above.

The metal complex compound includes 8-hydroxyquinolinato lithium, bis(8-hydroxyquinolinato)zinc, bis(8-hydroxyquinolinato)copper, bis(8-hydroxyquinolinato)manganese, tris(8-hydroxyquinolinato)aluminum, tris(2-methyl-8-hydroxyquinolinato) aluminum, tris(8-hydroxyquinolinato)gallium, bis(10-hydroxybenzo[h]quinolinato)beryllium, bis(10-hydroxybenzo[h]quinolinato)zinc, bis(2-methyl-8-quinolinato)chlorogallium, bis(2-methyl-8-quinolinato)(o-cresolato)gallium, bis(2-methyl-8-quinolinato)(1-naphtholato)aluminum, bis(2-methyl-8-quinolinato)(2-naphtholato)gallium and the like, but is not limited thereto.

The hole blocking layer is a layer blocking holes from reaching a cathode, and may be generally formed under the same condition as the hole injection layer. Specific examples thereof may include oxadiazole derivatives or triazole derivatives, phenanthroline derivatives, BCP, aluminum complexes and the like, but are not limited thereto.

The electron blocking layer is a layer blocking electrons from reaching an anode, and materials known in the art may be used.

The organic light emitting device according to the present disclosure may be a top-emission type, a bottom-emission type or a dual-emission type depending on the materials used.

Hereinafter, the present disclosure will be described in detail with reference to examples in order to specifically describe the present disclosure.

### <Preparation Example of Compound of Chemical Formula 1>

### Preparation Example 1. Preparation of Compound 1

### Step 1) Preparation of Compound 1-1

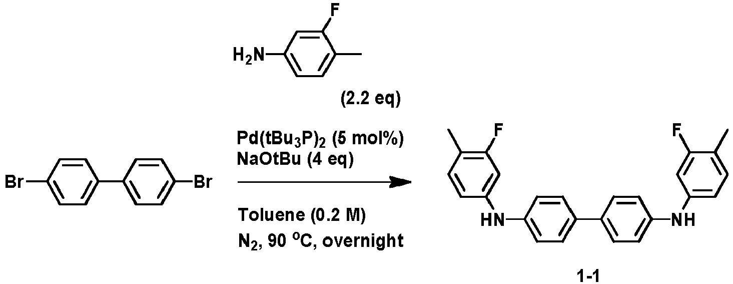

4,4'-Dibromobiphenyl (2 g, 6.4 mmol), Pd(tBu₃P)₂ (163.5 mg) and NaOtBu (2.46 g, 25.6 mmol) were introduced to a reactor, and the reactor was substituted with N₂. Toluene (32 mL) and 3-fluoro-4-methylaniline (1.6 mL, 14 mmol) were introduced thereto, and the result was stirred overnight at 90°C. A work-up was conducted by adding ethyl acetate and brine thereto, and then the result was purified by column chromatography to prepare Compound 1-1. The NMR result (1H NMR (300 Hz, CD₂Cl₂)) is shown in FIG. 2.

### Step 2) Preparation of Compound 1

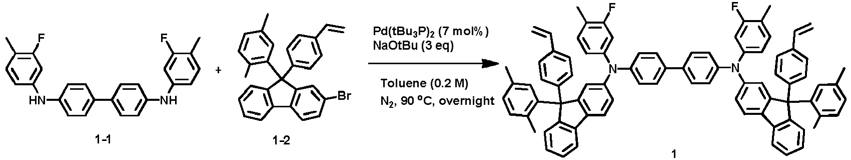

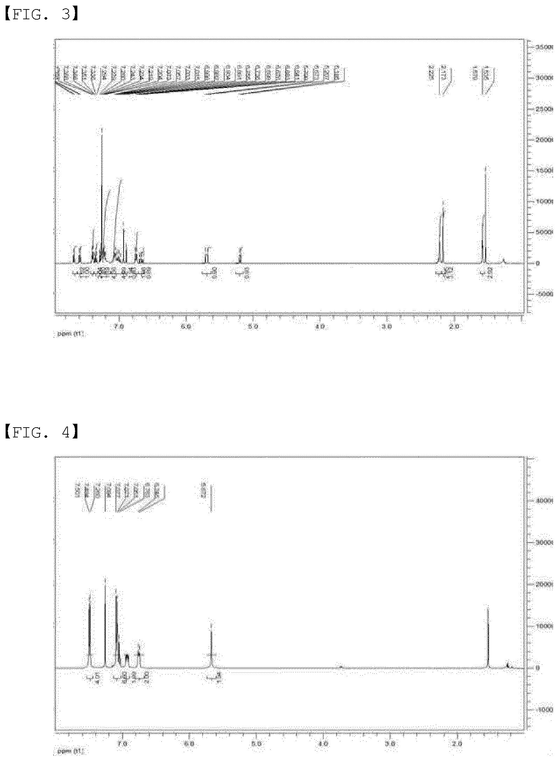

Compound 1-1 (0.6 g, 1.5 mmol), Pd(tBu₃P)₂ (54 mg) and NaOtBu (0.432 g, 4.5 mmol) were introduced to a reactor, and the reactor was substituted with N₂. Toluene (7.5 mL) and Compound 1-2 (1.386 g, 3.07 mmol) were introduced thereto, and the result was stirred overnight at 90°C. A work-up was conducted by adding ethyl acetate and water thereto, and then the result was purified by column chromatography to prepare Compound 1. The NMR result (1H NMR (300 Hz, CDCl₃)) is shown in FIG. 3.

### Preparation Example 2. Preparation of Compound 2

### Step 1) Preparation of Compound 2-1

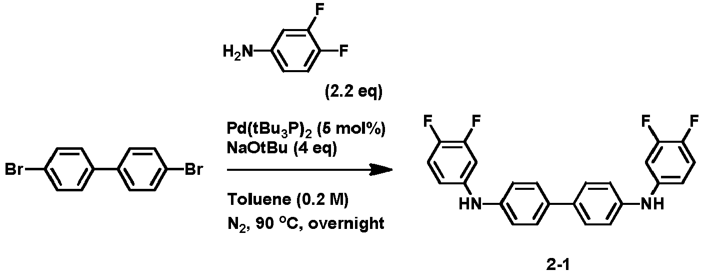

4,4'-Dibromobiphenyl (2 g, 6.4 mmol), Pd(tBu₃P)₂ (163.5 mg) and NaOtBu (2.46 g, 25.6 mmol) were introduced to a reactor, and the reactor was substituted with N₂. Toluene (32 mL) and 3,4-difluoroaniline (1.4 mL, 14.1 mmol) were introduced thereto, and the result was stirred overnight at 90°C. A work-up was conducted by adding ethyl acetate and brine thereto, and then the result was purified by column chromatography to prepare Compound 2-1. The NMR result (1H NMR (300 Hz, CDCl₃)) is shown in FIG. 4.

### Step 2) Preparation of Compound 2

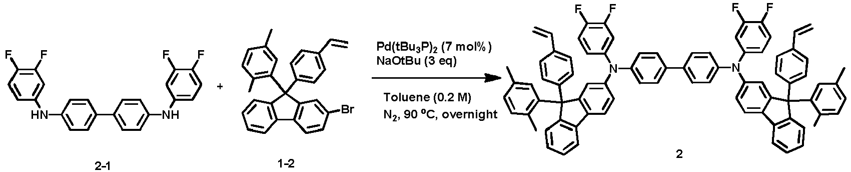

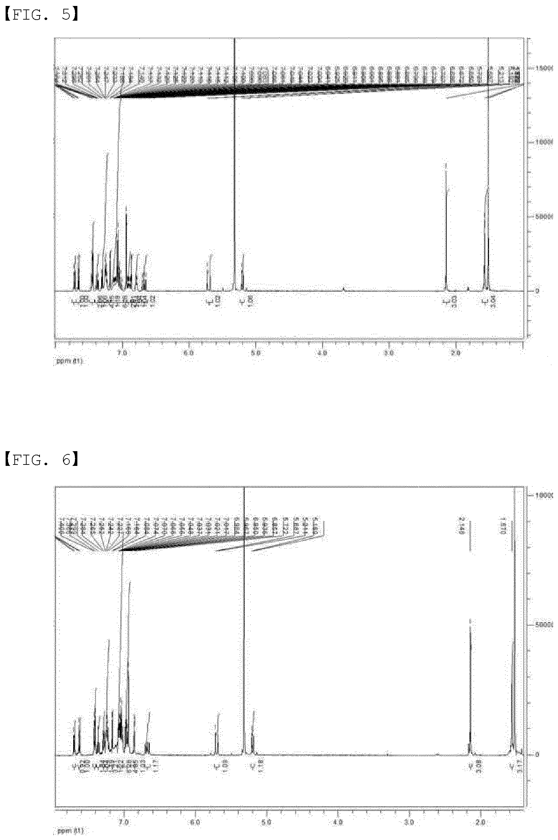

Compound 2-1 (1 g, 2.45 mmol), Pd(tBu₃P)₂ (87.6 mg, 0.17 mmol) and NaOtBu (0.706 g, 7.35 mmol) were introduced to a reactor, and the reactor was substituted with N₂. Toluene (12 mL) and Compound 1-2 (2.27 g, 5 mmol) were introduced thereto, and the result was stirred overnight at 90°C. A work-up was conducted by adding ethyl acetate and water thereto, and then the result was purified by MPLC (medium pressure liquid chromatography) and recrystallized with DCM (dichloromethane) to prepare Compound 2. The NMR result (1H NMR (300 Hz, CD₂Cl₂)) is shown in FIG. 5.

### Preparation Example 3. Preparation of Compound 3

### Step 1) Preparation of Compound 3-1

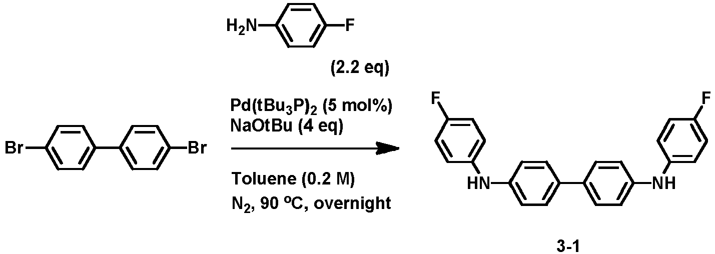

4,4'-Dibromobiphenyl (0.5 g, 1.6 mmol), Pd(tBu₃P)₂ (40.9 mg) and NaOtBu (615 mg) were introduced to a reactor, and the reactor was substituted with N₂. Toluene (8 mL) and 4-fluoroaniline (0.337 mL, 3.52 mmol) were introduced thereto, and the result was stirred overnight at 90°C. A work-up was conducted by adding ethyl acetate and brine thereto, and then the result was purified by column chromatography to prepare Compound 3-1.

### Step 2) Preparation of Compound 3

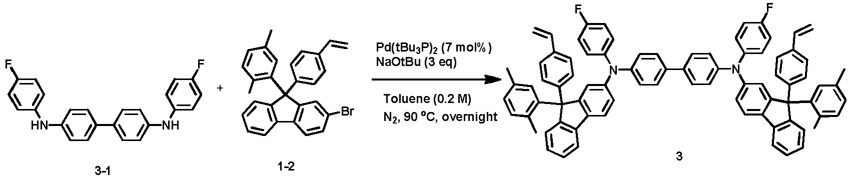

Compound 3-1 (0.32 g, 0.86 mmol), Pd(tBu₃P)₂ (31 mg) and NaOtBu (0.248 g, 2.58 mmol) were introduced to a reactor, and the reactor was substituted with N₂. Toluene (6 mL) and Compound 1-2 (900 mg, 1.76 mmol) were introduced thereto, and the result was stirred overnight at 90°C. A work-up was conducted by adding ethyl acetate and water thereto, and then the result was purified by column chromatography to prepare Compound 3. The NMR result (1H NMR (300 Hz, CDCl₃)) is shown in FIG. 6.

### Preparation Example 4. Preparation of Compound 4

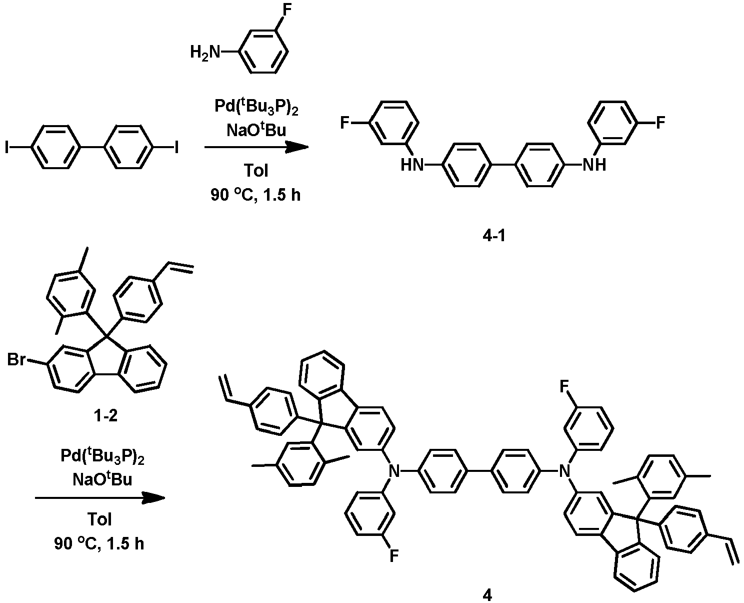

Diiodobiphenyl (5.00 g, 1.0 eq.), NaOtBu (7.10 g, 6.0 eq.), toluene (200 mL) and 3-fluoroaniline (2.39 mL, 2.02 eq.) were introduced to a round bottom flask, and after N₂ gassing, the temperature was raised to 90°C. Pd(tBu₃P)₂ (0.250 g, 4 mol%) was introduced thereto, and the result was stirred for 1.5 hours at 90°C. A work-up was conducted by adding ethyl acetate and brine thereto, and the result was purified by column chromatography to prepare Compound 4-1.

Compound 4-1 (1.0 eq.) and Compound 1-2 (11.4 g, 2.05 eq.) were introduced to a round bottom flask, and after introducing NaOtBu (7.10 g, 6.0 eq.), toluene (200 mL) and Pd(tBu₃P)₂ (0.25 g, 4 mol%) thereto, the result was stirred for 1.5 hours at 90°C. Then, the result was purified by column chromatography to prepare Compound 4.
MS: [M+H]⁺=1113

### Preparation Example 5. Preparation of Compound 5

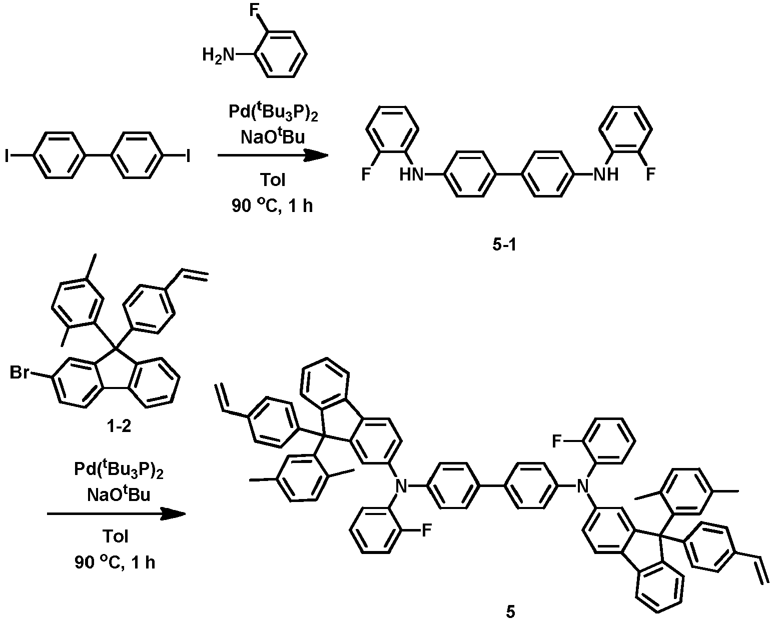

Diiodobiphenyl (5.00 g, 1.0 eq.), NaOtBu (7.10 g, 6.0 eq.), toluene (200 mL) and 2-fluoroaniline (2.40 mL, 2.02 eq.) were introduced to a round bottom flask, and after N₂ gassing, the temperature was raised to 90°C. Pd(tBu₃P)₂ (0.250 g, 4 mol%) was introduced thereto, and the result was stirred for 1 hour at 90°C. A work-up was conducted by adding ethyl acetate and brine thereto, and the result was purified by column chromatography to prepare Compound 5-1.

Compound 5-1 (1.0 eq.) and Compound 1-2 (11.4 g, 2.05 eq.) were introduced to a round bottom flask, and after introducing NaOtBu (7.10 g, 6.0 eq.), toluene (200 mL) and Pd(tBu₃P)₂ (0.25 g, 4 mol%) thereto, the result was stirred for 1 hour at 90°C. Then, the result was purified by column chromatography to prepare Compound 5.
MS: [M+H]⁺=1113

### Preparation Example 6. Preparation of Compound 6

### Step 1) Preparation of Compound 6-1

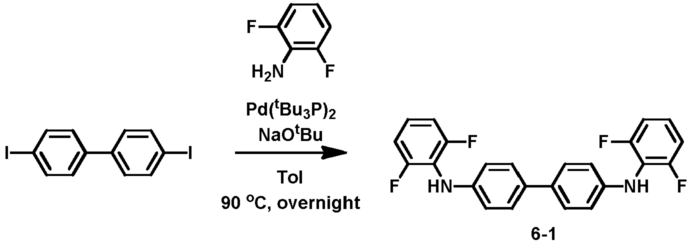

Diiodobiphenyl (6.00 g, 1.0 eq.), 2,6-difluoroaniline (4.20 g, 2.2 eq.), NaOtBu (4.26 g, 3.0 eq.) and toluene (85 mL) were introduced to a round bottom flask, and after N₂ gassing, the temperature was raised to 90°C. Pd(tBu₃P)₂ was introduced thereto, and the result was stirred overnight at 90°C.

### Step 2) Preparation of Compound 6

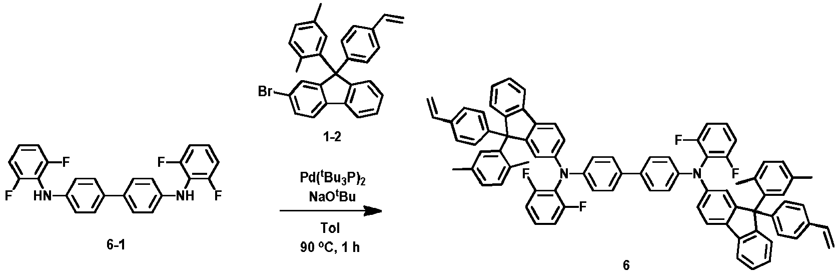

Compound 6-1 (1.30 g, 1.0 eq.), Compound 1-2 (3.02 g, 2.1 eq.), NaOtBu (0.918 g, 3.0 eq.) and toluene (30 mL) were introduced to a round bottom flask, and after N₂ gassing, the temperature was raised to 90°C. Pd(tBu₃P)₂ (0.114 g, 7 mol%) was introduced thereto, and the result was stirred for 1 hour at 90°C. Then, the result was purified by column chromatography to prepare Compound 6.
MS: [M+H]⁺=1149

### Preparation Example 7. Preparation of Compound 7

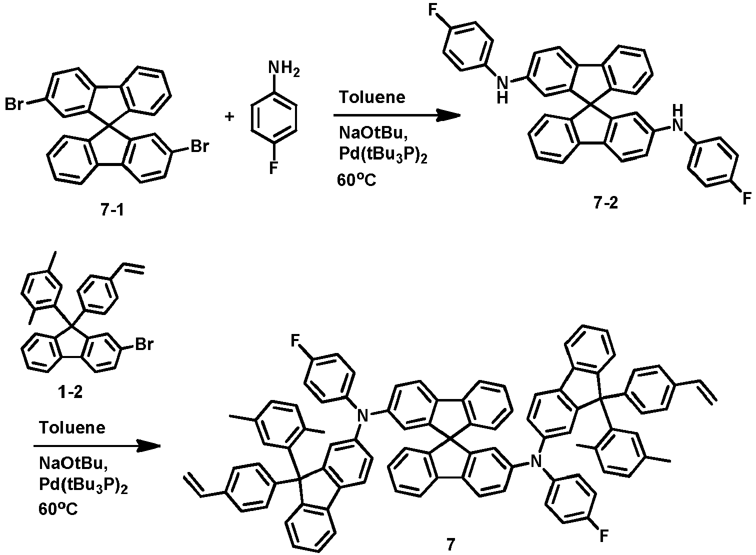

Compound 7-1 (1.0 eq.), NaOtBu (7.10 g, 6.0 eq.), toluene (200 mL) and 4-fluoroaniline (2.40 mL, 2.02 eq.) were introduced to a round bottom flask, and after N₂ gassing, the temperature was raised to 60°C. Pd(tBu₃P)₂ (0.250 g, 4 mol%) was introduced thereto, and the result was stirred for 1 hour at 60°C. A work-up was conducted by adding ethyl acetate and brine thereto, and the result was purified by column chromatography to prepare Compound 7-2.

Compound 7-2 (1.0 eq.) and Compound 1-2 (11.4 g, 2.05 eq.) were introduced to a round bottom flask, and after introducing NaOtBu (7.10 g, 6.0 eq.), toluene (200 mL) and Pd(tBu₃P)₂ (0.25 g, 4 mol%) thereto, the result was stirred for 1 hour at 60°C. Then, the result was purified by column chromatography to prepare Compound 7.
MS: [M+H]⁺=1276

### Preparation Example 8. Preparation of Compound 8

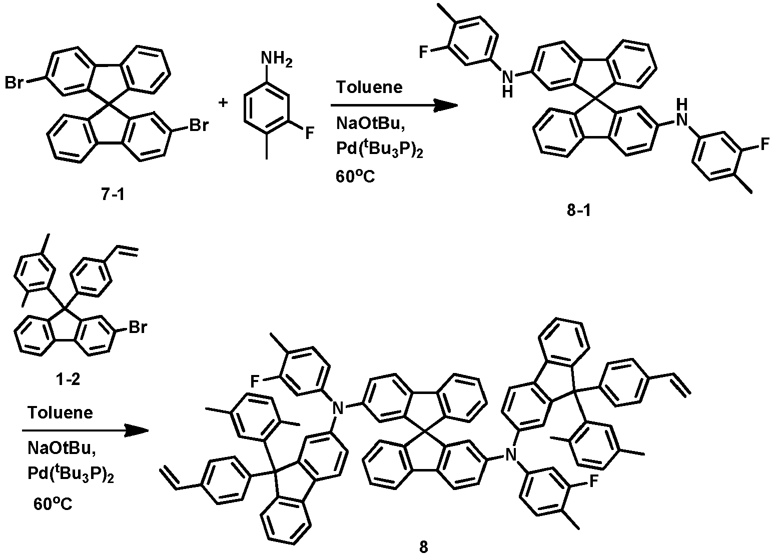

Compound 7-1 (1.0 eq.), NaOtBu (7.10 g, 6.0 eq.), toluene (200 mL) and 3-fluoro-4-methylaniline (2.02 eq.) were introduced to a round bottom flask, and after N₂ gassing, the temperature was raised to 60°C. Pd(tBu₃P)₂ (0.250 g, 4 mol%) was introduced thereto, and the result was stirred for 1 hour at 60°C. A work-up was conducted by adding ethyl acetate and brine thereto, and the result was purified by column chromatography to prepare Compound 8-1.

Compound 8-1 (1.0 eq.) and Compound 1-2 (11.4 g, 2.05 eq.) were introduced to a round bottom flask, and after introducing NaOtBu (7.10 g, 6.0 eq.), toluene (200 mL) and Pd(tBu₃P)₂ (0.25 g, 4 mol%) thereto, the result was stirred for 1 hour at 60°C. Then, the result was purified by column chromatography to prepare Compound 8.
MS: [M+H]⁺=1304

### Preparation Example 9. Preparation of Compound 9

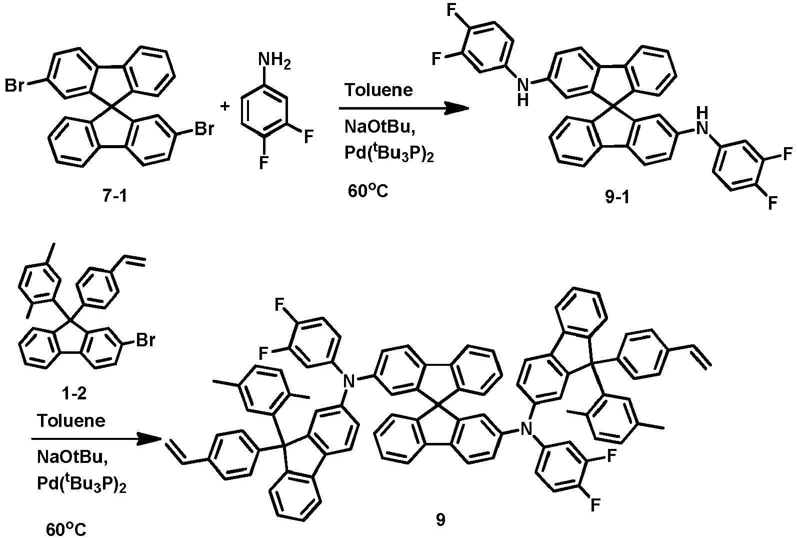

Compound 7-1 (1.0 eq.), NaOtBu (7.10 g, 6.0 eq.), toluene (200 ml), and 3,4-difluoroaniline (2.02 eq.) were introduced to a round bottom flask, and after N₂ gassing, the temperature was raised to 60°C. Pd(tBu₃P)₂ (0.250 g, 4 mol%) was introduced thereto, and the result was stirred for 1 hour at 60°C. A work-up was conducted by adding ethyl acetate and brine thereto, and the result was purified by column chromatography to prepare Compound 9-1.

Compound 9-1 (1.0 eq.) and Compound 1-2 (11.4 g, 2.05 eq.) were introduced to a round bottom flask, and after introducing NaOtBu (7.10 g, 6.0 eq.), toluene (200 mL) and Pd(tBu₃P)₂ (0.25 g, 4 mol%) thereto, the result was stirred for 1 hour at 60°C. Then, the result was purified by column chromatography to prepare Compound 9.
MS: [M+H]⁺=1312

### Preparation Example 10. Preparation of Compound 10

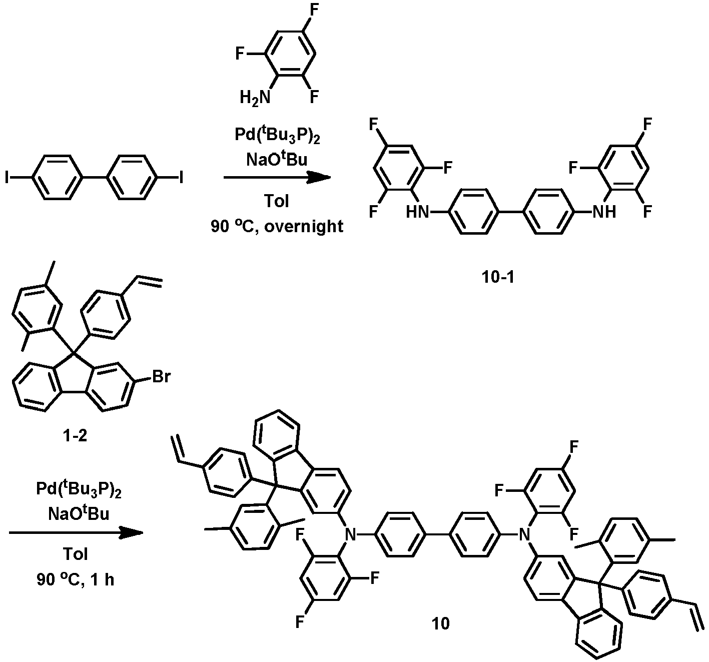

Diiodobiphenyl (4.00 g, 1.0 eq.), 2,4,6-trifluoroaniline (2.2 eq.), NaOtBu (3.79 g, 4.0 eq.) and toluene (100 mL) were introduced to a round bottom flask, and after N₂ gassing, the temperature was raised to 90°C. Pd(tBu₃P)₂ (0.25 g, 5mol%) was introduced thereto, and the result was stirred overnight at 90°C. A work-up was conducted by adding ethyl acetate and brine thereto, and the result was purified by column chromatography to prepare Compound 10-1.

Compound 10-1 (1.0 eq.) and Compound 1-2 (2.05 eq.) were introduced to a round bottom flask, and after introducing NaOtBu (6.0 eq.), toluene (100 mL) and Pd(tBu₃P)₂ (0.25 g, 5 mol%) thereto, the result was stirred for 1 hour at 90°C. Then, the result was purified by column chromatography to prepare Compound 10.
MS: [M+H]⁺=1185

### Preparation Example 11. Preparation of Compound 11

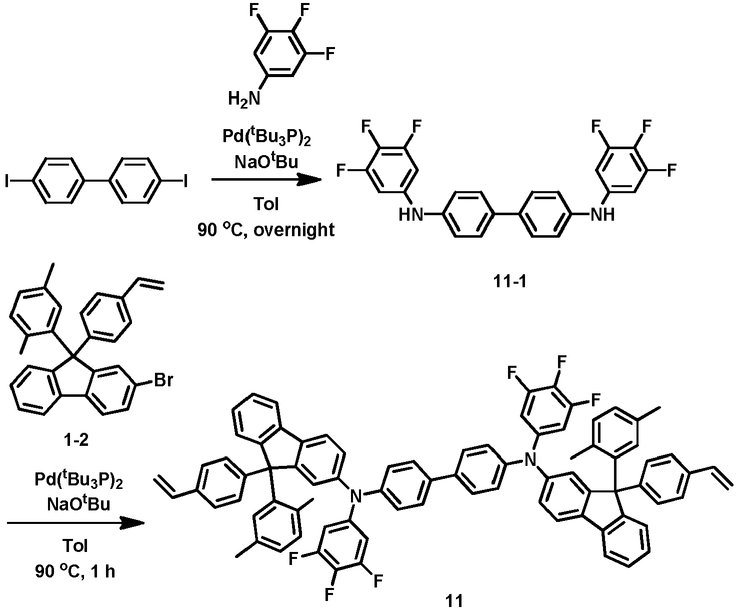

Diiodobiphenyl (4.00 g, 1.0 eq.), 3,4,5-trifluoroaniline (2.2 eq.), NaOtBu (3.79 g, 4.0 eq.) and toluene (100 mL) were introduced to a round bottom flask, and after N₂ gassing, the temperature was raised to 90°C. Pd(tBu₃P)₂ (0.25 g, 5 mol%) was introduced thereto, and the result was stirred overnight at 90°C. A work-up was conducted by adding ethyl acetate and brine thereto, and the result was purified by column chromatography to prepare Compound 11-1.

Compound 11-1 (1.0 eq.) and Compound 1-2 (2.05 eq.) were introduced to a round bottom flask, and after introducing NaOtBu (6.0 eq.), toluene (100 mL) and Pd(tBu₃P)₂ (0.25 g, 5 mol%) thereto, the result was stirred for 1 hour at 90°C. Then, the result was purified by column chromatography to prepare Compound 11.
MS: [M+H]⁺=1185

### Preparation Example 12. Preparation of Compound 12

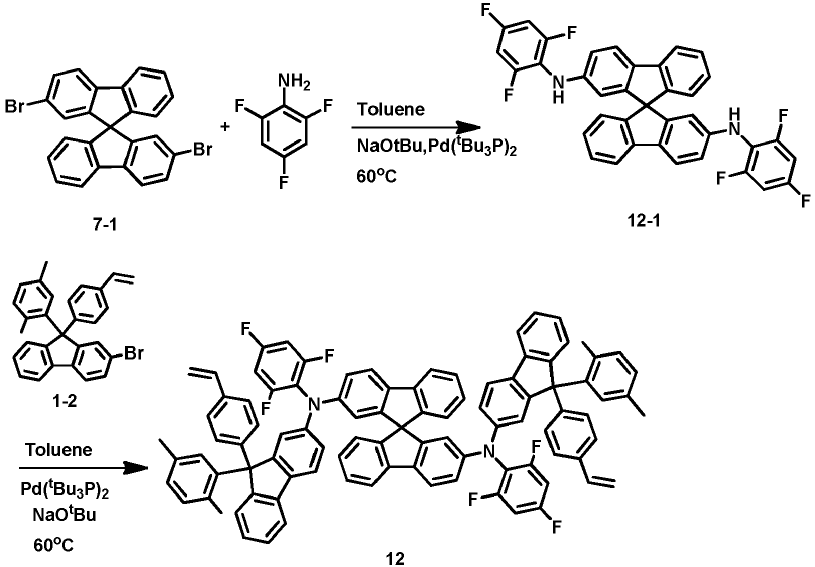

Compound 7-1 (1.0 eq.), NaOtBu (7.10 g, 6.0 eq.), toluene (200 mL) and 2,4,6-trifluoroaniline (2.02 eq.) were introduced to a round bottom flask, and after N₂ gassing, the temperature was raised to 60°C. Pd(tBu₃P)₂ (5 mol%) was introduced thereto, and the result was stirred for 1 hour at 60°C. A work-up was conducted by adding ethyl acetate and brine thereto, and the result was purified by column chromatography to prepare Compound 12-1.

Compound 12-1 (1.0 eq.) and Compound 1-2 (2.05 eq.) were introduced to a round bottom flask, and after introducing NaOtBu (6.0 eq.), toluene (100 mL) and Pd(tBu₃P)₂ (5 mol%) thereto, the result was stirred for 1 hour at 60°C. Then, the result was purified by column chromatography to prepare Compound 12.
MS: [M+H]⁺=1348

### Preparation Example 13. Preparation of Compound 13

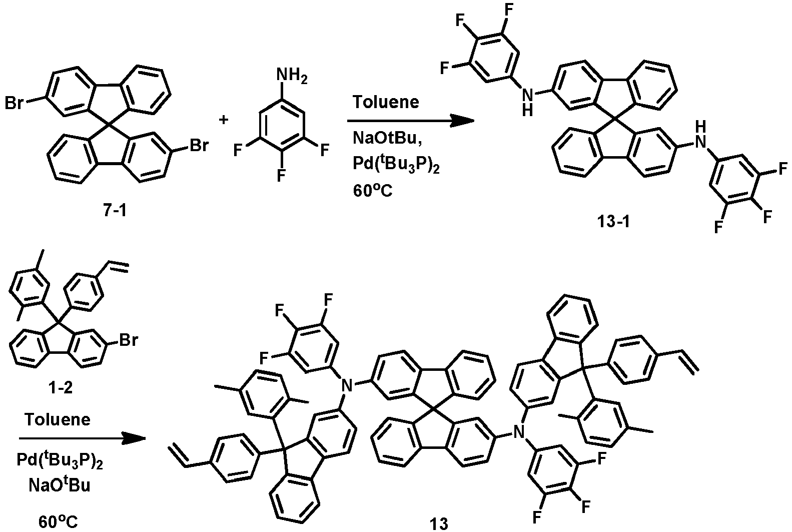

Compound 7-1 (1.0 eq.), NaOtBu (7.10 g, 6.0 eq.), toluene (200 mL) and 3,4,5-trifluoroaniline (2.02 eq.) were introduced to a round bottom flask, and after N₂ gassing, the temperature was raised to 60°C. Pd(tBu₃P)₂ (4 mol%) was introduced thereto, and the result was stirred for 1 hour at 60°C. A work-up was conducted by adding ethyl acetate and brine thereto, and the result was purified by column chromatography to prepare Compound 13-1.

Compound 13-1 (1.0 eq.) and Compound 1-2 (2.05 eq.) were introduced to a round bottom flask, and after introducing NaOtBu (6.0 eq.), toluene (100 mL) and Pd(tBu₃P)₂ (5 mol%) thereto, the result was stirred for 1 hour at 60°C. Then, the result was purified by column chromatography to prepare Compound 13.
MS: [M+H]⁺=1348

### Preparation Example 14. Preparation of Compound 14

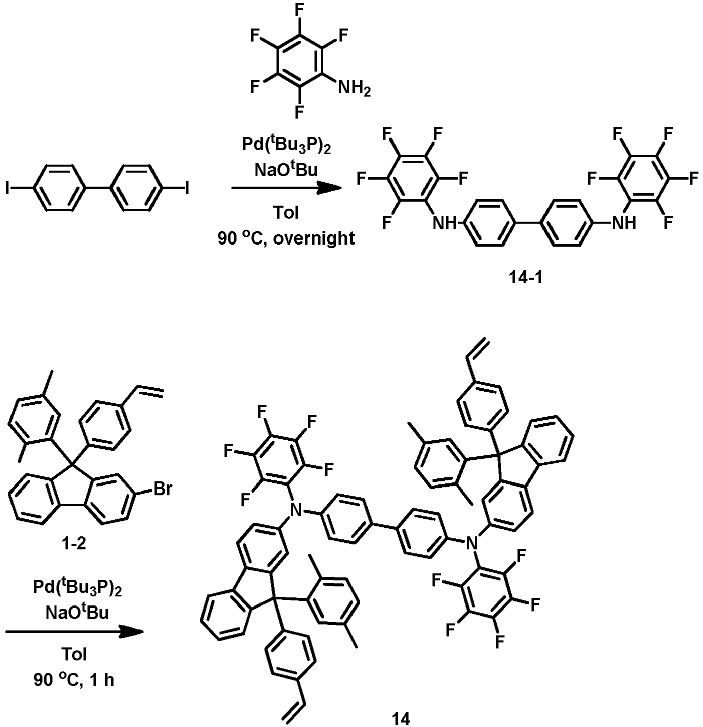

Diiodobiphenyl (6.00 g, 1.0 eq.), 2,3,4,5,6-pentafluoroaniline (2.2 eq.), NaOtBu (4.26 g, 3.0 eq.) and toluene (120 mL) were introduced to a round bottom flask, and after N₂ gassing, the temperature was raised to 90°C. Pd(tBu₃P)₂ (4 mol%) was introduced thereto, and the result was stirred for 1 hour at 90°C. A work-up was conducted by adding ethyl acetate and brine thereto, and the result was purified by column chromatography to prepare Compound 14-1.

Compound 14-1 (1.0 eq.) and Compound 1-2 (2.05 eq.) were introduced to a round bottom flask, and after introducing NaOtBu (6.0 eq.), toluene (100 mL) and Pd(tBu₃P)₂ (5 mol%) thereto, the result was stirred for 1 hour at 90°C. Then, the result was purified by column chromatography to prepare Compound 14.
MS: [M+H]⁺=1257

### Preparation Example 15. Preparation of Compound 15

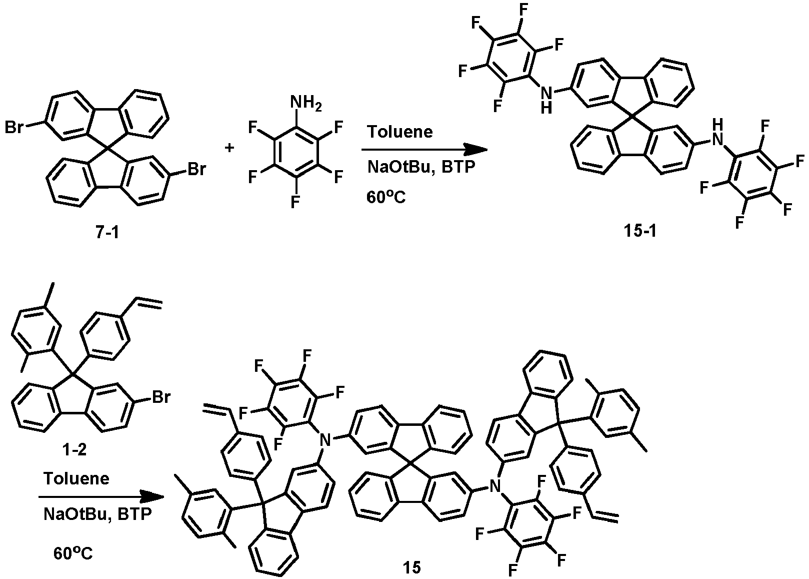

Compound 7-1 (1.0 eq.), NaOtBu (7.10 g, 6.0 eq.), toluene (200 mL) and 2,3,4,5,6-pentafluoroaniline (2.02 eq.) were introduced to a round bottom flask, and after N₂ gassing, the temperature was raised to 60°C. Pd(tBu₃P)₂ (4 mol%) was introduced thereto, and the result was stirred for 1 hour at 60°C. A work-up was conducted by adding ethyl acetate and brine thereto, and the result was purified by column chromatography to prepare Compound 15-1.

Compound 15-1 (1.0 eq.) and Compound 1-2 (2.05 eq.) were introduced to a round bottom flask, and after introducing NaOtBu (6.0 eq.), toluene (100 mL) and Pd(tBu₃P)₂ (5 mol%) thereto, the result was stirred for 1 hour at 60°C. Then, the result was purified by column chromatography to prepare Compound 15.
MS: [M+H]⁺=1419

Preparation Examples 1 to 15 illustrate synthesis methods of the compound of Chemical Formula 1, and by adjusting types, bonding positions and the number of substituents, the compound of Chemical Formula 1 may be synthesized.

### <Preparation Example of Ionic Compound>

### Preparation Example 1. Preparation of Compound 3-1

### Step 1) Preparation of Compound 3-1'

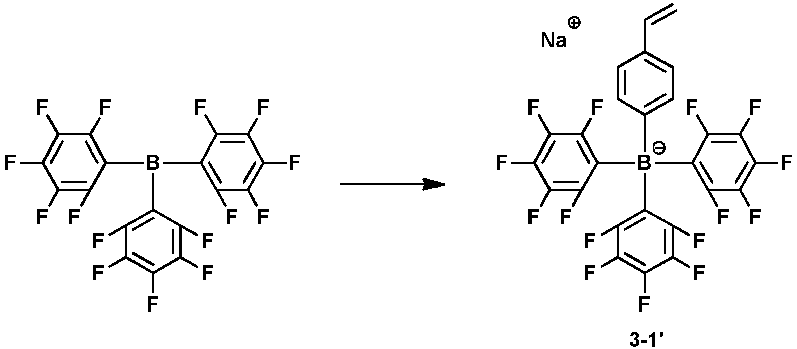

Mg (193 mg, 7.92 mmol), I₂ (4 mg) and THF (10 mL) were introduced to a 100 mL round bottom flask under the nitrogen atmosphere, and stirred for 30 minutes. 4-Bromostyrene (1.04 mL, 7.92 mmol) was introduced thereto, and after placing a 30°C water bath under the round bottom flask, the result was stirred for one day. With the reaction solution turning black, dissolution of Mg was identified. Ether (5 mL) was added thereto to dilute the reaction solution. Tris(pentafluorophenyl)borane (1 g, 3.96 mmol) dissolved in ether (5 mL) was slowly added to the reaction solution for 30 minutes. The solution was stirred for one day. Na₂CO₃ (0.1 M, 80 mL, 8.0 mmol) was slowly added to the reaction solution. The organic solvent was extracted using ethyl acetate (20 mLx3), and residual water was removed with MgSO₄. In order to additionally remove residual water and impurities, the result was distilled with benzene using Dean-Stark. When approximately 10 mL of the solvent remained, the solution was cooled and filtered to prepare Compound 3-1' (1.6 g, yield 64%) .

### Step 2) Preparation of Compound 3-1

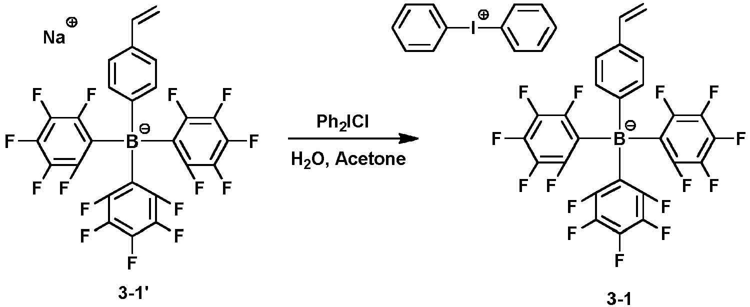

Compound 3-1' (100 mg, 0.16 mmol), distilled water (10 mL) and Ph₂ICl (60 mg, 0.19 mmol) were introduced to a 25 mL round bottom flask, and stirred for 1 hour. Acetone (15 mL) was added to the reaction solution to produce precipitates, and the precipitates were filtered and dried to prepare Compound 3-1 (140 mg, yield 100%).
MS: [M-H]⁻=615 (negative mode)
MS: [M+H]⁺=281 (positive mode)

### Preparation Example 2. Preparation of Compound 3-2

### Step 1) Preparation of Compound 3-2'

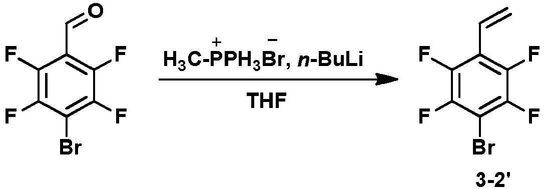

Methyltriphenyl potassium bromide (13.90 g, 38.91 mmol) and THF (100 mL) were introduced to a 250 mL round bottom flask, and stirred for 30 minutes at 0°C. n-BuLi (15.6 mL, 38.91 mmol, 2.5 M in hexane) was slowly added to the reaction solution, and the result was stirred for 30 minutes at 0°C. At 0°C, 4-formyl-2,3,5,6-tetrafluoro-1-bromobenzene (5.0 g, 19.47 mmol, in 30 mL THF) was slowly added to the reaction solution. The reaction solution was stirred while slowly raising the temperature to room temperature. After 3 hours, ether (100 mL) and a saturated NH₄Cl solution (400 mL) were added to the reaction solution. The organic solvent was extracted using ether (200 mLx2), and residual water was removed with MgSO₄. The result was columned using ethyl acetate:hexane=1:9 (v:v) to prepare Compound 3-2' (1.29 g, yield 26%).

### Step 2) Preparation of Compound 3-2"

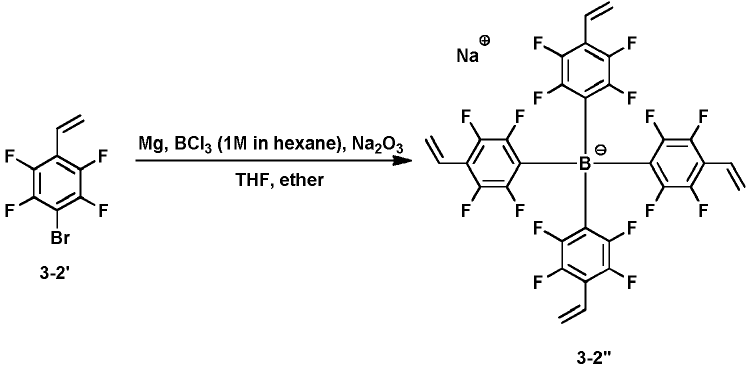

Mg (95 mg, 3.92 mmol), THF (10 mL) and I₂ (4 mg) were introduced to a 25 mL round bottom flask, and stirred. Compound 3-2' (1.0 g, 3.92 mmol) was introduced to the reaction solution, and the result was stirred at room temperature. After 10 hours, complete dissolution of Mg was identified with the solution turning black, and ether (10 mL) and BCl₃ (1.3 mL, 1.3 mmol, 1 M in hexane solution) were added thereto over 30 minutes. The reaction solution was stirred for one day, and Na₂CO₃ (30 mL, 3.0 mmol, 0.1 M in H₂O) was added thereto. The synthesized material was extracted using ethyl acetate (10 mLx3), and residual water was removed with MgSO₄. After the solvent was all removed, water was completed removed with Dean-Stark using benzene, and the solids were filtered to prepare Compound 3-2" (340 mg, yield 28%).

### Step 3) Preparation of Compound 3-2

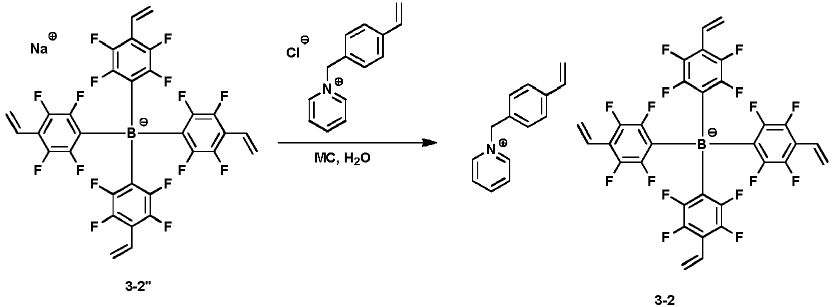

Compound 3-2" (200 mg, 0.27 mmol), 1-(4-vinylbenzyl)pyridin-1-ium chloride (69 mg, 0.30 mmol), H₂O (10 mL) and methylene chloride (10 mL) were introduced to a 25 mL round bottom flask, and vigorously stirred for 30 minutes. The organic solvent was extracted using ether (10 mLx3), and residual water was removed with MgSO₄. The solvent was removed, and the result was vacuum dried to prepare Compound 3-2 (247 mg, yield 100%).
MS: [M-H]⁻=711 (negative mode)
MS: [M+H]⁺=196 (positive mode)

### Preparation Example 3. Preparation of Compound 3-3

### Step 1) Preparation of Compound 3-3'

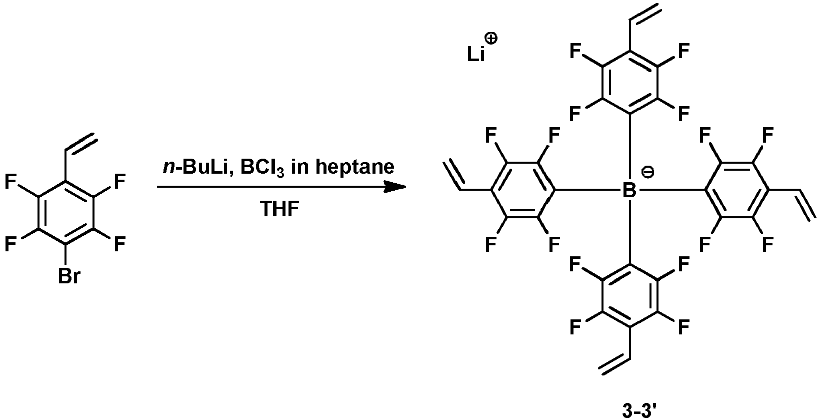

In a 50 mL round bottom flask, 1-bromo-2,3,5,6-tetrafluoro-4-vinylbenzene (2 g, 7.84 mmol) was introduced to THF (20 mL), and stirred for 30 minutes at -78°C. n-BuLi in hexane (3.45 mL, 8.63 mmol, 2.5 M) was slowly introduced to the solution, and the result was stirred for 30 minutes at -78°C. BCl₃ (2.6 mL, 2.61 mmol, 1 M in hexane solution) was added to the reaction solution over 15 minutes at -78°C. The reaction solution was stirred for one day while slowly raising the temperature to room temperature, and water (30 mL) was added thereto. The synthesized material was extracted using ethyl acetate (10 mLx3), and the solvent was all removed. Water was completed removed with Dean-Stark using benzene, and the solids were filtered to prepare Compound 3-3' (800 mg, yield 43%).

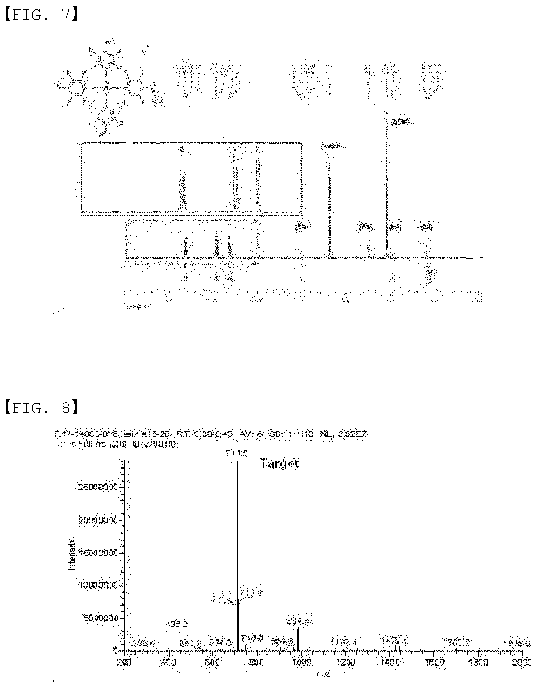

An NMR spectrum of Compound 3-3' is shown in FIG. 7. A mass spectrum of Compound 3-3' is shown in FIG. 8.

### Step 2) Preparation of Compound 3-3

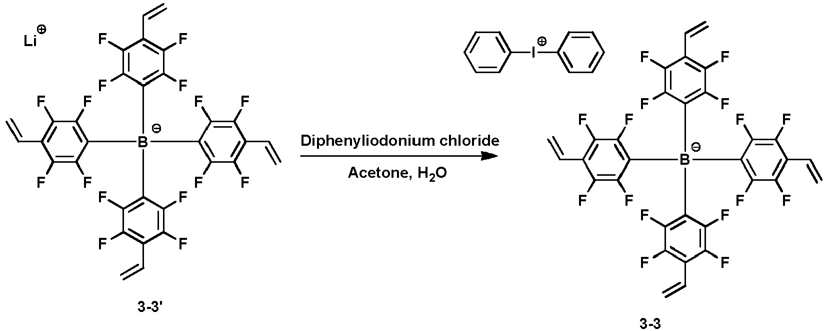

Compound 3-3' (400 mg, 0.56 mmol), diphenyliodonium chloride (176 mg, 0.56 mmol), water (10 mL) and acetone (10 mL) were introduced to a 25 mL round bottom flask, and vigorously stirred for 30 minutes. The result was extracted using dichloromethane (10 mLx3), and after removing the solvent, the result was dried to prepare Compound 3-3 (552 mg, yield 100%).
MS: [M-H]⁻=711 (negative mode)
MS: [M+H]⁺=281 (positive mode)

### Preparation Example 4. Preparation of Compound 3-4

### Step 1) Preparation of Compound 3-4'

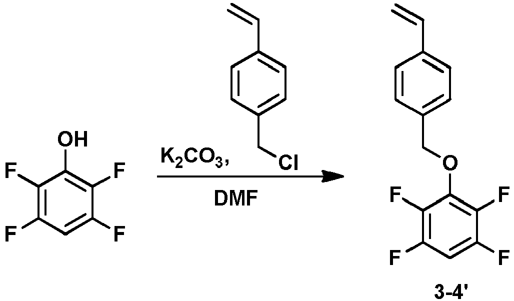

Potassium carbonate (10.4 g, 75.3 mmol) was introduced to a 500 mL round bottom flask, and dimethylformamide (DMF) (200 ml) was introduced thereto. To the flask, 2,3,5,6-tetrafluorophenol (10.0 g, 60.22 mmol) was introduced, and the result was stirred for 30 minutes at 60°C. 4-Vinylbenzyl chloride (7.66 g, 50.18 mmol) was slowly added to the reaction solution, and the result was stirred for 16 hours at 60°C. After that, water (300 mL) and ethyl acetate (200 ml) were added thereto. The organic layer was extracted using ethyl acetate (200 mLx2), and residual water was removed with MgSO₄. The result was columned using ethyl acetate:hexane=1:9 (v:v) to prepare Compound 3-4' (11.2 g, yield 79%).

### Step 2) Preparation of Compound 3-4"

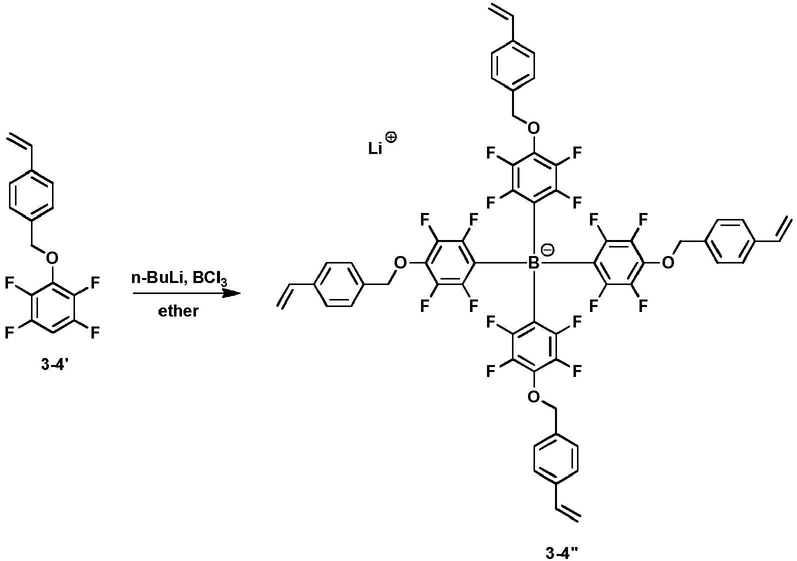

Compound 3-4' (10 g, 35.43 mmol) was introduced to a 250 ml round bottom flask, and after introducing ether (130 ml) thereto, the mixture was stirred. The reaction solution was cooled to -78°C, and stirred for 30 minutes. n-BuLi (17 ml, 42.52 mmol, 2.5 M in hexane) was slowly injected thereto over 30 minutes. After that, the result was stirred for 1 hour. BCl₃ (8.15 ml, 8.15 mmol, 1 M in hexane) was slowly introduced thereto over 30 minutes. The temperature of the reaction solution was slowly raised to room temperature. The reaction solution was stirred for one day, and water (200 ml) was introduced thereto. The synthesized material was extracted using ether (100 mLx3), and the solvent was all removed. After that, water was completed removed with Dean-Stark using benzene, and the solids were filtered to prepare Compound 3-4" (6.2 g, yield 66%).

### Step 3) Preparation of Compound 3-4

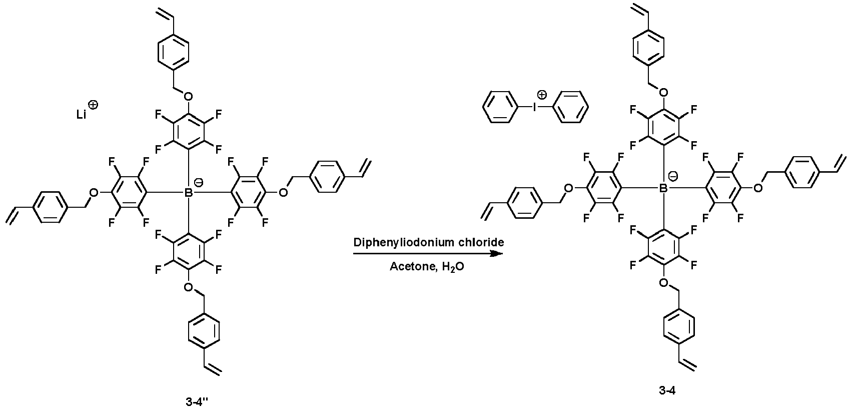

Compound 3-4" (6.2 g, 5.42 mmol), diphenyliodonium chloride (2.57 g, 8.13 mmol), water (50 mL) and acetone (10 mL) were introduced to a 25 mL round bottom flask, and vigorously stirred for 30 minutes. The organic solvent was extracted using methylene chloride (20 mLx3), and the solvent was removed. The result was columned using methylene chloride:acetone=9:1 (v:v) to prepare Compound 3-4 (5.0 g, yield 65%).
MS: [M-H]⁻=1135 (negative mode)
MS: [M+H]⁺=281 (positive mode)

Preparation Examples 1 to 4 illustrate synthesis methods of the ionic compound including the anion group of Chemical Formula 2, and by adjusting types, bonding positions and the number of substituents, the ionic compound may be synthesized.

### <Preparation Example of Copolymer of Chemical Formula 3>

### Preparation Example 1. Copolymer Type 5 (a1:b1:e1=58:12:30)

### Step 1) Preparation of Intermediate A

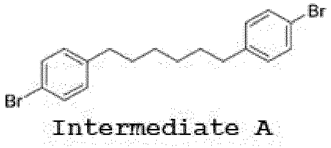

To a 1 L 3-neck round bottom flask oven dried under the nitrogen, 1,4-dibromobenzene (55.84 g, 236.71 mmol) and anhydrous THF (400 mL) were added. Once all the starting materials were dissolved, the solution was cooled to -67°C (inner temperature). A slight precipitation of dibromobenzene was observed. Once the solution was cooled, n-butyl lithium (15.16 g, 236.71 mmol) was added thereto via cannula transfer. The solution was left to stir for 15 minutes at -67°C, and carful observation was required in the stirring due to lithium salt precipitation. 1,6-Diiodohexane (40.00 g, 118.35 mmol) was added thereto, and the bath was left to warm slowly to room temperature to produce a clear solution. The solution was left to stir for 16 hours at room temperature. The solution was slowly quenched with 1 N HCl (200 mL). A slight heat generation was observed. The layers were separated, and the organic layer was dried with NaSO₄ and concentrated through rotary evaporation. The temperature of the water bath was raised to 55°C to distill low molecular weight impurities. A remaining product (crude) was purified using flash chromatography (silica, 100% hexane isocratic). Second purification was conducted using flash chromatography (C18, 10% H₂O:90% ACN isocratic). The ACN was removed to precipitate a product, which was collected by filtration. Intermediate A was obtained in a 19% yield (8.871 g) as white solids.

### Step 2) Preparation of Intermediate XL1

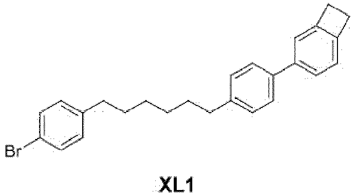

To a 500 mL 3-neck flask oven dried under the nitrogen, Compound A (8.871 g, 22.39 mmol), benzocyclobutene-4-boronic acid (3.313 g, 22.39 mmol), sodium carbonate (7.12 g, 67.17 mmol) and 1:1 m-xylene:water (80 mL) were added. The solution was degassed. Tetrakis(triphenylphosphine)Pd(0) (7.12 g, 67.17 mmol) was added to the solution. The produced mixture was heated to 100°C for 4 hours. Toluene (100 mL) and water (50 mL) were added to the reaction mixture. The layers were separated, and the organic layer was dried with NaSO₄ and filtered through celite, Florisil and silica gel pad. The crude material was concentrated to obtain yellow oil. This was purified using flash chromatography (silica, hexane:DCM 0%-10%). The pure fractions were concentrated to obtain white solids. The produced material was dissolved in acetonitrile (400 mL). Water (50 mL) was added thereto. The ACN was removed by rotary evaporation to precipitate a product, which was filtered and collected as white solids (2.854 g, 30% yield).

### Step 3) Preparation of Monomer M1

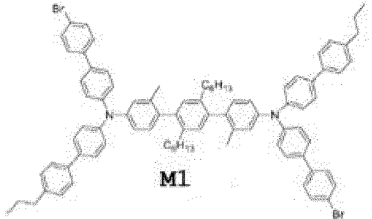

Syntheses of M1 and other monomers are described in the International Patent Publication No. WO 2011/159872. The syntheses may be conducted according to the following scheme.

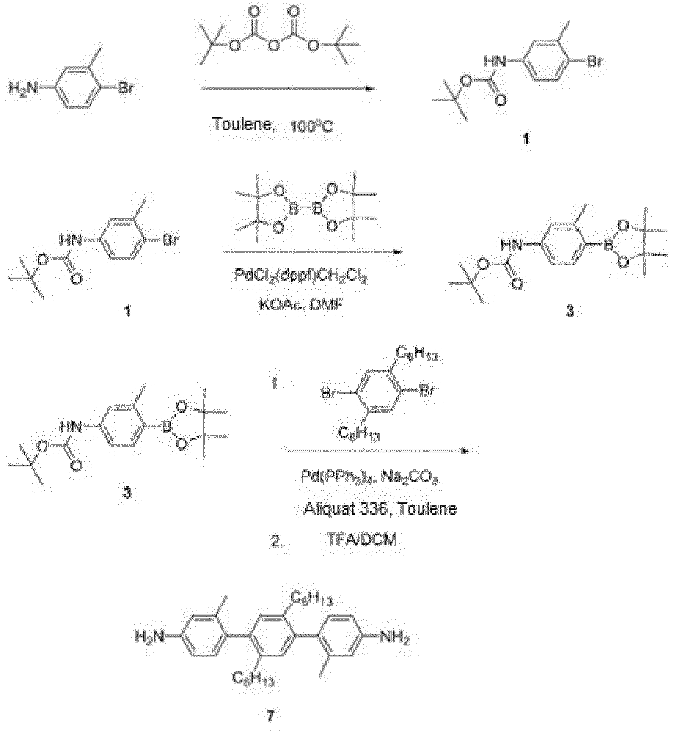

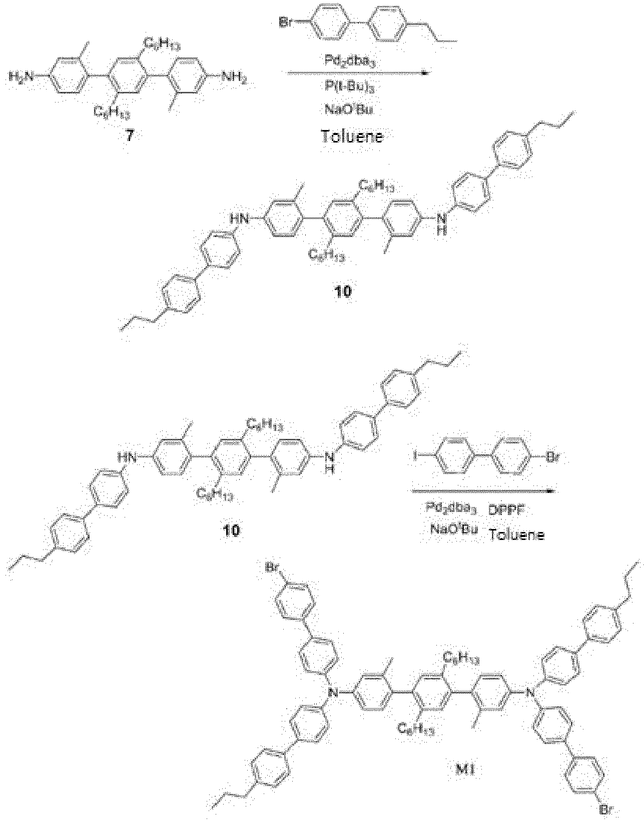

### Step 4) Preparation of Copolymer Type 5 (a1:b1:e1=58:12:30)

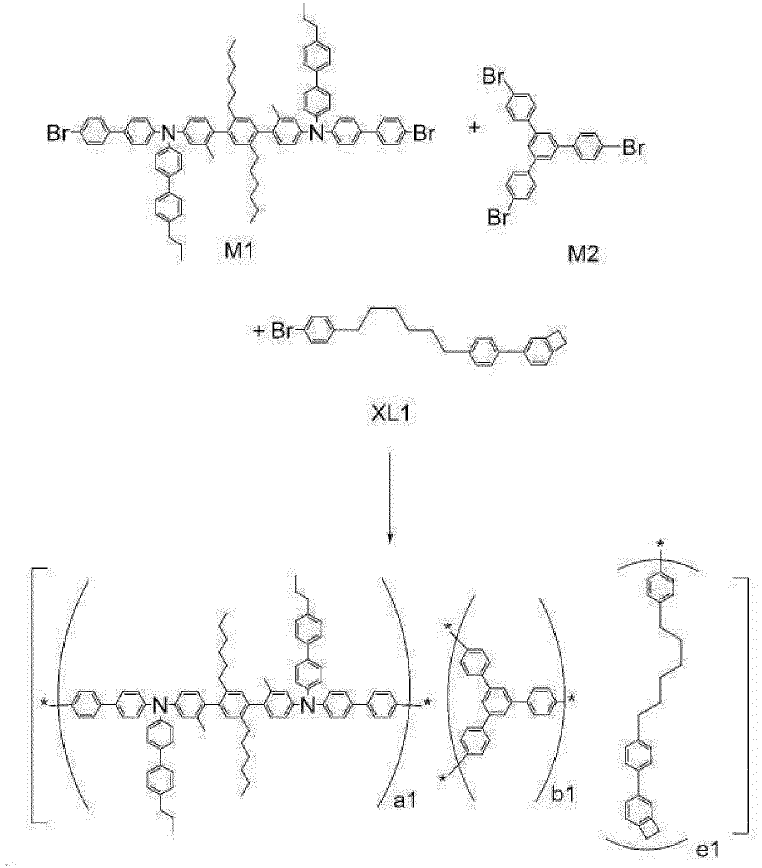

Compounds M1 (0.765 mmol), M2 (0.158 mmol) and XL1 (0.396 mmol) were added to a scintillation vial, and dissolved in toluene (11 mL). A clean and dry 50 mL Schlenk tube was filled with bis (1, 5-cyclooctadiene) nickel (0) (2.42 mmol). 2,2'-Dipyridyl (2.42 mmol) and 1,5-cyclooctadiene (2.42 mmol) were weighed and introduced to a scintillation vial, and dissolved in N,N'-dimethylformamide (5.5 mL) and toluene (11 mL). The solution was added to the Schlenk tube, which was then inserted into an aluminum block, and heated to an inner temperature of 50°C. The catalyst system was maintained for 30 minutes at 50°C. The monomer solution in toluene was added to the Schlenk tube, and the tube was sealed.

The polymerization mixture was stirred for 180 minutes at 50°C. Then, the Schlenk tube was taken out of the block, and left to cool to room temperature. The contents were poured into HCl/methanol (5% v/v, concentrated HCl). After stirring for 45 minutes, a polymer was collected by vacuum filtration, and dried under high vacuum. The polymer was dissolved in toluene (1% wt/v), and passed through a column containing basic aluminum oxide (6 grams) layered on silica gel (6 grams). The polymer/toluene filtrate was concentrated (2.5% wt/v toluene), and triturated with 3-pentanone. The toluene/3-pentanone solution was gradient separated from the semi-solid polymer, then dissolved in toluene (15 mL), and poured into stirring methanol to obtain Copolymer Type 5 (a1:b1:e1=58:12:30) in a 60% yield (Mw: 32,000).

Using the method for preparing Copolymer Type 5 (a1:b1:e1=58:12:30) described above, other copolymer types may be prepared in a similar manner.

The copolymer was characterized by gel permeation chromatography ("GPC") using a multi-angle light scattering detector as a detector and an in-line viscometer, and using THF as a solvent.

### Preparation Example 2. Copolymer Type 17 (a1:b1:e1=47:21:32)

Copolymer Type 17 is prepared by Suzuki coupling as shown in the following scheme. In the Suzuki approach method, an end-capping monomer was filled last after converting the monomers for unit A and unit B' to a polymer. This is conducted to consume all residual functional groups remaining on the polymer.

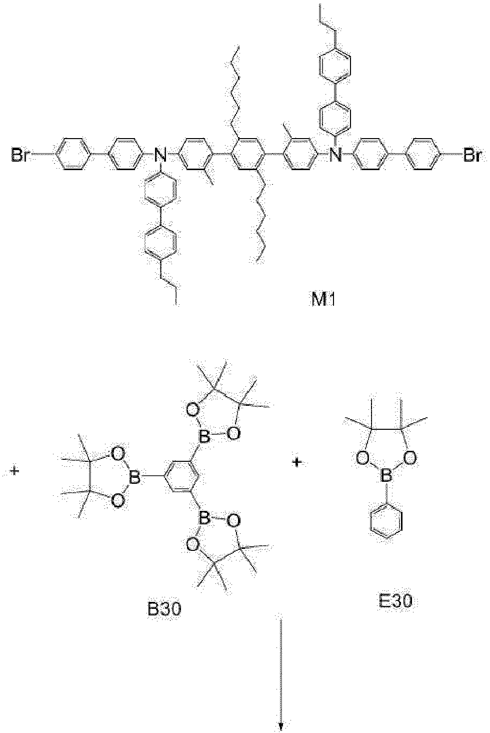

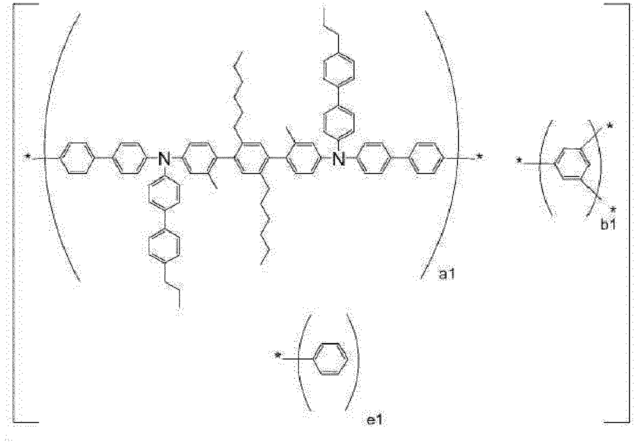

Under an inert gas condition, Compound M1 (0.207 mmol), Compound B30 (0.092 mmol), Aliquat 336 (0.041 mmol), an aqueous potassium carbonate solution (0.5 M, 1.24 mL), bis(di-tert-butyl(4-dimethylaminophenyl)phosphine)dichloropalladium(II) (0.1 mmol) and toluene (total 6.0 mL) were added to a scintillation vial equipped with a magnetic stir bar. The vial was sealed with a screw cap having a diaphragm, inserted into an aluminum block, heated to an outer temperature of 105°C over 30 minutes, and stirred for 5 hours at the temperature under mild reflux. Then, bis(di-tert-butyl(4-dimethylaminophenyl)phosphine)dichloropalladium(II) (0.05 pmol), phenylboronic acid pinacol ester E30 (0.138 mmol) and toluene (0.9 ml) was introduced to the reaction material. The reaction material was heated again for 1.5 hours at the temperature specified above. Then, iodobenzene (0.092 mmol) and toluene (0.6 mL) were added thereto. The reaction material was further heated for 1.5 hours, and then cooled to room temperature. The aqueous layer was removed, and the organic layer was washed twice using deionized water (20 mL each). The toluene layer was dried by passing through silica gel (10 g) as a drying agent, and the silica was rinsed with toluene. The solvent was removed to obtain a product (250 mg). The toluene solution was passed through alumina, silica gel and Florisil ^{®} to further purify the crude product. After concentration, the solvent-soaked product was diluted with toluene (approximately 14 mL), and then added to ethyl acetate (150 mL) to obtain a polymer (approximately 200 mg). The product toluene solution was reprecipitated in 3-pentanone to obtain final Copolymer Type 17 (a1:b1:e1=47:21:32) (145 mg) (Mw: 232,350).

### Preparation Example 3. Copolymer Type 9 (a1:b1:e1=42:17:41)

Copolymer Type 9 is prepared by Suzuki coupling as shown in the following scheme.

### Step 1) Preparation of Monomer M3

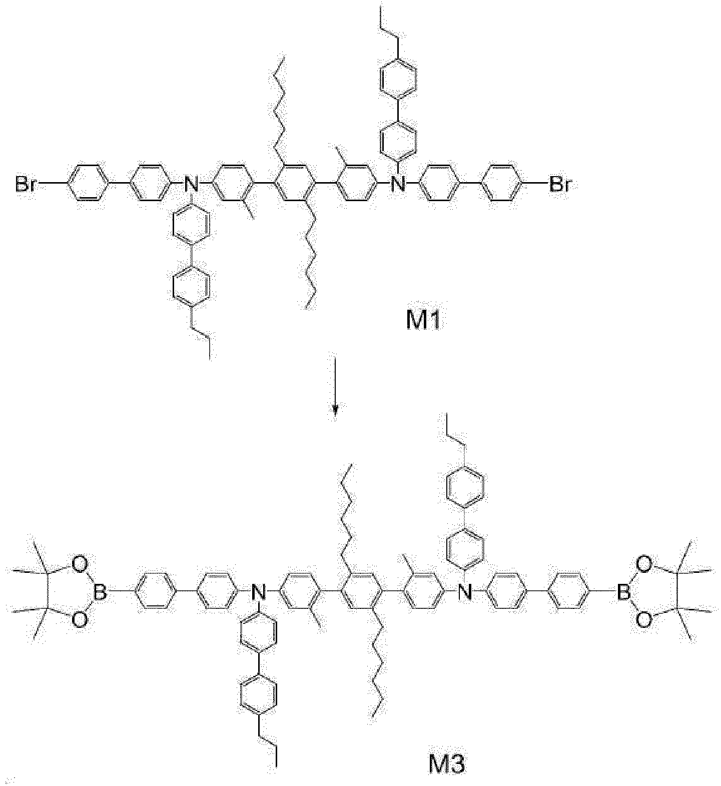

A 1 L jacketed-reactor equipped with an overhead mechanical stirrer and a reflux condenser was filled with Compound M1 (27.81 g, 21.3 mmol), bis(pinacolato)diboron (16.2 g, 63.8 mmol), potassium acetate (8.35 g, 85.1 mmol) and 1,4-dioxane (280 mL), and inerted. After that, the reactor was filled with a complex of [1,1'-bis(diphenyl-phosphino)ferrocene]dichloropalladium(II) (0.70 g) and dichloromethane under an inert atmosphere, and the reaction mixture was heated to an outer temperature of approximately 97°C over a period of 1 hour. After 10 hours of heating, the reaction was considered complete, and the result was cooled to 25°C. The reaction mixture was passed through a layer of celite, and then washed with a mixture of dichloromethane/hexane (1:1 v/v) (250 mL). The solvent was removed and the residue was diluted with dichloromethane/hexane (1:1, v/v) (50 mL), and the addition of dichloromethane helped to load a crude mixture onto a column containing silica gel (150 g) pre-embedded with boric acid. The collected product fractions were combined and purification by column was repeated using silica gel (300 g) embedded with boric acid. After removing the solvent, a bright colored monomer (19.1 g) was obtained. Using dichloromethane/hexane, the monomer was passed through a column packed with Florisil (190 g) to accomplish additional purification. Lastly, the monomer was dissolved in toluene/hexane, and precipitated in methanol to isolate solid Monomer M3 (15.4 g) in a 52% yield.

### Step 2) Preparation of Copolymer Type 9 (a1:b1:e1=42:17:41)

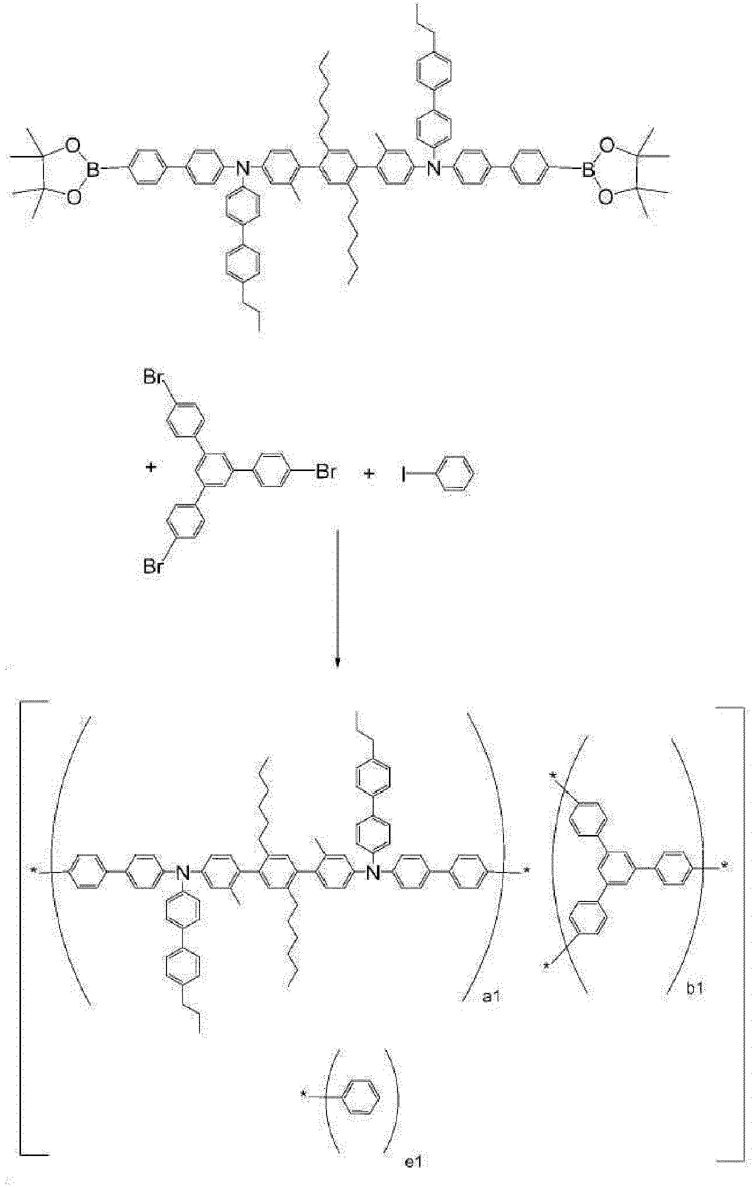

Synthesis was conducted in a similar manner as in Preparation Example 2 (Mw: 461,000).

In devices of the following examples, copolymers described in the following Table 1 were used.

**[Table 1]**

| Specific Copolymer | Copolymer Type | Molar Ratio | Weight Average Molecular Weight (Mw) |
|---|---|---|---|
| HTL1-1 | Copolymer Type 1 | 58:12:30 | 69,000 |
| HTL1-2 | Copolymer Type 1 | 38:12:50 | 13,000 |
| HTL2-1 | Copolymer Type 2 | 76:12:12 | 1,600,000 |
| HTL2-2 | Copolymer Type 2 | 68:12:20 | 150,000 |
| HTL3-1 | Copolymer Type 3 | 58:12:30 | 22,000 |
| HTL3-2 | Copolymer Type 3 | 76:12:12 | 53,000 |
| HTL4-1 | Copolymer Type 7 | 52:20:28 | 108,800 |
| HTL4-2 | Copolymer Type 7 | 54:20:26 | 130,700 |
| HTL5-1 | Copolymer Type 15 | 58:12:30 | 15,000 |
| HTL5-2 | Copolymer Type 15 | 52:20:28 | 14,000 |

### <Experimental Example>

### Example 1

A glass substrate on which ITO was deposited as a thin film to a thickness of 1,500 Å was ultrasonic cleaned for 10 minutes using an acetone solvent. After that, the substrate was placed in detergent-dissolved distilled water, and after cleaning for 10 minutes with ultrasonic waves, ultrasonic cleaning was repeated twice for 10 minutes using distilled water. After the cleaning with distilled water was finished, the substrate was ultrasonic cleaned with a solvent of isopropyl alcohol for 10 minutes, and then dried. After that, the substrate was transferred to a glove box.

On the transparent ITO electrode prepared as above, a 2 wt% cyclohexanone solution including Compound 1 and Compound 3-1 prepared above in a weight ratio of 8:2 was spin coated and heat treated for 30 minutes at 230°C to form a hole injection layer having a thickness of 60 nm. On the hole injection layer, a toluene solution including Copolymer HTL1-1 prepared above in 0.8 wt% was spin coated and heat treated for 25 minutes at 230°C to form a hole transfer layer having a thickness of 140 nm.

The result was transferred to a vacuum deposition apparatus, and the following Compound A and the following Compound B were vacuum deposited on the hole transfer layer in a weight ratio of 9:1 to form a light emitting layer having a thickness of 30 nm. On the light emitting layer, the following Compound C was vacuum deposited to form an electron injection and transfer layer having a thickness of 40 nm. LiF having a thickness of 0.5 nm and aluminum having a thickness of 100 nm were consecutively deposited on the electron injection and transfer layer to form a cathode.

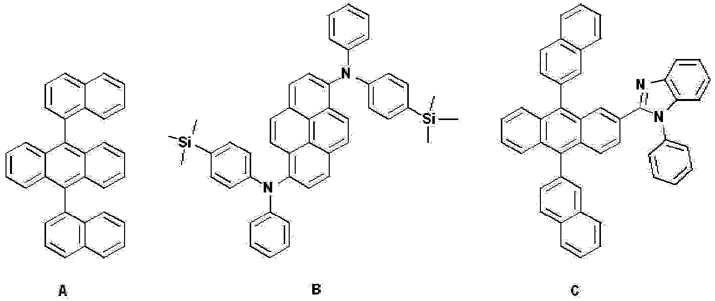

In the above-mentioned process, the deposition rates of the organic materials were maintained at 0.4 Å/sec to 1.0 Å/sec, the deposition rates of the LiF and the aluminum of the cathode were maintained at 0.3 Å/sec and 2 Å/sec, respectively, and the degree of vacuum during the deposition was maintained at 2×10⁻⁸ torr to 5×10⁻⁶ torr.

Examples 2 to 21 and Comparative Examples 1 to 4.

Organic light emitting devices were manufactured in the same manner as in Example 1 except that materials described in the following Table 2 were used instead of Compound 1, Compound 3-1 and Copolymer HTL1-1.

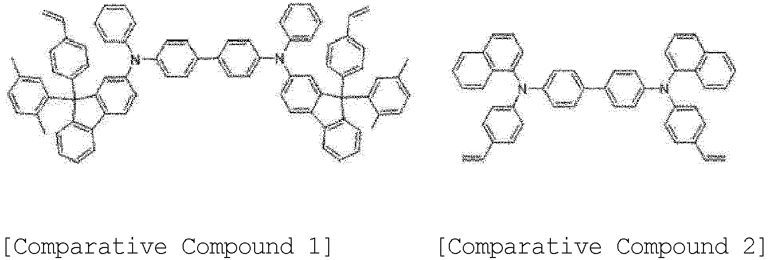

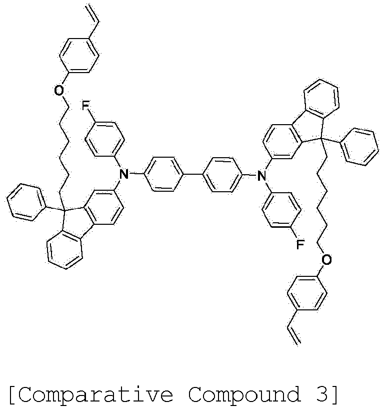

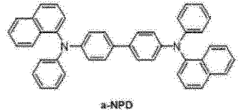

**[Table 2]**

| | Hole Injection Layer Material | | Hole Transfer |
|---|---|---|---|
| | | | Layer Material |
| Example 1 | Compound 1 | Compound 3-1 | HTL1-1 |
| Example 2 | Compound 1 | Compound 3-1 | HTL2-2 |
| Example 3 | Compound 1 | Compound 3-2 | HTL3-2 |
| Example 4 | Compound 1 | Compound 3-3 | HTL4-1 |
| Example 5 | Compound 1 | Compound 3-4 | HTL5-1 |
| Example 6 | Compound 1 | Compound 3-3 | HTL3-1 |
| Example 7 | Compound 1 | Compound 3-2 | HTL2-1 |
| Example 8 | Compound 2 | Compound 3-1 | HTL1-2 |
| Example 9 | Compound 2 | Compound 3-2 | HTL2-1 |
| Example 10 | Compound 2 | Compound 3-1 | HTL3-1 |
| Example 11 | Compound 2 | Compound 3-3 | HTL4-2 |
| Example 12 | Compound 2 | Compound 3-4 | HTL5-2 |
| Example 13 | Compound 2 | Compound 3-3 | HTL2-1 |
| Example 14 | Compound 2 | Compound 3-2 | HTL2-2 |
| Example 15 | Compound 3 | Compound 3-1 | HTL1-1 |
| Example 16 | Compound 3 | Compound 3-2 | HTL2-1 |
| Example 17 | Compound 3 | Compound 3-3 | HTL3-2 |
| Example 18 | Compound 3 | Compound 3-3 | HTL4-2 |
| Example 19 | Compound 3 | Compound 3-4 | HTL5-1 |
| Example 20 | Compound 3 | Compound 3-1 | HTL2-2 |
| Example 21 | Compound 3 | Compound 3-3 | HTL4-1 |
| Comparative Example 1 | Comparative Compound 1 | Compound 3-2 | HTL2-2 |
| Comparative Example 2 | Compound 1 | Compound 3-2 | a-NPD |
| Comparative Example 3 | Comparative Compound 2 | Compound 3-1 | HTL5-1 |
| Comparative Example 4 | Comparative Compound 3 | Compound 3-1 | HTL3-1 |

For the organic light emitting devices manufactured in Examples 1 to 21, values of driving voltage, current efficiency and power efficiency were measured at current density of 10 mA/cm². The results are shown in the following Table 3.

**[Table 3]**

| Experimental Example | Driving Voltage (V) | Current Efficiency (cd/A) | Power Efficiency (lm/W) |
|---|---|---|---|
| Example 1 | 4.23 | 4.46 | 3.31 |
| Example 2 | 4.38 | 4.31 | 3.09 |
| Example 3 | 4.24 | 4.34 | 3.21 |
| Example 4 | 4.19 | 4.19 | 3.14 |
| Example 5 | 4.11 | 4.23 | 3.20 |
| Example 6 | 4.14 | 4.25 | 3.22 |
| Example 7 | 4.38 | 4.31 | 3.09 |
| Example 8 | 4.25 | 4.22 | 3.12 |
| Example 9 | 4.22 | 4.25 | 3.16 |
| Example 10 | 4.17 | 4.28 | 3.22 |
| Example 11 | 4.20 | 4.23 | 3.16 |
| Example 12 | 4.29 | 4.29 | 3.14 |
| Example 13 | 4.24 | 4.46 | 3.30 |
| Example 14 | 4.25 | 4.34 | 3.21 |
| Example 15 | 4.19 | 4.22 | 3.16 |
| Example 16 | 4.27 | 4.35 | 3.20 |
| Example 17 | 4.13 | 4.29 | 3.26 |
| Example 18 | 4.22 | 4.18 | 3.11 |
| Example 19 | 4.24 | 4.25 | 3.15 |
| Example 20 | 4.41 | 4.33 | 3.08 |
| Example 21 | 4.37 | 4.31 | 3.10 |
| Comparative Example 1 | 4.82 | 3.25 | 2.12 |
| Comparative Example 2 | 6.82 | 1.72 | 0.79 |
| Comparative Example 3 | 5.49 | 2.81 | 1.61 |
| Comparative Example 4 | 5.87 | 3.14 | 1.68 |

From the experimental results of Table 3, it was identified that Examples 1 to 21, the organic light emitting devices of the present disclosure, had more superior driving voltage and efficiency compared to Comparative Examples 1 to 3 using materials different from the compound of Chemical Formula 1 or the copolymer of Chemical Formula 3 of the present application.

Specifically, Comparative Example 1 used a compound in which R1 and R3 of Chemical Formula 1 of the present application are hydrogen (Comparative Compound 1), and Comparative Example 2 used a monomer compound (a-NPD) different from the copolymer of Chemical Formula 3 of the present application. Comparative Example 3 used a compound in which a naphthyl group bonds instead of fluorene in Chemical Formula 1 of the present application (Comparative Compound 2). In addition, Comparative Example 4 used a compound in which L1 and L2 are substituted with a hexylene group in Chemical Formula 1 of the present application (Comparative Compound 3).

When comparing Example 10 of the present application and Comparative Example 4 as one example, Example 10 of the present application used the compound according to Chemical Formula 1, specifically Compound 2, instead of Comparative Compound 3 used in Comparative Example 4, and other materials were the same. Compound 2 and Comparative Compound 3 have different structures depending on whether L1 and L2 are a bond or not, and it was identified that the organic light emitting device had low driving voltage and high efficiency in Example 10 of the present application using Compound 2 in which L1 and L2 are a bond compared to in Comparative Example 4 using Comparative Compound 3 having a structure in which L1 and L2 are a hexylene group instead of a methylene group.

## Claims

1. An organic light emitting device comprising:
an anode (201); cathode (701);
a light emitting layer (501) provided between the anode and the cathode;
a first organic material layer (301) including a composition including a compound of the following Chemical Formula 1 or a cured material thereof provided between the light emitting layer and the anode, wherein the first organic material layer further includes an ionic compound including an anion group of the following Chemical Formula 2; and
a second organic material layer (401) including a copolymer of the following Chemical Formula 3 or a cured material thereof provided between the first organic material layer and the light emitting layer: 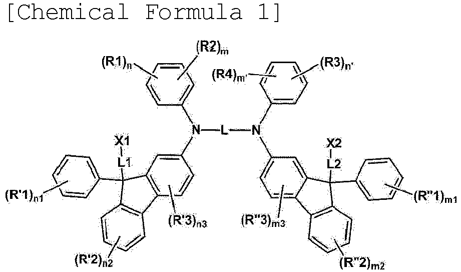
wherein, in Chemical Formula 1,
L is a substituted or unsubstituted C₆₋₆₀ arylene group; or a substituted or unsubstituted C₂₋₆₀ heteroarylene group including one or more heteroatoms selected from the group consisting of N, O and S;
R1 and R3 are the same as or different from each other, and each independently a halogen group;
R2 and R4 are the same as or different from each other, and each independently hydrogen; deuterium; or a C₁₋₁₀ alkyl group;
L1 and L2 are the same as or different from each other, and each independently a direct bond; or a methylene group;
X1 and X2 are the same as or different from each other, and each independently a curing group;
R'1, R'2, R'3, R"1, R"2 and R"3 are the same as or different from each other, and each independently hydrogen; deuterium; a substituted or unsubstituted C₁₋₆₀ alkyl group; a substituted or unsubstituted C₁₋₆₀ alkoxy group; a substituted or unsubstituted C₆₋₆₀ aryl group; or a C₂₋₆₀ heteroaryl group including one or more heteroatoms selected from the group consisting of N, O and S;
n and n' are each independently an integer of 1 to 5, m and m' are each independently 0 or 1, n+m is 5 or less, and n'+m' is 5 or less;
n1 and m1 are each independently an integer of 0 to 5, n2 and m2 are each independently an integer of 0 to 4, and n3 and m3 are each independently an integer of 0 to 3; and
when n, n', n1 to n3 and m1 to m3 are each 2 or greater, substituents in the two or more parentheses are the same as or different from each other, 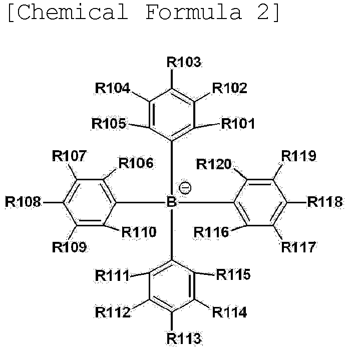
wherein, in Chemical Formula 2,
at least one of R101 to R120 is a curing group,
at least one of the rest of R101 to R120 that are not the curing group is F; a cyano group; or a substituted or unsubstituted fluoroalkyl group,
the rest of R101 to R120 that are not the curing group; the F; the cyano group; or the substituted or unsubstituted fluoroalkyl group are the same as or different from each other, and each independently hydrogen; deuterium; a nitro group; -C(O)R₂₀₁; -OR₂₀₂; -SR₂₀₃; -SO₃R₂₀₄; -COOR₂₀₅; -OC(O)R₂₀₆; -C(O )NR₂₀₇R₂₀₈; a substituted or unsubstituted alkyl group; a substituted or unsubstituted alkenyl group; a substituted or unsubstituted amine group; a substituted or unsubstituted aryl group; or a substituted or unsubstituted heterocyclic group, and
R₂₀₁ to R₂₀₈ are the same as or different from each other, and each independently hydrogen; deuterium; or a substituted or unsubstituted alkyl group, 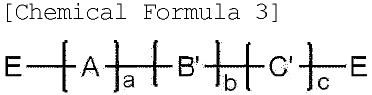
in Chemical Formula 3,
A is a monomer unit including at least one triarylamine group;
B' is a monomer unit having at least three bonding points in the copolymer;
C' is an aromatic monomer unit or a deuterated analogue thereof;
Es are the same as or different from each other, and each independently selected from the group consisting of hydrogen; deuterium; a halogen group; a substituted or unsubstituted alkyl group; a substituted or unsubstituted silyl group; a substituted or unsubstituted germanium group; a substituted or unsubstituted aryl group; a substituted or unsubstituted arylamino group; a substituted or unsubstituted siloxane group; and a substituted or unsubstituted curing group; and
a, b and c are a mole fraction, a+b+c=1, a≠0, and b≠0.

2. The organic light emitting device of Claim 1, wherein at least one of the compounds of Chemical Formula 1 or the copolymer of Chemical Formula 3 is 10% to 100% deuterated.

3. The organic light emitting device of Claim 1, wherein the copolymer of Chemical Formula 3 is 5% to 100% deuterated.

4. The organic light emitting device of Claim 1, wherein L is any one of the following structures:

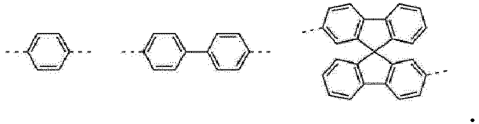

5. The organic light emitting device of Claim 1, wherein the monomer unit A is represented by any one of the following Chemical Formulae A-1 to A-5: 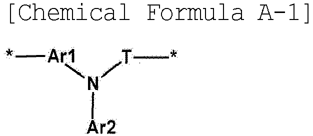 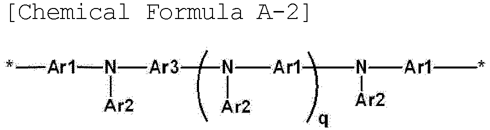 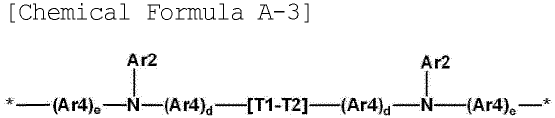 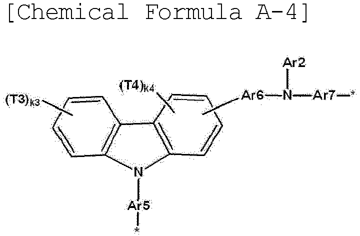 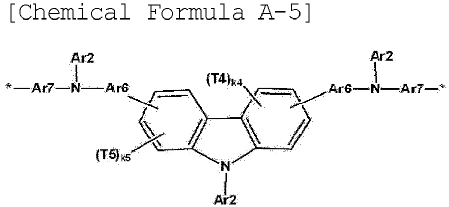
in Chemical Formulae A-1 to A-5,
Ar1s are the same as or different from each other, and each independently a substituted or unsubstituted arylene group or deuterated arylene group;
Ar2s are the same as or different from each other, and each independently a substituted or unsubstituted aryl group or deuterated aryl group;
Ar3 is a substituted or unsubstituted arylene group or deuterated arylene group;
Ar4s are the same as or different from each other, and each independently selected from the group consisting of a substituted or unsubstituted phenylene group; a substituted or unsubstituted naphthylene group; and deuterated analogues thereof;
Ar5, Ar6 and Ar7 are the same as or different from each other, and each independently a substituted or unsubstituted arylene group or deuterated arylene group;
T1 and T2 are the same as or different from each other, and each independently a conjugated moiety linked in a nonplanar configuration, or a deuterated analogue thereof;
T is selected from the group consisting of a direct bond; a substituted or unsubstituted aryl group; and a deuterated aryl group,
T3 to T5 are the same as or different from each other, and each independently selected from the group consisting of hydrogen; F; a cyano group; an alkyl group; a fluoroalkyl group; an aryl group; a heteroaryl group; an amino group; a silyl group; a germanium group; an alkoxy group; an aryloxy group; a fluoroalkoxy group; a siloxane group; a siloxy group; a deuterated alkyl group; a deuterated partial-fluorinated alkyl group; a deuterated aryl group; a deuterated heteroaryl group; a deuterated amino group; a deuterated silyl group; a deuterated germanium group; a deuterated alkoxy group; a deuterated aryloxy group; a deuterated fluoroalkoxy group; a deuterated siloxane group; a deuterated siloxy group; and a curing group, and herein, adjacent groups selected from among T3, T4 and T5 bond to each other to form a ring;
ds are each independently an integer of 1 to 6;
es are each independently an integer of 1 to 6;
k3 is an integer of 0 to 4, k4 and k5 are each independently an integer of 0 to 3, and q is an integer of 0 or greater; and
* represents a bonding point in the copolymer.

6. The organic light emitting device of Claim 1, wherein the monomer unit B' is represented by any one of the following Chemical Formulae B'-1 to B'-9: 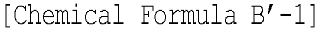 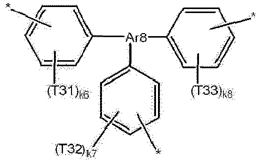 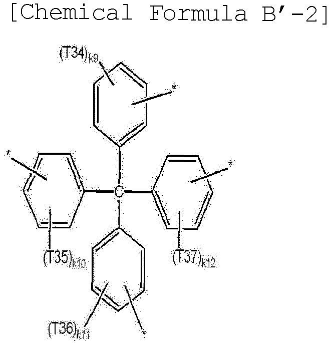 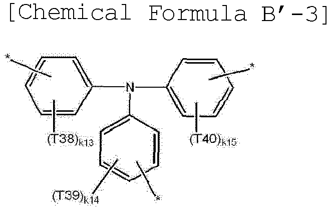 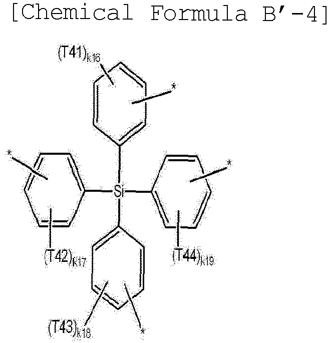 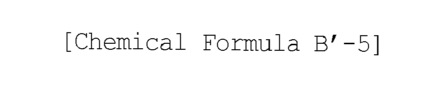 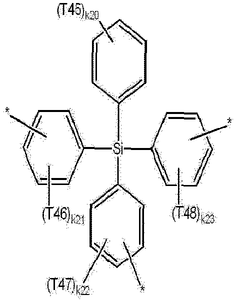 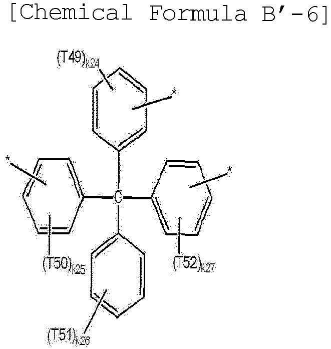 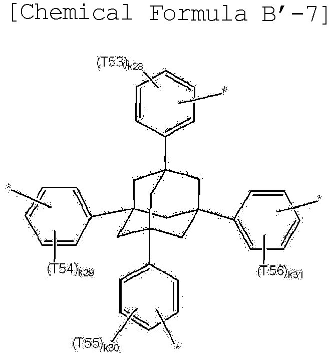 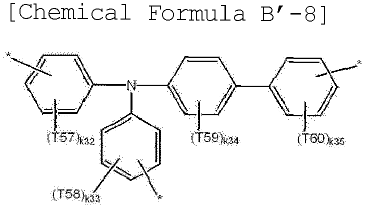 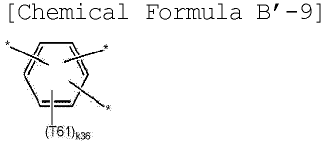
in Chemical Formulae B'-1 to B'-9,
Ar8 is an aromatic cyclic group or a deuterated aromatic cyclic group having at least three bonding points;
T31 to T61 are the same as or different from each other, and each independently selected from the group consisting of deuterium; F; a cyano group; an alkyl group; a fluoroalkyl group; an aryl group; a heteroaryl group; an amino group; a silyl group; a germanium group; an alkoxy group; an aryloxy group; a fluoroalkoxy group; a siloxane group; a siloxy group; a deuterated alkyl group; a deuterated partial-fluorinated alkyl group; a deuterated aryl group; a deuterated heteroaryl group; a deuterated amino group; a deuterated silyl group; a deuterated germanium group; a deuterated alkoxy group; a deuterated aryloxy group; a deuterated fluoroalkoxy group; a deuterated siloxane group; a deuterated siloxy group; and a curing group, and herein, adjacent groups selected from among T31 to T61 bond to each other to form a 5-membered or 6-membered aromatic ring;
k6 to k19, k21 to k25 and k27 to k35 are each independently an integer of 0 to 4, k20 and k26 are each independently an integer of 0 to 5, and k36 is an integer of 0 to 3; and
* represents a bonding point in the copolymer.

7. The organic light emitting device of Claim 1, wherein the copolymer of Chemical Formula 3 is represented by the following Chemical Formula 3': 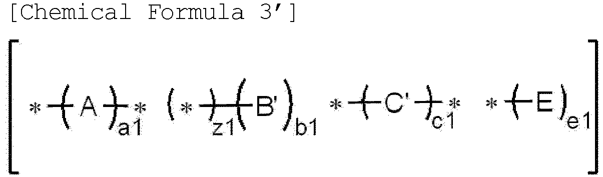
in Chemical Formula 3',
A is a monomer unit including at least one triarylamine group;
B' is a monomer unit having at least three bonding points in the copolymer;
C' is an aromatic monomer unit or a deuterated analogue thereof;
Es are the same as or different from each other, and each independently selected from the group consisting of hydrogen; deuterium; a halogen group; a substituted or unsubstituted alkyl group; a substituted or unsubstituted aryl group; a substituted or unsubstituted arylamino group; a substituted or unsubstituted siloxane group; and a substituted or unsubstituted curing group;
a1, b1, c1 and e1 are a mole fraction, a1+b1+c1+e1=1, a1≠0, and b1≠0;
z1 is an integer of 3 or greater; and
* means an attaching point in the copolymer.

8. The organic light emitting device of Claim 1, wherein the copolymer of Chemical Formula 3 has a weight average molecular weight of 10,000 g/mol to 5,000,000 g/mol.

9. The organic light emitting device of Claim 1, wherein the first organic material layer is a hole injection layer, and the second organic material layer is a hole transfer layer.

10. The organic light emitting device of Claim 1, wherein the first organic material layer is provided in contact with the anode, and the second organic material layer is provided in contact with the first organic material layer.

## Patentansprüche

1. Organische lichtemittierende Vorrichtung, umfassend:
eine Anode (201);
eine Kathode (701);
eine zwischen der Anode und der Kathode vorgesehene lichtemittierende Schicht (501);
eine zwischen der lichtemittierenden Schicht und der Anode vorgesehene erste organische Materialschicht (301), die eine Zusammensetzung umfasst, die eine Verbindung der folgenden chemischen Formel 1 oder ein gehärtetes Material hiervon umfasst, worin die erste organische Materialschicht ferner eine ionische Verbindung umfasst, die eine Aniongruppe der folgenden chemischen Formel 2 umfasst; und
eine zwischen der ersten organischen Materialschicht und der lichtemittierenden Schicht vorgesehene zweite organische Materialschicht (401), die ein Copolymer der folgenden chemischen Formel 3 oder ein gehärtetes Material hiervon umfasst: 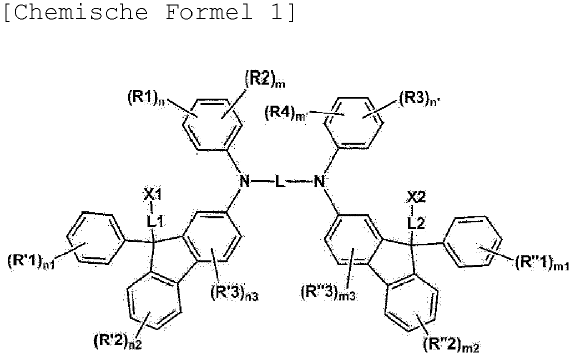
worin in der chemischen Formel 1
L eine substituierte oder unsubstituierte C₆₋₆₀-Arylengruppe; oder eine substituierte oder unsubstituierte C₂₋₆₀-Heteroarylengruppe ist, umfassend ein oder mehr Heteroatome, ausgewählt aus der Gruppe, bestehend aus N, O und S;
R1 und R3 gleich oder verschieden sind und jeweils unabhängig eine Halogengruppe sind;
R2 und R4 gleich oder verschieden sind und jeweils unabhängig Wasserstoff; Deuterium; oder eine C₁₋₁₀-Alkylgruppe sind;
L1 und L2 gleich oder verschieden sind und jeweils unabhängig eine direkte Bindung; oder eine Methylengruppe sind;
X1 und X2 gleich oder verschieden sind und jeweils unabhängig eine Härtungsgruppe sind;
R'1, R'2, R'3, R"1, R"2 und R"3 gleich oder verschieden sind und jeweils unabhängig Wasserstoff; Deuterium; eine substituierte oder unsubstituierte C₁₋₆₀-Alkylgruppe; eine substituierte oder unsubstituierte C₁₋₆₀-Alkoxygruppe; eine substituierte oder unsubstituierte C₆₋₆₀-Arylgruppe; oder eine C₂₋₆₀-Heteroarylgruppe, umfassend ein oder mehr Heteroatome, ausgewählt aus der Gruppe bestehend aus N, O und S, sind;
n und n' jeweils unabhängig eine ganze Zahl von 1 bis 5 sind, m und m' jeweils unabhängig 0 oder 1 sind, n+m 5 oder kleiner ist und n'+m' 5 oder kleiner ist;
n1 und m1 jeweils unabhängig eine ganze Zahl von 0 bis 5 sind, n2 und m2 jeweils unabhängig eine ganze Zahl von 0 bis 4 sind, und n3 und m3 jeweils unabhängig eine ganze Zahl von 0 bis 3 sind; und
wenn n, n', n1 bis n3 und m1 bis m3 jeweils 2 oder größer sind, die Substituenten in den zwei oder mehr Klammern gleich oder verschieden sind, 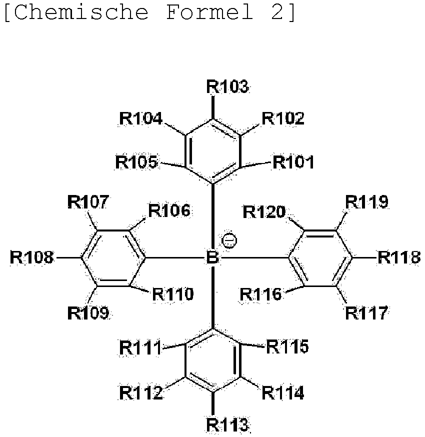
worin in der chemischen Formel 2
zumindest eines von R101 bis R120 eine Härtungsgruppe ist,
zumindest eines von den Verbleibenden von R101 bis R120, die keine Härtungsgruppe sind, F; eine Cyanogruppe; oder eine substituierte oder unsubstituierte Fluoralkylgruppe ist,
die Verbleibenden von R101 bis R120, die keine Härtungsgruppe; F; Cyanogruppe; oder substituierte oder unsubstituierte Fluoralkylgruppe sind, gleich oder voneinander verschieden sind und jeweils unabhängig Wasserstoff; Deuterium; eine Nitrogruppe; -C(O)R₂₀₁; -OR₂₀₂; -SR₂₀₃; -SO₃R₂₀₄; -COOR₂₀₅; -OC(O)R₂₀₆; - C(O)NR₂₀₇R₂₀₈; eine substituierte oder unsubstituierte Alkylgruppe; eine substituierte oder unsubstituierte Alkenylgruppe; eine substituierte oder unsubstituierte Aminogruppe; eine substituierte oder unsubstituierte Arylgruppe; oder eine substituierte oder unsubstituierte heterocyclische Gruppe sind, und
R₂₀₁ bis R₂₀₈ gleich oder verschieden sind und jeweils unabhängig Wasserstoff; Deuterium; oder eine substituierte oder unsubstituierte Alkylgruppe sind, 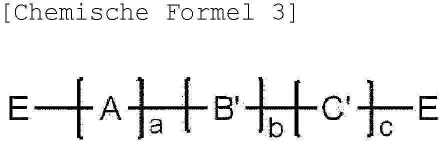
worin in der chemischen Formel 3
A eine Monomereinheit ist, die zumindest eine Triarylamingruppe umfasst;
B' eine Monomereinheit mit zumindest drei Verbindungspunkten in dem Copolymer ist;
C' eine aromatische Monomereinheit oder ein deuteriertes Analogon hiervon ist;
die E gleich oder verschieden sind und jeweils unabhängig ausgewählt sind aus der Gruppe bestehend aus Wasserstoff; Deuterium; einer Halogengruppe; einer substituierten oder unsubstituierten Alkylgruppe; einer substituierten oder unsubstituierten Silylgruppe; einer substituierten oder unsubstituierten Germaniumgruppe; einer substituierten oder unsubstituierten Arylgruppe; einer substituierten oder unsubstituierten Arylaminogruppe; einer substituierten oder unsubstituierten Siloxangruppe; und einer substituierten oder unsubstituierten Härtungsgruppe; und
a, b und c Molfraktionen sind, a+b+c=1, a#0 und b#0.

2. Organische lichtemittierende Vorrichtung gemäß Anspruch 1, worin zumindest eines von der Verbindung der chemischen Formel 1 oder des Copolymers der chemischen Formel 3 zu 10 % bis 100 % deuteriert ist.

3. Organische lichtemittierende Vorrichtung gemäß Anspruch 1, worin das Copolymer der chemischen Formel 3 zu 5 % bis 100 % deuteriert ist.

4. Organische lichtemittierende Vorrichtung gemäß Anspruch 1, worin L irgendeine der folgenden Strukturen ist:

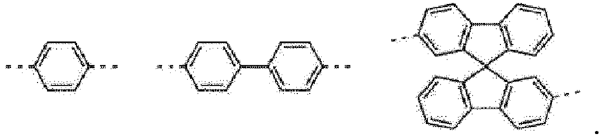

5. Organische lichtemittierende Vorrichtung gemäß Anspruch 1, worin die Monomereinheit A durch irgendeine der folgenden chemischen Formeln A-1 bis A-5 dargestellt ist: 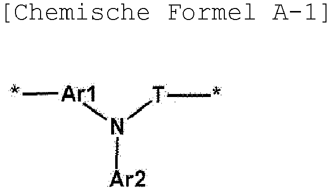 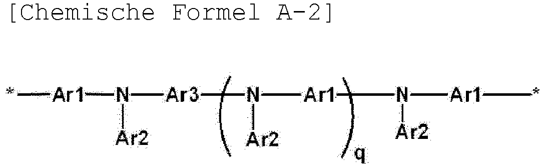 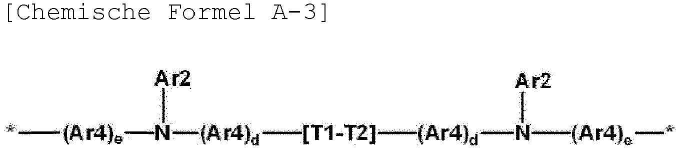 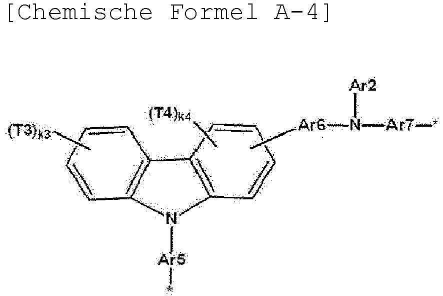 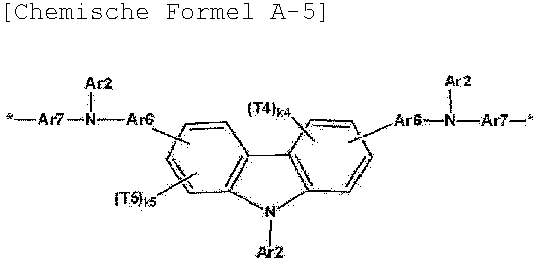
worin in den chemischen Formeln A-1 bis A-5
die Ar1 gleich oder verschieden sind und jeweils unabhängig eine substituierte oder unsubstituierte Arylengruppe oder deuterierte Arylengruppe sind;
die Ar2 gleich oder verschieden sind und jeweils unabhängig eine substituierte oder unsubstituierte Arylgruppe oder deuterierte Arylgruppe sind;
Ar3 eine substituierte oder unsubstituierte Arylengruppe oder deuterierte Arylengruppe ist;
die Ar4 gleich oder verschieden sind und jeweils unabhängig ausgewählt sind aus der Gruppe bestehend aus einer substituierten oder unsubstituierten Phenylengruppe; einer substituierten oder unsubstituierten Naphthylengruppe; und deuterierten Analoga davon;
Ar5, Ar6 und Ar7 gleich oder verschieden sind und jeweils unabhängig eine substituierte oder unsubstituierte Arylengruppe oder deuterierte Arylengruppe sind;
T1 und T2 gleich oder verschieden sind und jeweils unabhängig ein konjugierter Rest, der in einer nichtplanaren Konfiguration verknüpft ist, oder ein deuteriertes Analogon hiervon sind;
T ausgewählt ist aus der Gruppe, bestehend aus einer direkten Bindung; einer substituierten oder unsubstituierten Arylgruppe; und einer deuterierten Arylgruppe,
T3 bis T5 gleich oder verschieden sind und jeweils unabhängig ausgewählt sind aus der Gruppe, bestehend aus Wasserstoff; F; einer Cyanogruppe; einer Alkylgruppe; einer Fluoralkylgruppe; einer Arylgruppe; einer Heteroarylgruppe; einer Aminogruppe; einer Silylgruppe; einer Germaniumgruppe; einer Alkoxygruppe; einer Aryloxygruppe; einer Fluoralkoxygruppe; einer Siloxangruppe; einer Siloxygruppe; einer deuterierten Alkylgruppe; einer deuterierten teilfluorierten Alkylgruppe; einer deuterierten Arylgruppe; einer deuterierten Heteroarylgruppe; einer deuterierten Aminogruppe; einer deuterierten Silylgruppe; einer deuterierten Germaniumgruppe; einer deuterierten Alkoxygruppe; einer deuterierten Aryloxygruppe; einer deuterierten Fluoralkoxygruppe; einer deuterierten Siloxangruppe; einer deuterierten Siloxygruppe; und einer Härtungsgruppe; und worin hierin unter T3, T4 und T5 ausgewählte benachbarte Gruppen aneinander binden, um einen Ring zu bilden;
die d jeweils unabhängig eine ganze Zahl von 1 bis 6 sind;
die e jeweils unabhängig eine ganze Zahl von 1 bis 6 sind;
k3 eine ganze Zahl von 0 bis 4 ist, k4 und k5 jeweils unabhängig eine ganze Zahl von 0 bis 3 sind und q eine ganze Zahl von 0 oder größer ist; und
* eine Bindungsposition in dem Copolymer anzeigt.

6. Organische lichtemittierende Vorrichtung gemäß Anspruch 1, worin die Monomereinheit B' durch irgendeine der folgenden chemischen Formeln B'-1 bis B'-9 dargestellt ist: 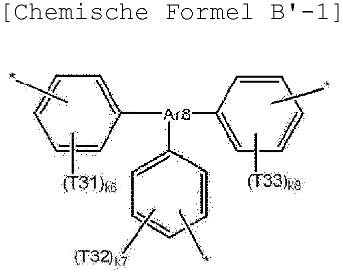 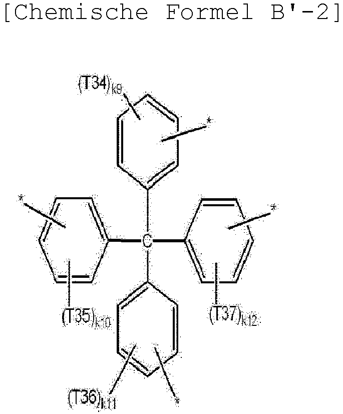 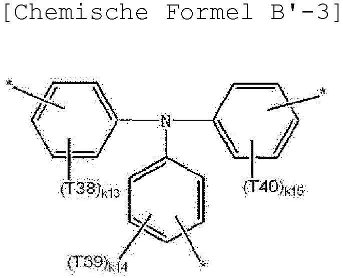 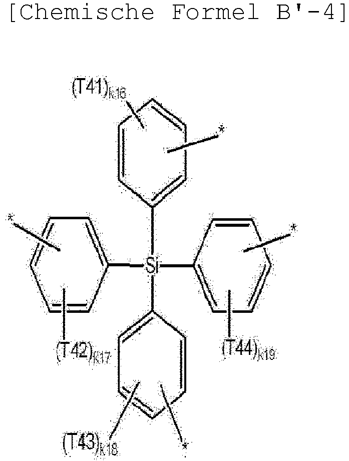 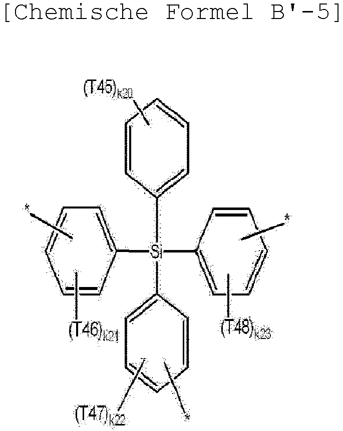 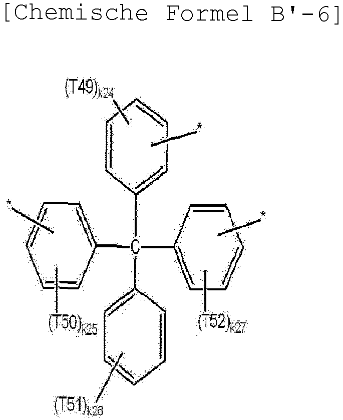 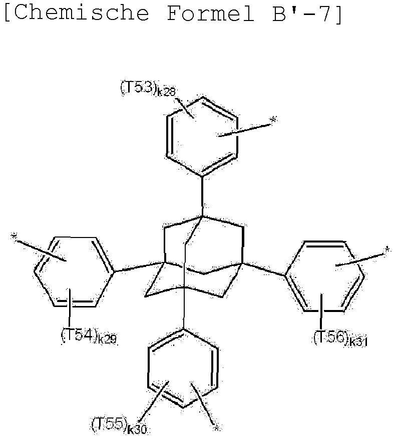 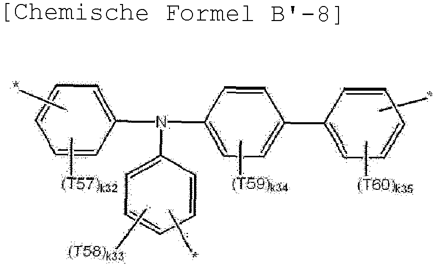 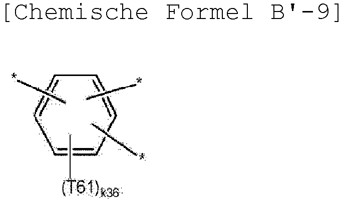
worin in den chemischen Formel B'-1 bis B'-9
Ar8 eine aromatische cyclische Gruppe oder eine deuterierte aromatische cyclische Gruppe mit mindestens drei Bindungsstellen ist;
T31 bis T61 gleich oder verschieden sind und jeweils unabhängig ausgewählt sind aus der Gruppe bestehend aus Deuterium; F; einer Cyanogruppe; einer Alkylgruppe; einer Fluoralkylgruppe; einer Arylgruppe; einer Heteroarylgruppe; einer Aminogruppe; einer Silylgruppe; einer Germaniumgruppe; einer Alkoxygruppe; einer Aryloxygruppe; einer Fluoralkoxygruppe; einer Siloxangruppe; einer Siloxygruppe; einer deuterierten Alkylgruppe; einer deuterierten teilfluorierten Alkylgruppe; einer deuterierten Arylgruppe; einer deuterierten Heteroarylgruppe; einer deuterierten Aminogruppe; einer deuterierten Silylgruppe; einer deuterierten Germaniumgruppe; einer deuterierten Alkoxygruppe; einer deuterierten Aryloxygruppe; einer deuterierten Fluoralkoxygruppe; einer deuterierten Siloxangruppe; einer deuterierten Siloxygruppe; und einer Härtungsgruppe; und worin hierin unter T31 bis T61 ausgewählte benachbarte Gruppen aneinander binden, um einen 5-gliedrigen oder 6-gliedrigen aromatischen Ring zu bilden;
k6 bis k19, k21 bis k25 und k27 bis k35 jeweils unabhängig eine ganze Zahl von 0 bis 4 sind, k20 und k26 jeweils unabhängig eine ganze Zahl von 0 bis 5 sind und k36 eine ganze Zahl von 0 bis 3 ist; und
* eine Bindungsstelle in dem Copolymer darstellt.

7. Organische lichtemittierende Vorrichtung gemäß Anspruch 1, worin das Copolymer der chemischen Formel 3 durch die folgende chemische Formel 3' dargestellt ist: 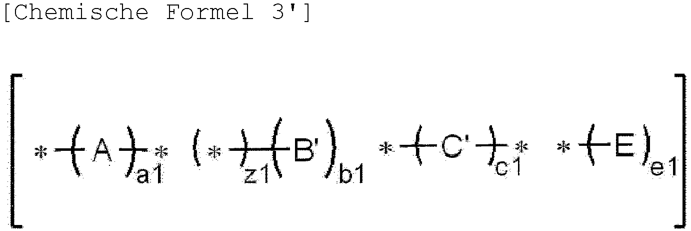
worin in der chemischen Formel 3'
A eine Monomereinheit ist, die zumindest eine Triarylamingruppe umfasst;
B' eine Monomereinheit mit zumindest drei Bindungsstellen in dem Copolymer ist;
C' eine aromatische Monomereinheit oder ein deuteriertes Analogon hiervon ist;
die E gleich oder verschieden sind und jeweils unabhängig ausgewählt sind aus der Gruppe bestehend aus Wasserstoff; Deuterium; einer Halogengruppe; einer substituierten oder unsubstituierten Alkylgruppe; einer substituierten oder unsubstituierten Arylgruppe; einer substituierten oder unsubstituierten Arylaminogruppe; einer substituierten oder unsubstituierten Siloxangruppe; und einer substituierten oder unsubstituierten Härtungsgruppe;
a1, b1, c1 und e1 Molfraktionen sind, a1+b1+c1+e1=1, a1≠0 und b1≠0;
z1 eine ganze Zahl von 3 oder größer ist; und
* einen Verbindungspunkt in dem Copolymer bezeichnet.

8. Organische lichtemittierende Vorrichtung gemäß Anspruch 1, worin das Copolymer der chemischen Formel 3 ein gewichtsgemitteltes Molekulargewicht von 10.000 g/mol bis 5.000.000 g/mol aufweist.

9. Organische lichtemittierende Vorrichtung gemäß Anspruch 1, worin die erste organische Materialschicht eine Lochinjektionsschicht ist und die zweite organische Materialschicht eine Lochtransportschicht ist.

10. Organische lichtemittierende Vorrichtung gemäß Anspruch 1, worin die erste organische Materialschicht in Kontakt mit der Anode vorgesehen ist und die zweite organische Materialschicht in Kontakt mit der ersten organischen Materialschicht vorgesehen ist.

## Revendications

1. Dispositif électroluminescent organique comprenant :
une anode (201) ;
une cathode (701) ;
une couche électroluminescente (501) prévue entre l'anode et la cathode ;
une première couche (301) de matériau organique incluant une composition incluant un composé de la formule chimique 1 suivante ou un matériau durci de celui-ci prévu entre la couche électroluminescente et l'anode, dans lequel la première couche de matériau organique inclut en outre un composé ionique incluant un groupe anionique de la formule chimique 2 suivante ; et
une seconde couche (401) de matériau organique incluant un copolymère de la formule chimique 3 suivante ou un matériau durci de celui-ci prévu entre la première couche de matériau organique et la couche électroluminescente : 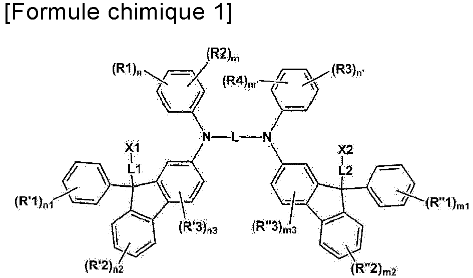
dans lequel, dans la formule chimique 1,
L est un groupe arylène en C₆₋₆₀ substitué ou non substitué ; ou un groupe hétéroarylène en C₂₋₆₀ substitué ou non substitué ; incluant un ou plusieurs hétéroatomes choisis dans le groupe constitué par N, O et S ;
R1 et R3 sont identiques l'un à l'autre ou différents l'un de l'autre, et sont chacun indépendamment un groupe halogène ;
R2 et R4 sont identiques l'un à l'autre ou différents l'un de l'autre, et chacun indépendamment un hydrogène, un deutérium ou un groupe alkyle en C₁₋₁₀ ;
L1 et L2 sont identiques l'un à l'autre ou différents l'un de l'autre, et sont chacun indépendamment une liaison directe ; ou un groupe méthylène ;
X1 et X2 sont identiques l'un à l'autre ou différents l'un de l'autre, et sont chacun indépendamment un groupe de durcissement ;
R'1, R'2, R'3, R"1, R"2 et R"3 sont identiques les uns aux autres ou différents les uns des autres, et sont chacun indépendamment l'hydrogène ; le deutérium ; un groupe alkyle en C₁₋₆₀ substitué ou non substitué ; un groupe alcoxy en C₁₋₆₀ substitué ou non substitué ; un groupe aryle en C₆₋₆₀ substitué ou non substitué ; ou un groupe hétéroaryle en C₂₋₆₀ substitué ou non substitué ; incluant un ou plusieurs hétéroatomes choisis dans le groupe constitué par N, O et S ;
n et n' sont chacun indépendamment un entier de 1 à 5, m et m' sont chacun indépendamment 0 ou 1, n+m est 5 ou moins, et n'+m' est 5 ou moins ;
n1 et m1 sont chacun indépendamment un entier de 0 à 5, n2 et m2 sont chacun indépendamment un entier de 0 à 4, et n3 et m3 sont chacun indépendamment un entier de 0 à 3 ; et
lorsque n, n', n1 à n3 et m1 à m3 sont chacun 2 ou plus, les substituants dans les deux parenthèses ou plus sont identiques les uns aux autres ou différents les uns des autres, 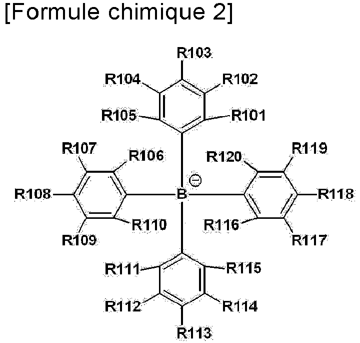
dans lequel, dans la formule chimique 2,
au moins un parmi R101 à R120 est un groupe de durcissement,
au moins un parmi le reste de R101 à R120 qui ne sont pas le groupe de durcissement est F ; un groupe cyano ; ou un groupe fluoroalkyle substitué ou non substitué,
le reste de R101 à R120 qui ne sont pas le groupe de durcissement ; le F ; le groupe cyano ; ou le groupe fluoroalkyle substitué ou non substitué, sont identiques les uns aux autres ou différents les uns des autres, et sont chacun indépendamment l'hydrogène ; le deutérium ; un groupe nitro ; -C(O)R₂₀₁ ; -OR₂₀₂ ; -SR₂₀₃ ; -SO₃R₂₀₄ ; -COOR₂₀₅ ; -OC(O)R₂₀₆ ; -C(O)NR₂₀₇R₂₀₈ ; un groupe alkyle substitué ou non substitué ; un groupe alcényle substitué ou non substitué ; un groupe amine substitué ou non substitué ; un groupe aryle substitué ou non substitué ; un groupe hétérocyclique substitué ou non substitué, et
R₂₀₁ à R₂₀₈ sont identiques les uns aux autres ou différents les uns des autres, et sont chacun indépendamment l'hydrogène, le deutérium ou un groupe alkyle substitué ou non substitué, 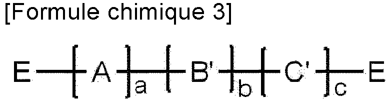
dans la formule chimique 3,
A est un motif monomère incluant au moins un groupe triarylamine ;
B' est un motif monomère présentant au moins trois points de liaison dans le copolymère ;
C' est un motif monomère aromatique ou un analogue deutéré de celui-ci ;
les E sont identiques les uns aux autres ou différents les uns des autres, et sont chacun indépendamment choisi dans le groupe constitué par l'hydrogène ; le deutérium ; un groupe halogène ; un groupe alkyle substitué ou non substitué ; un groupe silyle substitué ou non substitué ; un groupe germanium substitué ou non substitué ; un groupe aryle substitué ou non substitué ; un groupe arylamino substitué ou non substitué ; un groupe siloxane substitué ou non substitué ; et un groupe de durcissement substitué ou non substitué ; et
a, b et c sont une fraction molaire, a+b+c=1, a≠0 et b≠0.

2. Dispositif électroluminescent organique selon la revendication 1, dans lequel au moins un des composés de formule chimique 1 ou le copolymère de formule chimique 3 est deutéré de 10 % à 100 %.

3. Dispositif électroluminescent organique selon la revendication 1, dans lequel le copolymère de formule chimique 3 est deutéré de 5 % à 100 %.

4. Dispositif électroluminescent organique selon la revendication 1, dans lequel L est l'une quelconque des structures suivantes :

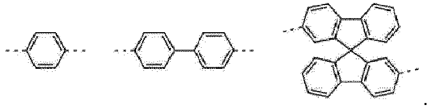

5. Dispositif électroluminescent organique selon la revendication 1, dans lequel le motif monomère A est représenté par l'une quelconque des formules chimiques A-1 à A-5 suivantes : 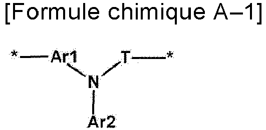 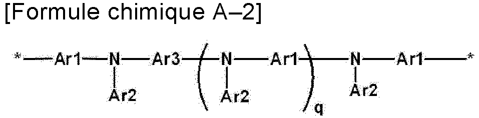 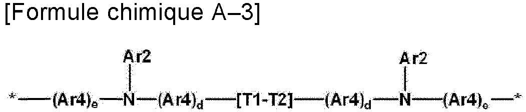 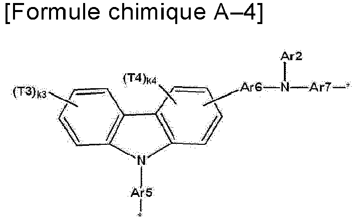 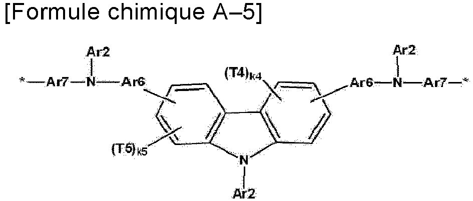
dans les formules chimiques A-1 à A-5,
les Ar1 sont identiques les uns aux autres ou différents les uns des autres, et chacun indépendamment un groupe arylène substitué ou non substitué ou un groupe arylène deutéré ;
les Ar2 sont identiques les uns aux autres ou différents les uns des autres, et chacun indépendamment un groupe aryle substitué ou non substitué ou un groupe aryle deutéré ;
Ar3 est un groupe arylène substitué ou non substitué ou un groupe arylène deutéré ;
les Ar4 sont identiques les uns aux autres ou différents les uns des autres, et chacun indépendamment choisi dans le groupe constitué par un groupe phénylène substitué ou non substitué ; un groupe naphtylène substitué ou non substitué ; et des analogues deutérés de ceux-ci ;
Ar5, Ar6 et Ar7 sont identiques les uns aux autres ou différents les uns des autres, et chacun indépendamment un groupe arylène substitué ou non substitué ou un groupe arylène deutéré ;
T1 et T2 sont identiques l'un à l'autre ou différents l'un de l'autre, et chacun indépendamment un fragment conjugué lié dans une configuration non plane, ou un analogue deutéré de celui-ci ;
T est choisi dans le groupe constitué par une liaison directe ; un groupe aryle substitué ou non substitué ; et un groupe aryle deutéré,
T3 à T5 sont identiques les uns aux autres ou différents les uns des autres, et chacun indépendamment choisi dans le groupe constitué par l'hydrogène ; F ; un groupe cyano ; un groupe alkyle ; un groupe fluoroalkyle ; un groupe aryle ; un groupe hétéroaryle ; un groupe amino ; un groupe silyle ; un groupe germanium ; un groupe alcoxy ; un groupe aryloxy ; un groupe fluoroalcoxy ; un groupe siloxane ; un groupe siloxy ; un groupe alkyle deutéré ; un groupe alkyle partiellement fluoré deutéré ; un groupe aryle deutéré ; un groupe hétéroaryle deutéré ; un groupe amino deutéré ; un groupe silyle deutéré ; un groupe germanium deutéré ; un groupe alcoxy deutéré ; un groupe aryloxy deutéré ; un groupe fluoroalcoxy deutéré ; un groupe siloxane deutéré ; un groupe siloxy deutéré ; et un groupe de durcissement, et dans lequel, des groupes adjacents choisis parmi T3, T4 et T5 se lient les uns aux autres pour former un cycle ;
les d sont chacun indépendamment un entier de 1 à 6 ;
les e sont chacun indépendamment un entier de 1 à 6 ;
k3 est un entier de 0 à 4, k4 et k5 sont chacun indépendamment un entier de 0 à 3, et q est un entier de 0 ou plus ; et
* représente un point de liaison dans le copolymère.

6. Dispositif électroluminescent organique selon la revendication 1, dans lequel le motif monomère B' est représenté par l'une quelconque des formules chimiques B'-1 à B'-9 suivantes : 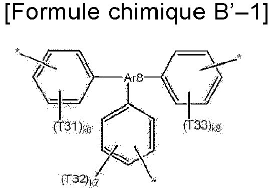 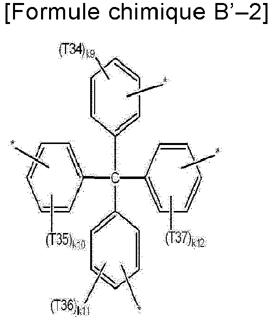 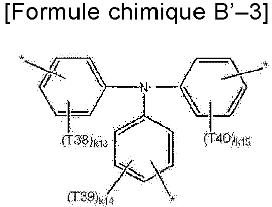 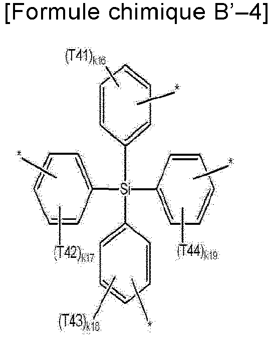 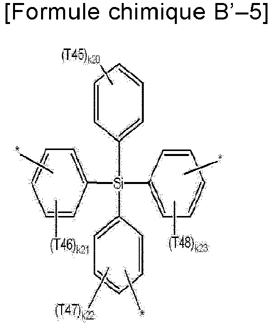 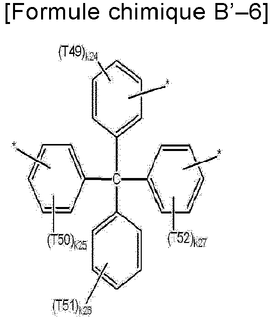 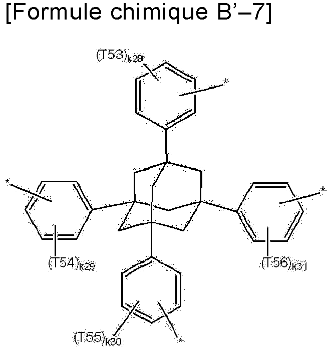 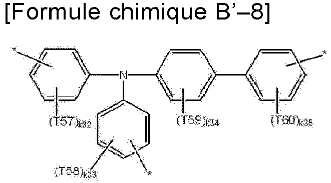 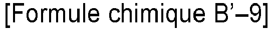 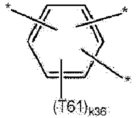
dans les formules chimiques B'-1 à B'-9,
Ar8 est un groupe cyclique aromatique ou un groupe cyclique aromatique deutéré présentant au moins trois points de liaison ;
T31 à T61 sont identiques les uns aux autres ou différents les uns des autres, et chacun indépendamment choisi dans le groupe constitué par le deutérium ; F ; un groupe cyano ; un groupe alkyle ; un groupe fluoroalkyle ; un groupe aryle ; un groupe hétéroaryle ; un groupe amino ; un groupe silyle ; un groupe germanium ; un groupe alcoxy ; un groupe aryloxy ; un groupe fluoroalcoxy ; un groupe siloxane ; un groupe siloxy ; un groupe alkyle deutéré ; un groupe alkyle partiellement fluoré deutéré ; un groupe aryle deutéré ; un groupe hétéroaryle deutéré ; un groupe amino deutéré ; un groupe silyle deutéré ; un groupe germanium deutéré ; un groupe alcoxy deutéré ; un groupe aryloxy deutéré ; un groupe fluoroalcoxy deutéré ; un groupe siloxane deutéré ; un groupe siloxy deutéré ; et un groupe de durcissement, et dans lequel, des groupes adjacents choisis parmi T31 à T61 se lient les uns aux autres pour former un cycle aromatique à 5 ou 6 chaînons ;
k6 à k19, k21 à k25 et k27 à k35 sont chacun indépendamment un entier de 0 à 4, k20 et k26 sont chacun indépendamment un entier de 0 à 5, et k36 est un entier de 0 à 3 ; et
* représente un point de liaison dans le copolymère.

7. Dispositif électroluminescent organique selon la revendication 1, dans lequel le copolymère de formule chimique 3 est représenté par la formule chimique 3' suivante : 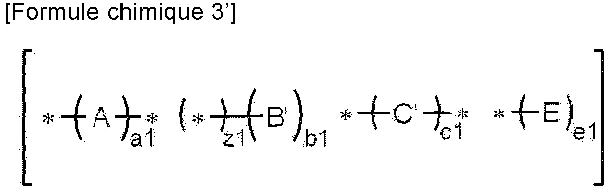
dans la formule chimique 3',
A est un motif monomère incluant au moins un groupe triarylamine ;
B' est un motif monomère présentant au moins trois points de liaison dans le copolymère ;
C' est un motif monomère aromatique ou un analogue deutéré de celui-ci ;
les E sont identiques les uns aux autres ou différents les uns des autres, et chacun indépendamment choisi dans le groupe constitué par l'hydrogène ; le deutérium ; un groupe halogène ; un groupe alkyle substitué ou non substitué ; un groupe aryle substitué ou non substitué ; un groupe arylamino substitué ou non substitué ; un groupe siloxane substitué ou non substitué ; et un groupe de durcissement substitué ou non substitué ;
a1, b1, c1 et e1 sont une fraction molaire, a1+b1+c1+e1=1, a1≠0 et b1≠0 ;
z1 est un entier de 3 ou plus ; et
* désigne un point d'attache dans le copolymère.

8. Dispositif électroluminescent organique selon la revendication 1, dans lequel le copolymère de formule chimique 3 présente un poids moléculaire moyen de 10 000 g/mol à 5 000 000 g/mol.

9. Dispositif électroluminescent organique selon la revendication 1, dans lequel la première couche de matériau organique est une couche d'injection à trous, et la seconde couche de matériau organique est une couche de transfert à trous.

10. Dispositif électroluminescent organique selon la revendication 1, dans lequel la première couche de matériau organique est prévue en contact avec l'anode, et la seconde couche de matériau organique est prévue en contact avec la première couche de matériau organique.
